Europäisches Patentamt

European Patent Office

Office européen des brevets

(19)

(11) EP 0 869 557 B1

(12) EUROPEAN PATENT SPECIFICATION

(45) Date of publication and mention
of the grant of the patent:
**02.02.2005** Bulletin 2005/05

(51) Int Cl.⁷: $H01L\ 29/51$, $H01L\ 27/115$, $H01L\ 21/8247$

(21) Application number: **98301688.2**

(22) Date of filing: **06.03.1998**

(54) **Ferroelectric memory cell and method of making the same**

Ferroelektrische Speicherzelle und deren Herstellungsverfahren

Cellule de mémoire ferroélectrique et son procédé de fabrication

(84) Designated Contracting States:
**DE FR GB**

(30) Priority: **07.03.1997 US 812579**
 **04.04.1997 US 834499**
 **06.06.1997 US 869534**
 **06.06.1997 US 870161**
 **06.06.1997 US 870375**
 **04.08.1997 US 905380**

(43) Date of publication of application:
**07.10.1998** Bulletin 1998/41

(73) Proprietors:
• **Sharp Kabushiki Kaisha**
 **Osaka-shi, Osaka 545-8522 (JP)**
• **SHARP MICROELECTRONICS TECHNOLOGY, INC.**
 **Camas, WA 98607 (US)**

(72) Inventors:
• **Hsu, Sheng Teng**
 **Camas, WA 98607 (US)**
• **Lee, Jong Jan**
 **Camas, WA 98607 (US)**
• **Peng, Chien-Hsiung**
 **Vancouver, WA 98684 (US)**

(74) Representative: **Brown, Kenneth Richard et al**
**R.G.C. Jenkins & Co.**
**26 Caxton Street**
**London SW1H 0RJ (GB)**

(56) References cited:
 **WO-A-96/13860**  **US-A- 5 303 182**

• **PATENT ABSTRACTS OF JAPAN vol. 017, no. 039 (E-1311), 25 January 1993 & JP 04 256361 A (NISSAN MOTOR CO LTD), 11 September 1992**
• **PATENT ABSTRACTS OF JAPAN vol. 097, no. 003, 31 March 1997 -& JP 08 293565 A (NEC CORP), 5 November 1996**
• **TAKASHI NAKAMURA ET AL: "CHARACTERISTICS OF NDRO FERROELECTRIC FETS WITH A POLY-SI FLOATING GATE" PROCEEDINGS OF THE NINTH IEEE INTERNATIONAL SYMPOSIUM ON APPLICATIONS OF FERROELECTRICS (ISAF), UNIVERSITY PARK, PENNSYLVANIA, AUG. 7 - 10. 1994, no. SYMP. 9, 7 August 1994, pages 345-347, XP000553149 PANDEY R K;LIU M; AHMAD SAFARI**

**Description**

BACKGROUND OF THE INVENTION

1. FIELD OF THE INVENTION:

This application relates to ferroelectric thin films which are used in nonvolatile memories and specifically to a metal-ferroelectric-metal-oxide-silicon semi-conductor.

2. DESCRIPTION OF THE RELATED ART:

This application relates to ferroelectric thin films which are used in nonvolatile memories and specifically to a metal-ferroelectric-metal-silicon semi-conductor (or a shallow junction metal-ferroelectric-metal-silicon semi-conductor). Known ferroelectric random access memories (FRAM) are constructed with one transistor (IT) and one capacitor (1C). The capacitor is generally made by sandwiching a thin ferroelectric film between two conductive electrodes, which electrodes are usually made of platinum. The circuit configuration and the read/write sequence of this type of memory are similar to that of conventional dynamic random access memories (DRAM), except that no data refreshing is necessary in a FRAM. Known FRAMs have a fatigue problem that has been observed in the ferroelectric capacitor, which is one of the major obstacles that limit the viable commercial use of such memories. The fatigue is the result of a decrease in the switchable polarization (stored nonvolatile charge) that occurs with an increased number of switching cycles. As used in this case, "switching cycles" refers to the sum of reading and writing pulses in the memory.

Another known use of ferroelectric thin films in memory applications is to form a ferroelectric-gate-controlled field effect transistor (FET) by depositing the ferroelectric thin film directly onto the gate area of the FET. Such ferroelectric gate controlled devices have been known for some time and include devices known as metal-ferroelectric-silicon (MFS) FETs. FRAMs incorporating the MFS FET structure have two major advantages over the transistor-capacitor configuration: (1) The MFS FET occupies less surface area, and (2) provides a non-destructive readout (NDR). The latter feature enables a MFS FET device to be read thousands of times without switching the ferroelectric polarization. Fatigue, therefore, is not a significant concern when using MFS FET devices. Various forms of MFS FET structures may be constructed, such as metal ferroelectric insulators silicon (MFIS) FET, metalferroelectric metal silicon (MFMS) FET, and metal ferroelectric metal oxide silicon (MFMOS) FET.

JP 04 256361 A (D1), WO 96 13860 A (D3), JP 08 293565A (D4) and "Characteristics of NDRO Ferroelectric FETs with a Poly-Si Floating Gate" (D5) are examples of documents relating to semiconductor devices such as memories and FETs involving ferroelectric material.

There are a number of problems that must be overcome in order to fabricate an efficient MFS FET device. The first problem is that it is difficult to form an acceptable crystalline ferroelectric thin film directly on silicon. Such structure is shown in U.S. Patent No. 3,832,700. Additionally, it is very difficult to have a clean interface between the ferroelectric material and the silicon. Further, there is a problem retaining an adequate charge in the ferroelectric material. A FEM structure on a gate region is shown in U.S. Patent No. 5,303,182, which emphasizes that the transfer of metal ions into the gate region is undesirable. Similar structure is shown in U.S. Patent No. 5,416,735.

It is an object of this invention to overcome the aforementioned problems.

It is desirable to provide an MFS FET device which provides a non-destructive readout.

It is also desirable to provide an MFS FET device that occupies a relatively small surface area.

It is also desirable to provide an MFS FET device which requires a relatively low programming voltage.

It is also desirable to provide a FEM memory cell that has minimal leakage current.

It is also desirable to provide an MFS FET device that includes a MOS transistor overlaid with a FEM cell.

It is also desirable to provide an FEM gate unit which overlies a shallow junction p$^-$ layer, which p$^-$ layer extends beyond the margins of the FEM gate unit.

It is also desirable to provide an FEM cell that contains an easily formed diffusion barrier therein.

It is also desirable to provide an FEM cell that includes a drain electrode that contacts both an n$^+$ and a p$^-$ conductive surface.

It is also desirable to provde an FEM device that occupies a relatively small surafce area and requires a relatively low programming voltage.

It is also desirable to provide an FEM gate unit which has an asymmetric ferroelectric polarization.

SUMMARY OF THE INVENTION

The invention proves a method of forming a semi-conductor structure as set out in claim 1.

The method of forming the FEM cell semi-conductor structure includes forming a device area for the ferroelectric memory (FEM) gate unit on a silicon substrate. Appropriate impurities are implanted into the device area to form conductive channels, for use as a source junction region, a gate junction region and a drain junction region. A FEM cell includes a FEM gate unit formed on the substrate. A gate junction region is formed between the source junction region and the drain junction region for the FEM gate unit on the FEM gate unit device area, which FEM gate unit includes a lower metal layer, a ferroelectric (FE) layer, and an upper metal layer. A Schottky barrier or a very shallow junction layer is formed between the FEM gate unit and the gate junction region, as another conductive channel. The FEM gate unit is spaced apart from the source region and the drain region. Formation of the various conductive channels may take place at various stages of the manufacture, depending on what other devices are built on the substrate, and depending on the efficiencies of the various orders of construction.

The structure of the FEM cell semiconductor includes a substrate, which may be a bulk silicon substrate or an SOI-type substrate, conductive channels of first and second type formed above the substrate, an FEM gate unit formed above a gate region, wherein the FEM gate unit includes a lower metal layer, an FE layer, and an upper metal layer, and wherein a conductive channel of a third type is formed between the FEM gate unit and the gate region. The FEM cell may be constructed in series with a conventional MOS transistor.

The invention also provides a ferroelectric memory cell as set out in claim 14.

The ferroelectric memory (FEM) cell includes a silicon substrate, a gate region located in said substrate, doped to form a conductive channel of a first type, a source junction region and a drain junction region located in the substrate on either side of the gate region, doped to form a pair of conductive channels of a second type, a MOS capacitor, including an oxide layer and a conductive layer of a third type located over the gate junction region, wherein the MOS capacitor has a predetermined surface area, a FEM capacitor, including a lower metal layer, a FE layer and an upper metal layer; wherein the FEM capacitor is stacked on and overlays at least a portion of the MOS capacitor, thereby forming, with the MOS capacitor, a stacked gate unit, an insulating layer, having an upper surface, overlying the junction regions, the stacked gate unit, and the substrate, and a source electrode and a drain electrode, each located on the upper surface of the insulating layer and extending therethrough to make electrical contact with their respective junction regions, and a gate electrode located on the upper surface of said insulating layer and extending therethrough to make electrical contact with the upper metal layer of the stacked gate unit.

These and other objects and advantages of the invention will become more fully apparent as the description which follows is read in conjunction with the drawings.

BRIEF DESCRIPTION OF THE DRAWINGS

Figs. 1 and 2 depict exemplars of successive steps in the formation of the substrate used for the FEM cell of embodiments of the invention.

Fig. 3 depicts the FEM gate unit constructed on the substrate.

Fig. 4 depicts one embodiment of the FEM cell of the invention having a silicon layer formed under the FEM gate unit.

Fig. 5 depicts preparation of the substrate as used in an another embodiment of the invention.

Fig. 6 depicts an another embodiment of the FEM gate unit of the invention, formed on a p⁻ conducive layer.

Fig. 7 depicts current flow in the FEM cell of an embodiment of the invention.

Fig. 8 depicts the basic operation principle for the MFS FET devices of embodiments of the invention.

Fig. 9 is a graph of $I_D$ vs. $V_G$ for the FEM gate unit of embodiments of the invention.

Figs. 10-13 depict successive stages of preparation of the substrate and formation of an active region used for the FEM cell of an embodiment of the invention.

Fig. 14 depicts the completed two transistor memory cell as constructed on a bulk silicon substrate.

Fig. 15 depicts the completed two transistor memory cell as constructed on a SOI substrate.

Fig. 16 depicts an alternate embodiment of the completed two transistor memory cell as constructed on a SOI substrate.

Fig. 17 depicts a 4 X 4 array of the memory cells of an embodiment of the invention.

Fig. 18 depicts the basic operation principle for the MFS FET devices of an embodiment of the invention.

Fig. 19 is a graph of $I_D$ vs. $V_G$ for the FEM gate unit of an embodiment of the invention.

Fig. 20 depicts the substrate and an active region used for the FEM cell of an embodiment of the invention.

Fig. 21 depicts the substrate having a FEM gate unit formed thereon.

Fig. 22 depicts the FEM gate unit constructed on the substrate and surrounded by an insulating region.

Fig. 23 depicts the FEM gate unit of an embodiment of the invention on the substrate with the source, gate and drain regions formed.

Fig. 24 depicts the FEM cell of an embodiment of the invention having a shallow junction layer formed under the FEM gate unit.

Fig. 25 depicts the completed FEM cell of an embodiment of the invention, and also depicts current flow therethrough.

Fig. 26 depicts the basic operation principle for the MFS FET devices of an embodiment of the invention.

Fig. 27 is a graph of $I_D$ vs. $V_G$ for the FEM gate unit of an embodiment of the invention.

Figs. 28-30 depict successive stages preparation of the substrate and formation of an active region used for the FEM cell of an embodiment of the invention.

Fig. 31 depicts the FEM gate unit constructed on the substrate and surrounded by an insulating region.

Fig. 32 depicts the FEM gate unit of an embodiment of the invention on the substrate with the source, gate and drain regions formed.

Fig. 33 depicts the FEM cell of an embodiment of the invention having a shallow junction layer formed under the FEM gate unit.

Fig. 34 depicts the completed FEM cell of an embodiment of the invention, and also depicts current flow therethrough.

Fig. 35 depicts an alternate embodiment of the FEM cell formed on a bulk silicon substrate.

Fig. 36 depicts the alternate embodiment of the FEM cell formed on an SOI substrate.

Fig. 37 depicts the basic operation principle for the MFS FET devices of an embodiment of the invention.

Fig. 38 is a graph of $I_D$ vs. $V_G$ for the FEM gate unit of an embodiment of the invention.

Fig. 39 depict a silicon substrate which has been prepared to facilitate the construction of a FEM cell.

Fig. 40 depicts a single transistor offset stacked gate unit.

Figs. 41-45 depict successive steps in the construction of a stacked transistor gate.

Figs. 46-49 depict successive steps in the construction of a variation of the single transistor stacked gate unit.

Fig. 50 is a graph of the P - E hysteresis loop of the FE.

Figs. 51a and 51b are graphs of charge distribution of the device of the invention in a "O" state and a "1" state, respectively.

Fig. 52 is a graph of $I_D$ vs. $V_G$ for the FEM gate unit.

Fig. 53 depicts a FEM cell constructed according to an embodiment of the invention.

Fig. 54 is a graph of $I_D$ vs. $V_G$ for the FEM gate unit of an embodiment of the invention.

Fig. 55 depicts the P-E hysteresis loops for a variety of FEM gate units.

Fig. 56 depicts the basic operation principle for the MFS FET devices of an embodiment of the invention.

Fig. 57 depicts a memory array constructed according to an embodiment of the invention.

DESCRIPTION OF THE PREFERRED EMBODIMENTS

(Example 1)

The ferroelectric memory (FEM) cell of this example may be formed on a SOI (SIMOX) substrate, or, it may be formed in a bulk silicon substrate which has a $p^-$ well formed therein. The initial description will concentrate on the formation of the FEM gate unit on a SIMOX substrate. It should be appreciated that in some embodiments of the FEM gate unit, a MOS transistor is fabricated simultaneously with the ferroelectric memory cell by conventional means which are well known to those of ordinary skill in the art. Accordingly, for the sake of clarity, the drawings do not depict the formation of the MOS transistor.

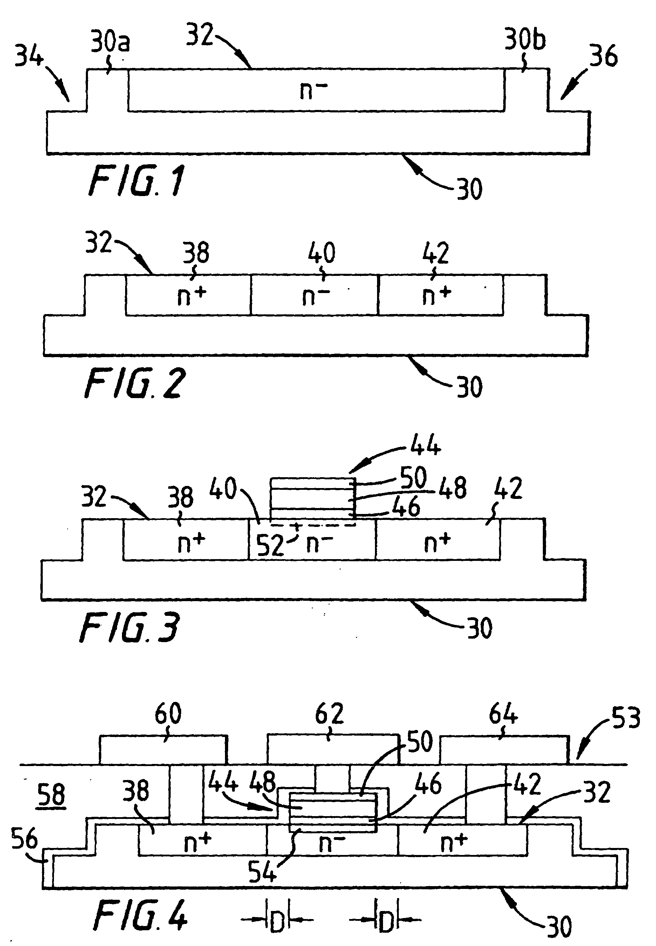

Turning now to Fig. 1, a SIMOX substrate is depicted at 30. Substrate 30, in the preferred embodiment, is formed of $SiO_2$, and is a single-crystal substrate. As depicted in Fig. 1, substrate 30 has been partially etched to the configuration depicted, and a portion of the substrate has been lightly doped to form an active region, or device area, 32, which provides a desired background polarity, in this case, that of an $n^-$ region. As is well known to those of a skill in the art a multiplicity of such regions are formed on the surface of a silicon wafer. For the FEM gate unit of the invention, the cells are arranged in a perpendicular grid to form a memory array.

The initial description is a general method of forming and preparing the substrate that the FEM gate unit will overlay, ultimately resulting in a FEM memory cell. Active region 32 is bordered by non-active, or insulation regions 30a, 30b, which, are upward extensions of substrate 30. An area of the substrate is trenched as depicted generally at 34, 36, which trench regions will ultimately be filled with an insulating material, usually $SiO_2$.

Turning now to Fig.2, active region 32 may be seen to have been modified to a source region 38, a gate region 40, a drain region 42. These regions are formed by applying a photoresist across active region 32 to mask what will ultimately be gate region 40, and implanting the appropriate ions in the remainder of active region 32 to form two $n^+$ layers, also referred to herein as conductive channels of a first type, which will serve as source region 38 and drain region 42. Appropriate ion implantation in this instance may be the implantation of As ions at a preferred energy of about 50 keV, although implantation in a range of 40 keV to 70 keV is acceptable and a dosing in a range of $2 \times 10^{15}$ $cm^{-2}$ to $5 \times 10^{15}$ $cm^{-2}$. Alternately phosphorus ions may be implanted in an energy range of 30 keV - 60 keV in the same dosing range. The wafer is then heat treated to activate and defuse the implanted ions. Temperature range for the heat treatment is in the range of 500°C to 1100°C.

At this point, formation of the FEM gate unit may begin. Referring now to Fig. 3, a FEM gate unit is identified generally at 44 and includes a lower electrode 46, the ferroelectric (FE) material 48 and an upper electrode 50. The construction of FEM gate unit 44 begins with the deposition of the lower electrode on gate region 40, also referred to herein as a conductive channel of a second type. Lower electrode 46 may be formed of Pt or Ir, an alloy of Pt/Ir, or other suitable conductive material. The thickness of this metal is 20 nm to 100 nm.

Next, the FE material is deposited by chemical vapor deposition (CVD). The FE material may be any of the following: $Pb(Zr,Ti)O_3$ (PZT), $SrBi_2Ta_2O_9$ (SBT), $Pb_5Ge_3O_{11}$, $BaTiO_3$, or $LiNbO_3$. The preferred compounds are, in order of preference $Pb_5Ge_3O_{11}$, SBT and PZT. Most of the experimental work in the FEM gate unit field has been done on PZT compounds. The FE material 48 is deposited to a thickness of 100 nm to 400 nm.

The upper electrode 50 is then formed over the FE material. The upper electrode may be formed of the same materials as the lower electrode, to a thickness of 20 nm to 200 nm. A conductive channel precursor is identified at 52. This precursor will ultimately become a metal silicide layer by diffusion of metal ion from lower electrode 46 into the gate region 40.

Photoresist is applied over the FEM gate unit, and the cell is then etched to the proper configuration and size. It should be appreciated that the three layers of the FEM gate unit need not be precisely aligned as shown, as their shape may be formed by applying a photoresist, and etching, with masks that have different geometries. However, for the sake of clarity, the FEM gate unit is depicted as a structure which has contiguous, aligned sidewalls.

Turning now to Fig. 4, FEM gate unit 44 is depicted as part of a FEM memory cell 53, which includes FEM gate unit 44 and the underlying source, channel and drain regions, which embodiment includes a thin layer of silicide 54 formed under FEM gate unit 44, where conductive channel precursor 52 was located. Silicide layer 54 may be formed prior to the deposition of the components of FEM gate unit 44, as described in connection with a second embodiment of the method of the invention, or, assuming that lower electrode 46 is formed of platinum (Pt), or an alloy thereof, the platinum may be allowed to diffuse into the upper portion of gate region 40, forming a shallow silicide layer which acts as a Schottky barrier, which is referred to herein as a conductive channel of a third type.

A layer of TiO, 56, or other suitable barrier insulation material is formed by CVD to protect the FEM gate unit. The TiO is etched to form the side wall insulator for the gate electrode. Photoresist is applied and appropriate $n^+$ and $p^+$ regions are formed by ion implantation. An oxide layer is formed by CVD, or, other suitable passivation insulation is applied. The structure is heat treated, at between 500°C and 1100°C, to allow passivation and diffusion of the implanted ions. To complete the description of FEM cell 53, bores are formed in oxide layer 58 and a source electrode 60, a gate electrode 62 and a drain electrode 64 and connected to their respective components.

The embodiment depicted in Fig. 4 represents the simplest case of the structure of the invention. The structure is a ferroelectric gate depletion-type MIS transistor. At zero gate voltage, the charge in the $n^-$ channel underlying the FEM gate unit is completely depleted. Accordingly, the leakage current is very small. In order to maintain the small leakage, the distance between the point at which any edge of lower electrode 46 contacts the $n^-$ silicon and the edges of the $n^+$ source or $n^+$ drain regions, represented by "D", has to be at least 50 nm in order that the leakage current remain small. However, as D increases, the series resistance of the memory cell also increases. It is therefore preferred that D be no larger than 300 nm. The gate leakage current is determined by the platinum to $n^-$ type silicon Schottky barrier and the platinum to ferroelectric material contact. The leakage current is the gate current at a very small up to moderate field intensity. The potential barrier between the platinum and $n^-$ type silicon is 0.9 eV. A potential barrier of this magnitude causes the $n^-$ type silicon channel to be completely depleted when the ferroelectric material is not polarized, or when the ferroelectric material is polarized with negative charge at the lower electrode. When the ferroelectric material is polarized with a positive charge at the lower electrode, the threshold voltage of the memory transistor is small. The nature of these memory charges and techniques for changing the amount of voltage necessary to the program the cells will be described later herein.

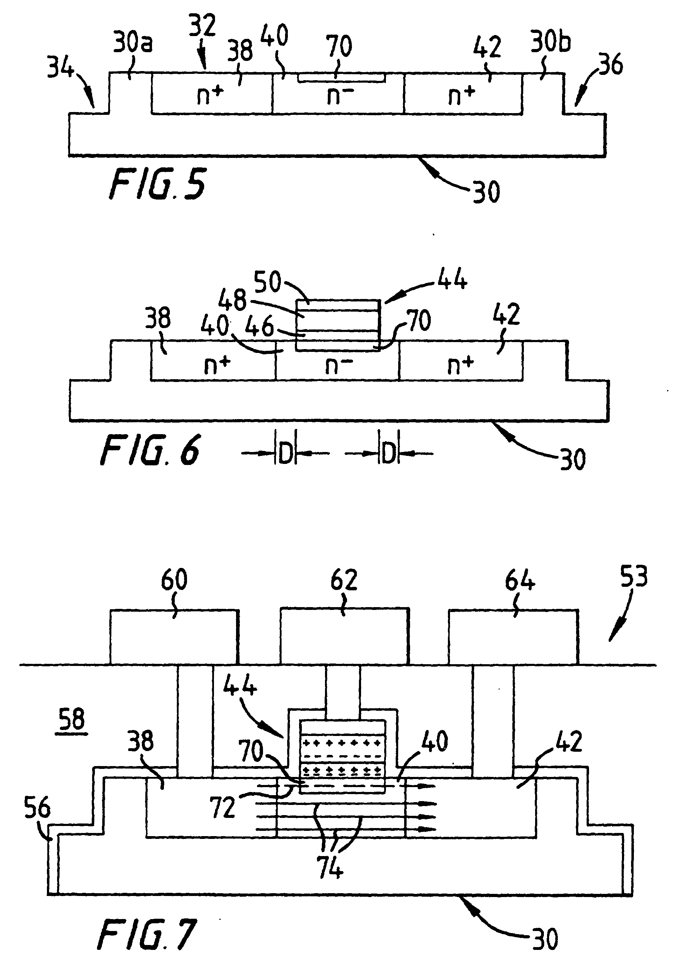

In another embodiment of the MFMS FET of the invention, and now referring to Fig. 5, a $p^-$ layer 70 may be formed in gate channel region 40 as a conductive channel precursor. Substrate 30 and active region 32 are formed as described in connection with Figs. 1 and 2. The $p^-$ layer may be formed by implanting B or $BF_2$ ions, or by diffusing metal ions from the FEM gate unit. Boron ions may be implanted at an energy of 3 keV to 10 keV, while $BF_2$ ions are implanted with an energy level of between 15 keV and 50 keV. Ion concentration in both instances are in the range of $1 \times 10^{11}$ cm$^{-2}$ to $1 \times 10^{13}$ cm$^{-2}$.

Using a bulk CMOS substrate as an example to explain the fabrication process, the initial step is to fabricate $n^-$ well and $p^-$ well structures, isolate these structures, and implant appropriate ions to provide threshold voltage adjustment for the transistors. Photoresist is used to mask the CMOS section of the wafer. Next, phosphorous ions, are implanted at an energy of between 30 keV to 120 keV, with a dose of $1.0 \times 10^{12}$ cm$^{-2}$ to $5.0 \times 10^{13}$ cm$^{-2}$ to the $p^-$ well where the FEM gate units are to be constructed. Multiple implantation steps, and/or thermal diffusion may be required to obtain an optimum donor distribution in the $n^-$ layer. The photoresist is stripped away. The implanted $n^-$ type silicon layer may also be replaced with a selective epitaxial growth of silicon with a thickness of 100 nm to 1000 nm. Boron (3 keV to 5 keV) or $BF_2$ (30 keV to 50 keV) ions are implanted, having a dose between $5.0 \times 10^{12}$ cm$^{-2}$ to $1.0 \times 10^{13}$ cm$^{-2}$. The ions are thermally activated.

Referring now to Fig. 6, the FEM gate unit is now constructed as previously described by depositing Pt, or other suitable material to form lower electrode 46. The thickness of this metal is 20 nm to 100 nm. Boron or $BF_2$ ions may be implanted. The FE material 48 is deposited to a thickness of 100 nm to 400 nm, and upper electrode 50 is formed by depositing Pt, or other suitable electrode material to a thickness of 20 nm to 200 nm. Photoresist is applied, and the upper and lower electrodes, and the FE are etched to provide appropriate spacing "D" from the source region and the drain region, as previously described. The photoresist is then stripped from the structure. As explained in connection with Fig. 4, TiO (56), or another suitable barrier insulator is deposited by CVD to protect ferroelectric material. The TiO is etched to form sidewall insulator at the gate electrode. Additional oxide may be used for this step. Photoresist is again applied, and $n^+$ ions are implanted. The photoresist is stripped away and oxide, or another suitable passivation insulator, is applied by CVD. The structure is heat treated to densify the passivation insulator and to activate implanted ions. Again, photoresist is applied, contact holes are etched, and the fabrication process completed by methods well known to those of skill in the art.

Regardless of the method used to form Schottky barrier 54 or shallow junction layer 70, the barrier structure serves to provide an efficient switching mechanism for the FEM cell.

Alternately, the source/drain ion implantation and annealing may be completed before the deposition of the lower gate electrode, if the ferroelectric material is unable to sustain high temperature heat treatment.

Operation:

The structure constructed according to the embodiment is particularly efficient because the FEM gate unit, located over the conductive channel on the gate region, is able to shift the polarity of the gate region allowing efficient current flow from the source through the gate to the drain. The structure provides for nearly total charge depletion when in an "off" condition, and efficient, low heat transmission of current when in an "on" condition. Fig. 7 is an enlarged view of the FEM cell, and depicts typical, prior art current flow represented by dashed line 72, wherein the current flows through gate region 40 only directly below the FEM gate unit. This is because known FEM cell configurations do not completely allow current flow through the gate region. Such structures may be thought of a switch that is partially "open." Solid lines 74 depict a completely "closed" switch of the instant invention, where current may flow through the entire gate region below barrier structure 70.

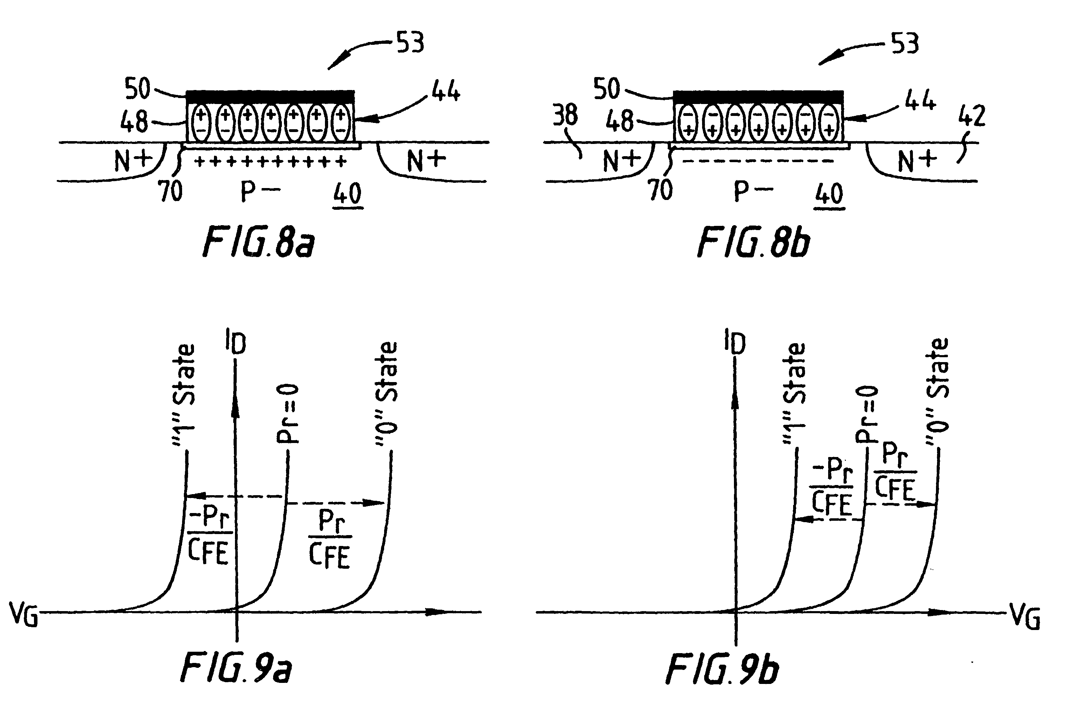

Memory cells may be placed in an array of memory cells such that the gate lines run perpendicular to the drain lines. In order to write to FEM gate unit 44, $+V_{p1}$ is applied to all gate electrodes, while the source and drain electrodes of the memory cell are at the ground potential. This polarizes FE 48 such that a positive charge is located at lower electrode 46 and a negative charge is located at upper electrode 50 (See Fig. 8b). This places FEM gate unit 44 in a high conductive state.

When a negative voltage, $-V_{p0}$, is applied to the gate electrode (program line), and a positive voltage, $+V_{p0}$ is applied to the drain, and the source is grounded, and where $|V_{p1}| > |V_{p0}|$, the FE is polarized with a negative charge at lower electrode 46. This places FEM gate unit 44 in a low conductive state (see Fig. 8a). The write process enables each memory transistor in a memory array to be written to independent of other memory cells in the array, with no interference to or from the threshold voltages of the other memory cells in the array.

The threshold voltage for FEM gate unit 44 may be determined as follows: for a large scale array the threshold voltage at the "1" state has to be a positive value, i.e., 0.4V to 0.8V. The threshold voltage for the "0" state has to be larger than the supply voltage, i.e., 3.3V. The n⁻ channel layer is depleted by the p⁻ type substrate junction as well as by the lower electrode Schottky barrier, or the very shallow p⁻ surface layer and the gate bias voltage. It can be shown that the memory window is equal to:

$$\Delta V_T = \frac{2Q_{FE}}{C_{FE}} \tag{1}$$

where $Q_{FE}$ is the remanent charge and $C_{FE}$ is the ferroelectric capacitance of the gate unit.

During a read operation, a voltage, $V_a$, of no larger than the coercive voltage, i.e., that voltage where the memory content may change, is applied to the gate electrode and the drain electrode. Because the content of the memory cell is not disturbed when any electrode is biased with $V_a$, the read operation will not disturb the memory contents of any memory cell. Therefor, a long charge retention is obtained.

A One Transistor Memory Cell:

The general $I_D$ vs. $V_G$ plot for the MFMOS FET is depicted in Fig. 9. Fig. 9a depicts the $I_D$ vs. $V_G$ characteristics of a FEM cell with high channel doping, $N_D$. The centerline is the $I_D$ vs. $V_O$ curve when the FEM gate unit is not charged. When the FEM cell is programmed to a "1" state, the threshold voltage of the FEM cell is negative. Thus, a large drain current may flow through the channel region even if $V_G = 0$ V. Such a device is not suitable for large scale array applications.

Fig. 9b depicts the $I_D$ vs. $V_G$ characteristics of a FEM cell with low channel doping $N_D$. The threshold voltage of the FEM cell when it is programmed to a "1" state is positive. No current may flow through the device when the gate is at ground potential. A large scale memory array of such devices will have a very small standby leakage current, and will not require frequent refreshing.

Ferroelectric $Pb_5Ge_3O_{11}$ Thin Film for MFMOS Applications:

It can be shown that the lower ferroelectric capacitance results in higher memory window and lower programming voltage. Thicker film and lower $\in_r$ material can result in lower ferroelectric capacitance; however, the former choice could increase the programming voltage if the switching field for ferroelectric is well defined. Common oxide ferroelectric materials exhibit higher $\in_r$ and $T_c$, while non-oxide ferroelectrics exhibit lower $\in_r$ and $T_c$. Oxide $Pb_5Ge_3O_{11}$ thin film has very low $\in_r$ and moderate $T_c$ (178°C). Table 1 compares the memory window of MFMOS devices with ferroelectric gate of $Pb_5Ge_3O_{11}$, PZT and $SrBi_2Ta_2O_9$ thin films. Even though the steady state polarization for $Pb_5Ge_3O_{11}$ thin film is much lower than that for PZT and $SrBi_2Ta_2O_9$ thin films, the memory window for $Pb_5Ge_3O_{11}$ gate controlled MFMOS device is larger than its counterparts due to its low $\in_r$.

Table 1:

| Memory Windows for MFMOS Devices with Various Ferroelectrics | | | |
|---|---|---|---|
| Ferroelectric | $Pb(Zr,Ti)O_3$ | $SrBi_2Ta_2O_9$ | $Pb_5Ge_3O_{11}$ |
| $P_r$ ($\mu C/cm^2$) | 15 | 7 | 3.5 |
| $\in_r$ | 1000 | 280 | 35 |
| $d_{Ferro}$ (Å) | 2000 | 2000 | 2000 |
| $V_{dep}$ (V) | 3.14 | 4.39 | 6.87 |
| $P_r^*$ ($\mu C/cm^2$) when $V_{dep}$ = 0.5V | 2.4 | 0.8 | 0.25 |
| Memory Window $2P_r^*$ / $C_{FF}$ (V) | 1.08 | 1.29 | 3.23 |
| Gate oxide ($SiO_2$) thickness: 100Å Steady state $V_{dep}$ is assumed to be 0.5V | | | |

Thus, a FEM memory cell, and a method of constructing same has been disclosed. The FEM gate unit may be constructed as a single transistor device, or it may be constructed with an associated MOS transistor. Although a preferred embodiment of the invention has been disclosed, it should be appreciated that further variations may be made to the architecture and method without departing from the scope of the invention as defined in the appended claims.

(Example 2)

The ferroelectric memory (FEM) cell of this example may be formed on a SOI (SIMOX) substrate, or, it may be formed in a bulk silicon substrate. The description herein will concentrate on the formation of the FEM gate unit on a bulk silicon substrate, however, as used herein, "silicon substrate" refers to either a SOI substrate or to a bulk silicon substrate. It should be appreciated that a MOS transistor and a FEM gate unit are fabricated sequentially or simultaneously in order to form the two transistor structure of the invention. The completed structure provides a cost effective, extremely small memory cell, that has a simple circuit configuration, provides a non-volatile memory, and has a very low leakage current.

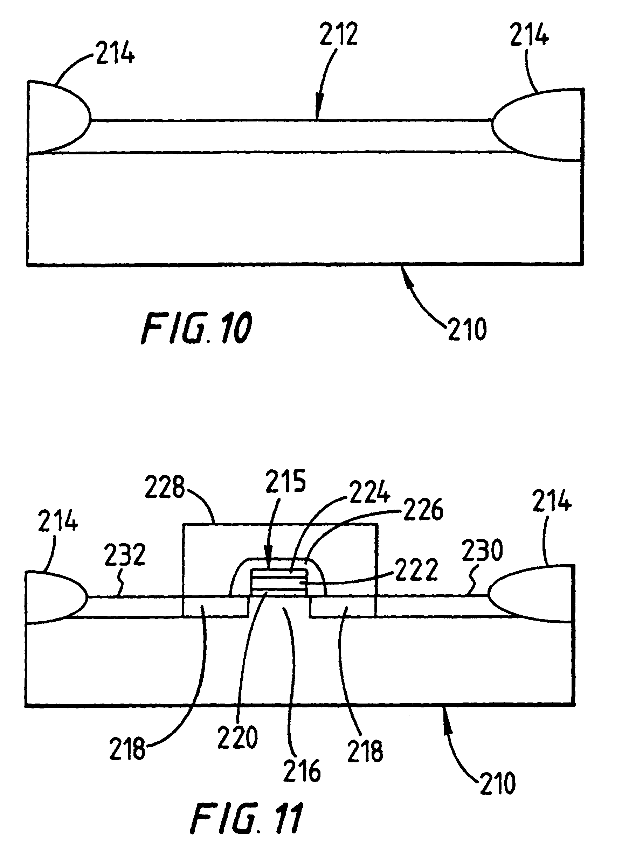

Turning now to Fig. 10, a silicon substrate is depicted at 210. Substrate 210, in this embodiment is a single-crystal substrate, and is formed of bulk silicon. As depicted in Fig 10, substrate 210 has been modified to the configuration depicted, and a portion of the substrate has been lightly doped to form an active region, or device area, 212, which provides a desired background polarity, in this case, that of an n⁻ region, referred to herein as a conductive channel of a first type. Phosphorous ions, also referred to herein as doping impurities of a first type, are implanted to form the conductive channel of the first type at an energy of between 30 keV to 120 keV, with a dose of $1.0 \cdot 10^{12}$ cm⁻² to $5.0 \cdot 10^{13}$ cm⁻² to the p⁻ well where the FEM gate units are to be constructed. Multiple implantation steps, and/or thermal diffusion may be required to obtain an optimum donor distribution in the n⁻ layer. The implanted n⁻ type silicon layer may also be replaced with a selective epitaxial growth of silicon with a thickness of 100 nm to 1000 nm. Active region 212 is bounded by an insulating region 214, formed of $SiO_2$ by thermal oxidation or deposited by chemical vapor deposition (CVD), to form LOCOS or mesa isolation between devices. As is well known to those of a skill in the art, a multiplicity of such active regions are formed on the surface of a silicon wafer. For the two transistor memory cell, the active regions are arranged in a perpendicular grid to form a memory array, as will be described later herein.

Referring now to Fig. 11, the construction of the semiconductor device of the embodiment is seen to have progressed to a point where a MOS transistor 215 has been formed on the substrate. Active region 212 has been modified to include a p⁻ well 216, which is accomplished by masking active region 212, and ion implantation. This p⁻ layer may be formed by implanting B or $BF_2$ ions, referred to herein as doping impurities of a second type, on active layer 212. Boron ions may be implanted at an energy of 3 keV to 10 keV, while $BF_2$ ions are implanted with an energy level of between 15 keV and 50 keV. Ion concentration in both instances is in the range of $5 \times 10^{11}$ cm⁻² to $1 \times 10^{13}$ cm⁻².

The ions are thermally activated by annealing. The implanted ions will diffuse into the n⁻ active region, to form a p⁻ n layer, referred to herein as a conductive channel of a second type. Annealing takes place at a temperature in a range of between 500 C and 1100 C. A channel region 218 the conductive channel of the first type, remains on either side of p⁻ well 216.

The lateral portions of active region 212 are masked, and a layer of $SiO_2$, 220, is formed by CVD over p⁻ well 216 and portions of channel regions 218. A layer of n⁺ polysilicon is deposited thereover, again by CVD. A layer of silicide 224, may be formed over the n⁺ polysilicon 222 by CVD, and functions as a part of the MOS transistor, which, although depicted in the drawing, is an optional portion of the method and structure of the embodiment. Another layer of $SiO_2$, 226, also referred to herein as a transistor insulating layer, is laid down by CVD.

Alternately, a layer of $SiO_2$ may be deposited on the non-masked regions of p⁻ well 216 and channel regions 218, the $SiO_2$ layer etched to form sidewalls, and, n⁺ polysilicon layer 222 and layer 224 deposited therein. A top layer of $SiO_2$ is deposited over the sidewalls and layer 224.

The MOS transistor is covered with a photo-resist 228, which covers MOS transistor 215 as well as the channel regions 218 for the FEM gate unit. The remainder of device area 212 is then treated by arsenic ion implantation to form an n⁺ silicon source region 230 and an n⁺ silicon drain region 232, referred to herein as conductive channels of a third type. Appropriate ion implantation in this instance may be the implantation of As ions at a preferred energy of about 50 keV, although implantation in a range of 40 keV to 70 keV is acceptable, and a dosing in a range of $1 \cdot 10^{15} cm^{-2}$ to $5 \cdot 10^{15} cm^{-2}$. Alternately, phosphorus ions may be implanted in an energy range of 30 keV - 60 keV in the same dosing range. In either case, the material implanted at this step of the construction is referred to herein as a doping impuriry of a third type.

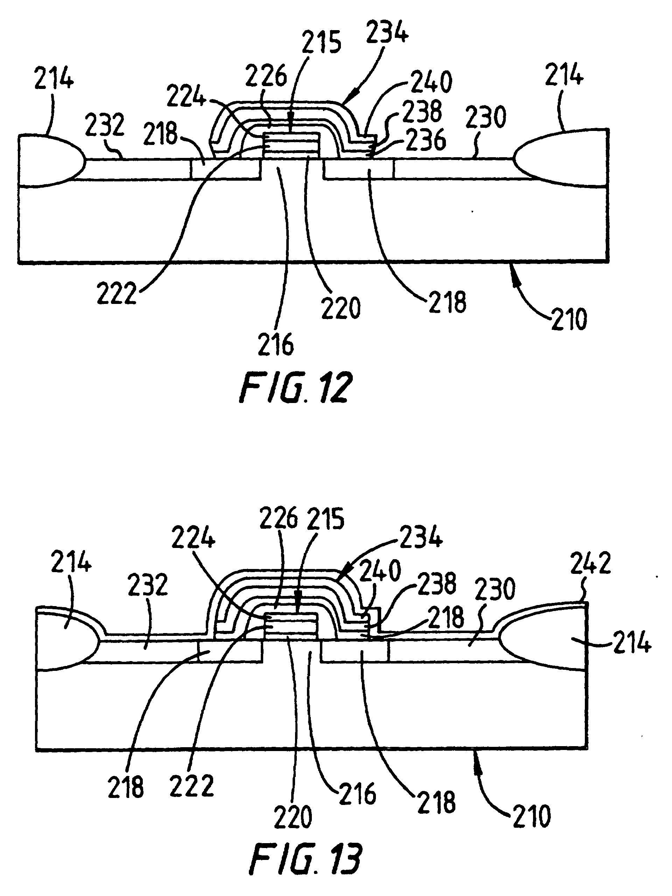

The photoresist is stripped away. Referring now to Fig. 12, FEM gate unit 234 is fabricated. Gate unit 234 includes a lower electrode 236, a FE layer 238, and an upper electrode 240. The construction of FEM gate unit 234 begins with the deposition of the lower electrode on $SiO_2$ layer 226, which extends partially over channel regions 218. Lower electrode 236 may be formed of Pt or Ir, $IrO_2$ or an alloy of Pt/Ir, or other suitable conductive material. Other appropriate conductive barrier layer material may also be used. The thickness of electrode 236 is 20 nm to 100 nm, in the preferred embodiment.

Next, FE material 238 is deposited by CVD. The FE material may be any of the following: $Pb(Zr, Ti)O_3$ (PZT), $SrBi_2Ta_2O_9$ (SBT), $Pb_5Ge_3O_{11}$, $BaTiO_3$, or $LiNbO_3$. The preferred compounds are, in order of preference, $Pb_5Ge_3O_{11}$, SBT and PZT. Most of the experimental work in the field of FEM gate units has been done on PZT compounds. FE material 238 is deposited to a thickness of 50 nm to 400 nm.

Upper electrode 240 is then formed over the FE material. The upper electrode may be formed of the same materials as the lower electrode, to a thickness of 20 nm to 200 nm.

Photoresist is applied over the FEM gate unit, and the cell is then etched to the proper configuration and size. It should be appreciated that the three layers of the FEM gate unit need not be precisely aligned as shown as their shape may be formed by applying a photoresist, and etching, with masks that have different geometries. However, for the sake of clarity, the FEM gate unit is depicted as a structure which has contiguous, aligned sidewalls.

Referring now to Fig. 13, the photo-resist is stripped from the FEM gate unit and a layer of $TiO_x$ 242, $Si_3N_4$, or other suitable dielectric material is deposited by CVD to isolate the ferroelectric material from the silicon oxide.

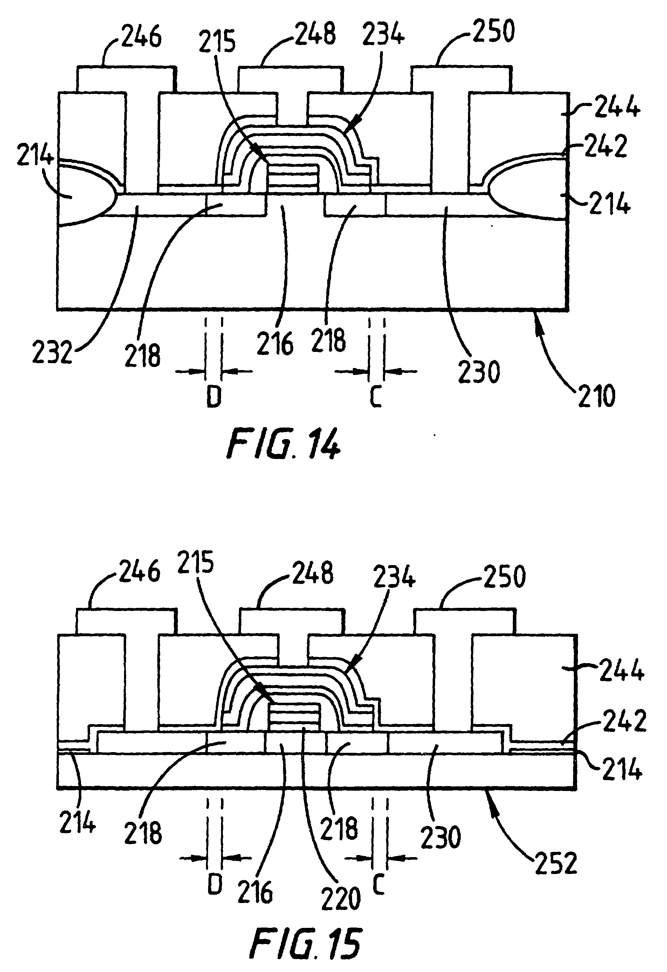

As shown in Fig. 14, the structure is completed with the deposition of a silicon oxide layer 244, a covering insulating layer, over the extend of the structure, and the milling and insertion of a drain electrode 246, a gate electrode 248, and a source electrode 250.

Referring now to Fig. 15, the structure is depicted as would be formed on an SOI substrate, which includes substantially all of the same components, referred to by like reference numbers, except that the substrate is formed of silicon oxide 252 rather than the bulk silicon used in the embodiment in Fig. 14.

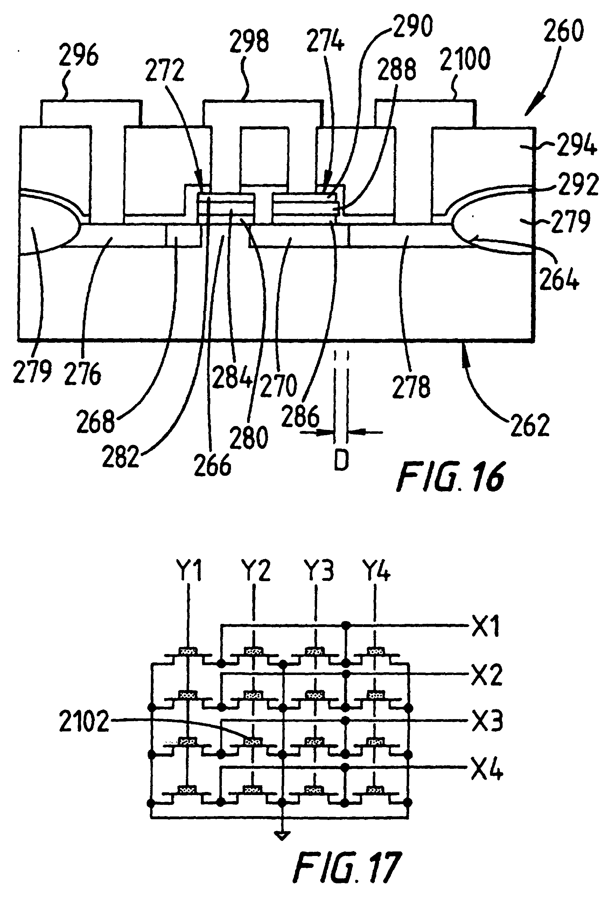

Turning now to Fig. 16, an alternate embodiment of the memory cell is depicted generally at 260. In this embodiment, and using bulk silicon as a substrate 262, an active region 264 is formed and subsequently modified into a p⁻ well 266, n⁻ regions 268, 270 which serve as gate region for the MOS transistor 272 and FEM cell 274, respectively. An n⁺ drain region 276 is formed as is an n⁺ source region 278. Oxide regions 279 flank active region 264, and are formed by thermal oxidation or by CVD. The materials for both MOS transistor 272 and FEM gate unit 274 are laid down sequentially, those layers being, for MOS transistor 272, an $SiO_2$ layer 280, an n⁺ polysilicon layer 282, and an optional silicide layer 284. FEM gate unit 274 is formed by depositing a bottom electrode 286, the FE material 288, and a top electrode 290. Next, a layer of $TiO_x$, $Si_3N_4$ or other suitable insulator, 292 is deposited by CVD, and a layer of $SiO_2$ 294 is deposited, also by CVD. Fabrication is completed by the installation of a drain electrode 296, a gate electrode 298, and a source electrode 2100. The MOS transistor and the FEM are isolated with the $TiO_x$ or $Si_3N_4$ layer. In this embodiment, layer 292 functions as a transistor insulating layer while layer 294 functions as a covering insulating layer.

Thus, several embodiments of a combination of a MFS transistor formed adjacent to a MOS transistor have been shown. As used herein, "adjacent" means that the two transistors are formed either along side one another, or that one transistor overlays the other.

The embodiments depicted in Figs. 14, 15 and 16 represent a ferroelectric gate depletion-type MIS transistor in combination with a conventional MOS transistor. The threshold voltage of the MFS transistor may be negative when the FE is polarized with a positive charge at the bottom electrode interface 238a. When the FE is polarized with a negative charge at the bottom electrode interface 238a, the threshold voltage of the MFS transistor is very large. At zero gate voltage, the MOS transistor is not conductive. Therefore, there is no current flow through the device even if the threshold voltage of the MFS transistor is negative.

When the gate voltage is equal to the operation voltage, the MOS transistor is very conductive. The device current is controlled by the current flow in the MFS transistor. When the MFS transistor is at "0" state, i.e., the threshold voltage is larger than the operation voltage, there is no current flow through the device. In order to maintain a small leakage current at the "0" state, the distance between any edge of lower electrode 236 and 286, and any edge of the $n^+$ source and $n^+$ drain regions represented by "D", has to be at least 50 nm. However, as D increases, the series resistance of the memory cell also increases. It is therefore preferred that D be no larger than 300 nm. When the MFS transistor is at the "1" state, i.e., the threshold voltage is very low, or has a negative value, both the MOS transistor and the MFS transistor are conductive. Therefore, a large current can flow through the device. This enables the device to be used in large scale memory arrays even if the "1" state threshold voltage of the MFS transistor is a negative value.

Operation:

Memory cells may be placed in an array of memory cells such that the gate lines run perpendicular to the drain lines, as shown in Fig. 17. Referring now to Figs. 14, 17 and 18, in order to write to FEM gate unit 234, $+V_{p1}$ is applied to all gate electrodes 248, (Y1, Y2, Y3 and Y4), while the source electrodes 250 and drain electrodes 246 (X1, X2, X3 and X4) of the memory cell are at the ground potential. This polarizes FE 238 such that a positive charge is located at lower electrode interface 238a and a negative charge is located at upper electrode interface 238b (See Fig. 18b). This places FEM gate unit 234 in a high conductive state.

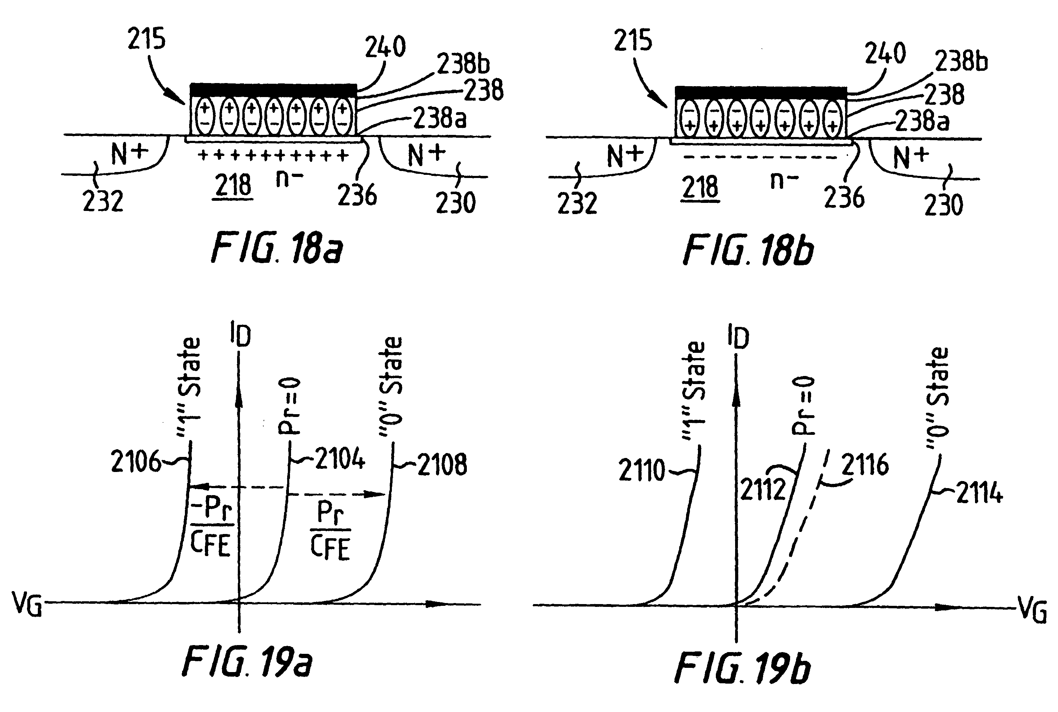

When a negative voltage, $-V_{po}$, is applied to the gate electrode 248 (program line), Y2 for instance, a positive voltage, $+V_{po}$ is applied to drain 232, X3 for instance, and source 230 is grounded, and where $|V_{p1}| > |V_{po}|$, the FE, such as 2102, X3, Y2, is polarized with a negative charge at lower electrode interface 238a. This places FEM gate unit 234 in a low conductive state (see Fig. 18a). The write process enables each memory transistor in a memory array to be written to independent of other memory cells in the array, with no interference to the other memory cells in the array.

The threshold voltage for FEM gate unit 215, 274, shown in Figs. 14 and 16, may be determined as follows: for a large scale array the threshold voltage at the "1" state may be negative or a small positive voltage. The threshold voltage for the "0" state has to be larger than the supply voltage, i.e., 3.3 V.

The width of the space in the $n^-$ region of a Pt-n silicon barrier is about 0.3 $\mu$m if the doping density of the n-region is about $1.0 \cdot 10^{16} cm^{-3}$. The threshold voltage may be adjusted by changing the doping density and the thickness of the $n^-$ channel layer, and the permitivity and the remnant charge of the ferroelectric capacitor.

During a read operation, a voltage, $V_a$, of no larger than the coercive voltage, i.e., that voltage where the memory content may change, is applied to the gate electrode and the drain electrode. Because the content of the memory cell is not disturbed when any electrode is biased with $V_a$, the read operation will not disturb the memory contents of any memory cell. Therefore, a long charge retention is obtained.

The general $I_D$ vs. $V_G$ plot for the MFMOS FET is depicted in Fig. 19. Fig. 19a depicts the $I_D$ vs. $V_G$ characteristics of a FEM cell with high channel doping, $N_D$. The centerline 2104 is the $I_D$ vs. $V_o$ curve when the FEM gate unit is not charged. When the FEM cell is programmed to a "1" state, line 2106, the threshold voltage of the FEM cell is negative. When the FEM cell is programmed to a "0" state, line 2108, the threshold voltage of the FEM cell is positive. Thus, at the "1" state, a large drain current may flow through the channel region even if $V_G = 0$ V. Such a device alone is not suitable for large scale array applications.

Fig. 19b depicts the $I_D$ Vs. $V_G$ characteristics of the device of this embodiment. Line 2112 depicts the $I_D$ vs. $V_o$ curve when the FEM gate unit is not charged. When the FEM cell is programmed to a "1" state, line 2110, the threshold voltage of the FEM cell is negative. When the FEM cell is programmed to a "0" state, line 2114, the threshold voltage of the FEM cell is positive. The threshold voltage, dashed line 2116, of the MOS transistor limited the threshold voltage of the device to a small positive value when it is programmed to a "1" state. No current may flow through the device when the gate is at ground potential. A large scale memory array of such devices will have a very small standby leakage current.

Thus, a two-transistor memory cell, including a MOS transistor and an FEM gate unit, and a method of constructing same has been disclosed. Although a preferred embodiment of the invention, and a variation thereof have been disclosed, it should be appreciated that further variations may be made to the architecture and method without departing from the scope of the invention as defined in the appended claims.

(Example 3)

The ferroelectric memory (FEM) cell of this example may be formed on a SOI (SIMOX) substrate, or, it may be formed in a bulk silicon substrate. The description herein will concentrate on the formation of the FEM gate unit on a bulk silicon substrate. It should be appreciated that in some embodiments of the FEM gate unit, a MOS transistor is fabricated simultaneously with the ferroelectric memory cell by conventional means which are well known to those of ordinary skill in the art. Accordingly, for the sake of clarity, the drawings do not depict the formation of the MOS transistor.

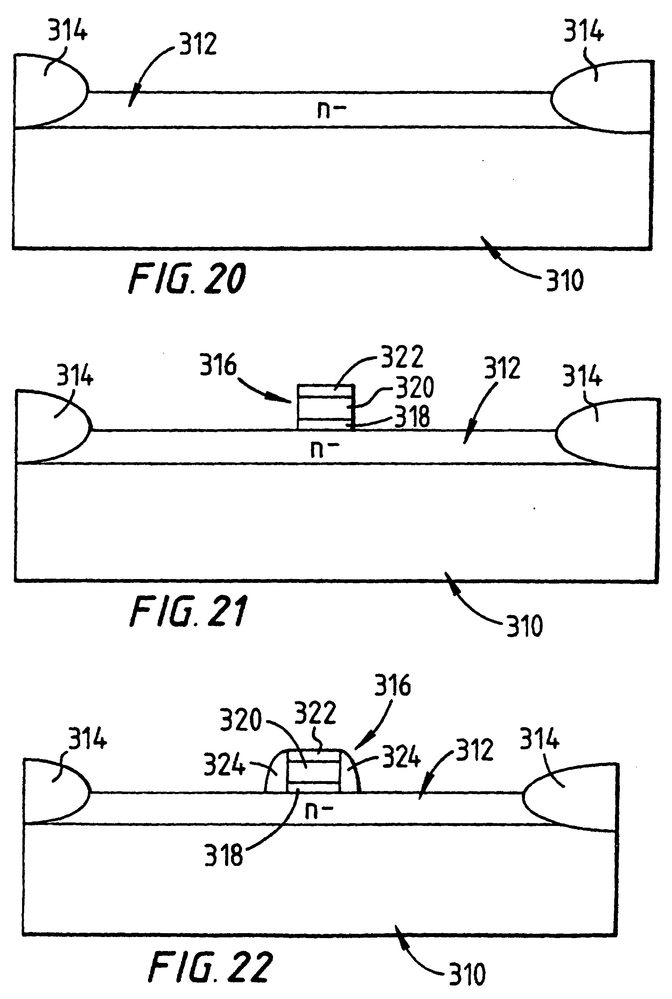

Turning now to Fig. 20, a silicon substrate is depicted at 310. Substrate 310, in the preferred embodiment is a single-crystal substrate, and is formed of bulk silicon. Other embodiments may be formed on a SOI substrate. As used herein, "silicon substrate" refers to either a bulk silicon substrate or a SOI substrate, or to any other suitable silicon-based substrate. As depicted in Fig. 20, substrate 310 has been partially etched to the configuration depicted, and a portion of the substrate has been lightly doped to form an active region, or device area, 312, which provides a desired background polarity, in this case, that of an n$^-$ region, referred to herein as a conductive channel of a first type. Active region 312 is bounded by an insulating region 314, formed of SiO$_2$. As is well known to those of a skill in the art, a multiplicity of such regions are formed on the surface of a silicon wafer. For the FEM gate unit of the embodiment, the cells are arranged in a perpendicular grid to form a memory array.

Using a bulk CMOS substrate as an example to explain the fabrication process, the initial step is to fabricate n$^-$ well and p$^-$ well structures, isolate these structures, and implant appropriate ions to provide threshold voltage adjustment for the transistors. Photoresist is used to mask sections of the wafer. Next, phosphorous ions, also referred to herein as doping impurities of a first type, are implanted at an energy of between 30 keV to 120 keV, with a dose of 1.0x10$^{12}$ cm$^{-2}$ to 5.0x10$^{13}$ cm$^{-2}$ to the p$^-$ well where the FEM gate units are to be constructed. Multiple implantation steps, and/or thermal diffusion may be required to obtain an optimum donor distribution in the n$^-$ layer. The photoresist is stripped away. The implanted n$^-$ type silicon layer may also be replaced with a selective epitaxial growth of silicon with a thickness of 100 nm to 1000 nm.

At this point, formation of the FEM gate unit may begin. Referring now to Fig. 21, a FEM gate unit is identified generally at 316 and includes a lower metal layer, or electrode, 318, the ferroelectric (FE) material 320, and an upper metal layer, or electrode, 322. The construction of FEM gate unit 316 begins with the deposition of the lower electrode on active region 312. Lower electrode 318 may be formed of Pt, Ir, IrO$_2$, or an alloy of Pt/Ir, or other suitable conductive material. The thickness of this metal is 20 nm to 100 nm, in the preferred embodiment.

Ultimately, a p$^-$ layer will be formed between FEM gate unit 316 and the gate junction region. The p$^-$ layer may be formed by implanting B or BF$_2$ ions into the surface of the conducting channel of the first type, or into lower electrode 318. Boron ions may be implanted at an energy of 3 keV to 10 keV, while BF$_2$ ions are implanted with an energy level of between 15 keV and 50 keV. Ion concentration in both instances are in the range of 1·10$^{11}$cm$^{-2}$ to 1·10$^{13}$cm$^{-2}$. During an annealing step, described later herein, the implanted ions will diffuse into an n$^-$ gate junction region, to form a p$^-$ layer, referred to herein as a conductive channel of a third type.

Next, the FE material is deposited by chemical vapor deposition(CVD), after appropriate masking. The FE material may be any of the following: Pb(Zr,Ti)O$_3$(PZT), SrBi$_2$Ta$_2$O$_9$(SBT), Pb$_5$Ge$_3$O$_{11}$, BaTiO$_3$, or LiNbO$_3$. The preferred compounds are, in order of preference, Pb$_5$Ge$_3$O$_{11}$, SBT and PZT. Most of the experimental work in the FEM gate unit field has been done on PZT compounds. The FE material 320 is deposited to a thickness of 50 nm to 400 nm.

The upper electrode 322 is then formed over the FE material. The upper electrode may be formed of the same materials as the lower electrode, to a thickness of 20 nm to 200 nm. Photoresist is applied over the FEM gate unit, and the cell is then etched to the proper configuration and size. It should be appreciated that the three layers of the FEM gate unit need not be precisely aligned as shown, as their shape may be formed by applying a photoresist, and etching, with masks that have different geometries. However, for the sake of clarity, the FEM gate unit is depicted as a structure which has contiguous, aligned sidewalls.

A layer of TiO$_x$, Si$_3$N$_4$, or other suitable barrier insulation material, 324, as shown in Fig. 22, is formed by CVD to protect the FEM gate unit. The barrier insulation material is etched to form the sidewall insulator for the gate electrode.

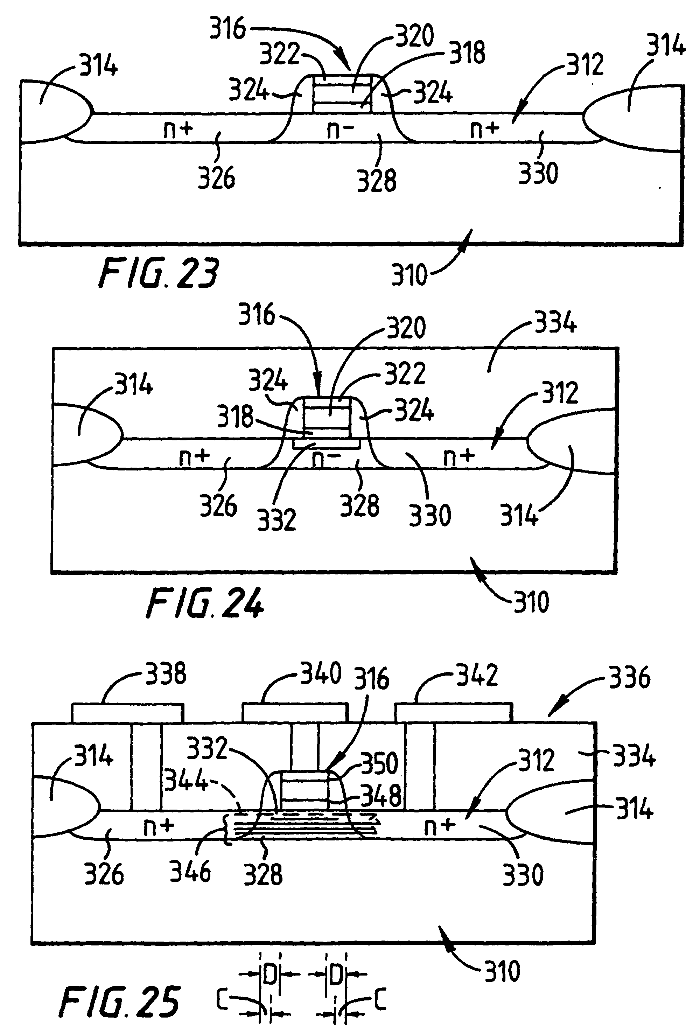

Turning now to Fig. 23, active region 312 may be seen to have been modified to a source region 326, a gate region 328, a drain region 330. These regions are formed by implanting the appropriate ions, also referred to herein as doping impurities of a second type, in the remainder of active region 312 to form two n$^+$ layers, also referred to herein as conductive channels of a second type, which will serve as source region 326 and drain region 330. Appropriate ion implantation in this instance may be the implantation of As ions at a preferred energy of about 50 keV, although implantation in a range of 40 keV to 70 keV is acceptable, and a dosing in a range of 1·10$^{15}$cm$^{-2}$ to 5·10$^{15}$cm$^{-2}$. Alternately, phosphorus ions may be implantated an energy range of 30 keV - 60 keV in the same dosing range.

Referring now to Fig. 24, the wafer is heat treated to activate and diffuse the implanted ions, both in the source region and drain region, and in the lower electrode. Diffusion of the ions implanted in lower electrode 318 results in the formation of a shallow junction 332 under FEM gate unit 316, which is the conductive channel of a third type. Temperature range for the heat treatment is in the range of 500°C to 1100°C, to allow passivation and diffusion of the implanted ions. A layer 334 of $SiO_2$ is then formed over the structure by CVD, or, other suitable passivation insulation is applied.

Turning now to Fig. 25, FEM gate unit 316 is depicted as part of a FEM memory cell 336, which includes FEM gate unit 316 and the underlying source, channel and drain regions, which embodiment includes a thin shallow junction region 332, which is a p⁻ layer, formed under FEM gate unit 316.

To complete the description of FEM cell 336, bores are formed in oxide layer 334 to receive a source electrode 338, a gate electrode 340 and a drain electrode 342 which are connected to their respective components.

The embodiment depicted in Fig. 25 represents a ferroelectric gate depletion-type MIS transistor. At zero gate voltage, the charge in the n⁻ channel underlying the FEM gate unit is completely depleted. Accordingly, the leakage current is very small. In order to maintain the small leakage, the distance between any edge of lower electrode 318 and the edges of the n⁻ source or n⁻ drain regions, represented by "D", has to be at least 50 nm in order that the leakage current remain small. However, as D increases, the series resistance of the memory cell also increases. It is therefore preferred that D be no larger than 300 nm. The gate leakage current is determined by the p⁻ type silicon shallow junction 332 and the platinum to ferroelectric material contact. The potential barrier between the platinum and n⁻ type silicon is 0.9 eV. The potential barrier between the p⁻ conductive layer of the third type 332 and the n⁻ conductive layer of the first type 328 is also on the order of 0.9 eV. A potential barrier of this magnitude causes the n⁻ type silicon channel to be completely depleted when the ferroelectric material is not polarized. When the ferroelectric material is polarized with positive charge at the lower electrode interface 348, the threshold voltage is small. When the ferroelectric material is polarized with a negative charge at the lower electrode interface 348, the threshold voltage of the memory transistor is very large. The nature of these memory charges and techniques for changing the amount of voltage necessary to the program the cells will be described later herein.

Diffusion of implanted B or $BF_2$ ions into the gate junction region is controlled to maintain a distance "C" between any edge of shallow junction layer 332 and the source and drain regions. In the preferred embodiment, "C" is between about 0 nm and 300 nm. The shallow junction structure serves to provide a reliable potential barrier between gate region 328 and the conducting channels for low leakage current and provides an efficient switching mechanism for the FEM cell of the embodiment.

Alternately, the source/drain ion implantation and annealing may be completed before the deposition of the lower gate electrode, if the ferroelectric material is unable to sustain high temperature heat treatment.

Operation:

The structure constructed according to the embodiment is particularly efficient because the FEM gate unit, located over the conductive channel on the gate region, is able to shift the polarity of the gate region, allowing efficient current flow from the source through the channel to the drain. The structure provides a total charge depletion when in an "off" condition. Fig. 25 also depicts typical, prior art current flow, represented by dashed line 344, wherein the current flows through gate region 328 only directly below the FEM gate unit. This is because known FEM cell configurations are surface-inversion type structures, while the device disclosed herein is of the depletion type. The operating theory of a depletion-type device is similar to that of a junction FET. Solid lines 346 depict current flow through the device of the invention, where current may flow through the entire gate region below junction 332.

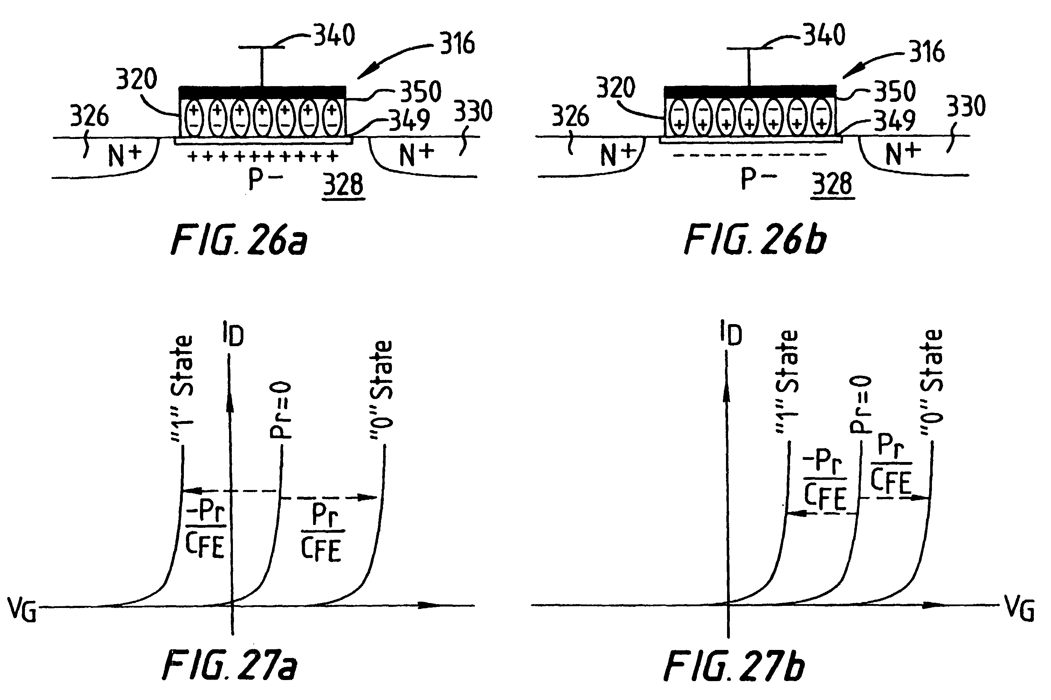

Memory cells constructed according to the embodiment may be placed in an array of memory cells such that the gate lines run perpendicular to the drain lines. When a negative voltage, $-V_{p0}$ is applied to the gate electrode 340 (program line), and a positive voltage, $+V_{po}$ is applied to the drain 330 and the source 326 is grounded, and where | $V_{p1}$ | > | $V_{p0}$ | , the FE is polarized with a negative charge at lower electrode interface 348. This places FEM gate unit 316 in a low conductive state (see Fig. 26a). The write process enables each memory transistor in a memory array to be written to independent of other memory cells in the array, with no interference to the other memory cells in the array.

In order to write to FEM gate unit 316, $+V_{p1}$ is applied to all gate electrodes 340 while the source electrodes 338 and drain electrodes 342 of the memory cell are at the ground potential. This polarizes FE 320 such that a positive charge is located at lower electrode interface 348 and a negative charge is located at upper electrode interface 350 (See Fig. 26b). This places FEM gate unit 316 in a high conductive state.

The threshold voltage for FEM gate unit 316 may be determined as follows: for a large scale array the threshold voltage at the "1" state has to be a small positive value, i.e., 0.4V to 0.8V. The threshold voltage for the "0" state has to be larger than the supply voltage, i.e., 3.3 V. The n⁻ channel layer is depleted by the p-type substrate junction as well as by the very shallow p⁻ surface layer and the gate bias voltage. It can be shown that the memory window is equal to:

$$\Delta V_T = \frac{2Q_{FE}}{C_{FE}} \qquad (2)$$

where $Q_{FE}$ is the remnant charge and $C_{FE}$ is the ferroelectric capacitance of the gate unit.

During a read operation, a voltage, $V_a$, no larger than the coercive voltage, i.e., the voltage where the memory content may change, is applied to the gate electrode and the drain electrode. Because the content of the memory cell is not disturbed when any electrode is biased with $V_a$, the read operation will not disturb the memory contents of any memory cell. Therefore, a long charge retention is obtained.

A One Transistor Memory Cell:

The general $I_D$ vs. $V_G$ plot for the MFMS FET is depicted in Fig.27. Fig. 27a depicts the $I_D$ vs. $V_G$ characteristics of a FEM cell with high channel doping, $N_D$. The centerline is the $I_D$ vs. $V_o$ curve when the FEM gate unit is not charged. When the FEM cell is programmed to a "1" state, the threshold voltage of the FEM cell is negative. Thus, a large drain current may flow through the channel region even if $V_G = 0V$. Such a device is not suitable for large scale array applications.

Fig. 27b depicts the $I_D$ Vs. $V_G$ characteristics of a FEM cell with low channel doping $N_D$. The threshold voltage of the FEM cell when it is programmed to a "1" state is positive. No current may flow through the device when the gate is at ground potential. A large scale memory array of such devices will have a very small standby leakage current.

Ferroelectric $Pb_5Ge_3O_{11}$ Thin Film for MFMS Applications:

It can be shown that the lower ferroelectric capacitance results in higher memory window and lower programming voltage. Thicker film and lower $\in_r$ material can result in lower ferroelectric capacitance; however, the former choice could increase the programming voltage. Oxide $Pb_5Ge_3O_{11}$ thin film has very low $\in_r$ and moderate $T_c$ (178°C). Even though the steady state polarization for $Pb_5Ge_3O_{11}$ thin film is much lower than that for PZT and $SrBi_2Ta_2O_9$ films, the memory window for $Pb_5Ge_3O_{11}$ gate controlled MFMS device is larger than its counterparts due to its low $\in_r$.

Thus, a FEM memory cell, and a method of constructing same has been disclosed. The FEM gate unit may be constructed as a single transistor device, or it may be constructed with an associated MOS transistor. Although a preferred embodiment of the invention has been disclosed, it should be appreciated that further variations may be made to the architecture and method without departing from the scope of the invention as defined in the appended claims.

(Example 4)

The ferroelectric memory (FEM) cell of the example may be formed on a SOI (SIMOX) substrate, or, it may be formed in a bulk silicon substrate. The description herein will concentrate on the formation of the FEM gate unit on a bulk silicon substrate, however, as used herein, "silicon substrate" refers to either a SOI substrate or to a bulk silicon substrate. It should be appreciated that in some embodiments of the FEM gate unit, a MOS transistor is fabricated simultaneously with the ferroelectric memory cell by conventional means which are well known to those of ordinary skill in the art. Accordingly, for the sake of clarity, the drawings do not depict the formation of the MOS transistor.

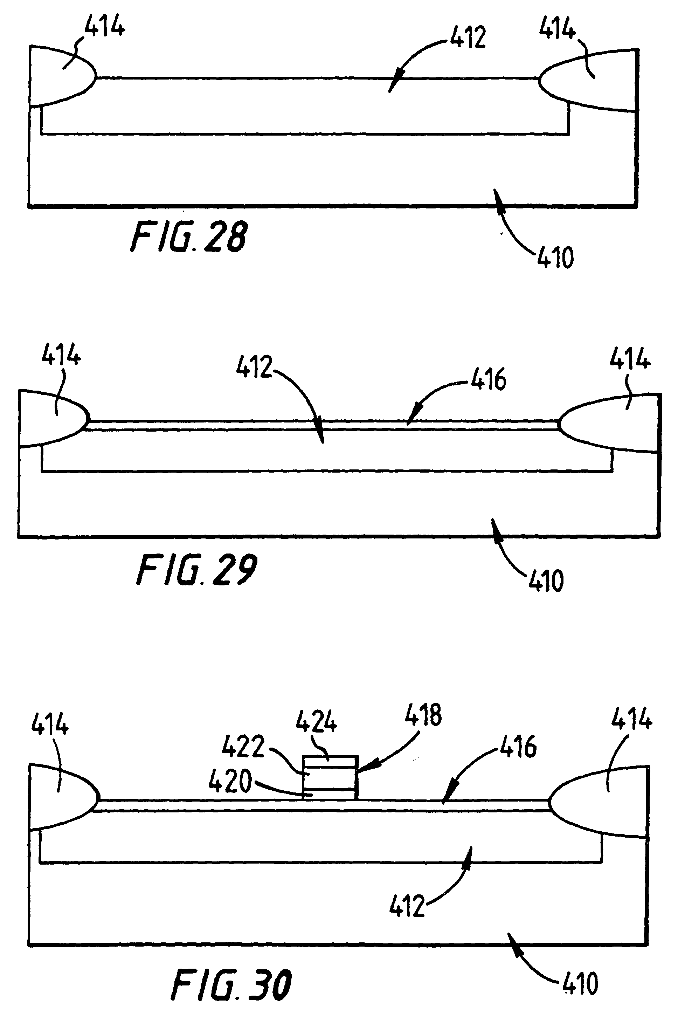

Turning now to Fig. 28, a silicon substrate is depicted at 410. Substrate 410, in this embodiment is a single-crystal substrate, and is formed of bulk silicon. As depicted in Fig. 28, substrate 410 has been partially etched to the configuration depicted, and a portion of the substrate has been lightly doped to form an active region, or device area, 412, which provides a desired background polarity, in this case, that of an n⁻ region, referred to herein as a conductive channel of a first type. Active region 412 is bounded by an insulating region 414, formed of $SiO_2$. As is well known to those of a skill in the art, a multiplicity of such regions are formed on the surface of a silicon wafer. For the FEM gate unit of the embodiment, the cells are arranged in a perpendicular grid to form a memory array.

Using a bulk CMOS substrate as an example to explain the fabrication process, the initial step is to fabricate n⁻ well and p⁻ well structures, isolate these structures, and implant appropriate ions to provide threshold voltage adjustment for the transistors. Substrate 410, in this embodiment, has been made into p⁻ silicon, or a p⁻ well. Photoresist is used to mask sections of the wafer. Next, phosphorous ions, also referred to herein as doping impurities of a first type, are implanted at an energy of between 30 keV to 120 keV, with a dose of $1.0 \times 10^{12} cm^{-2}$ to $5.0 \times 10^{13} cm^{-2}$ to the p⁻ well where the FEM gate units are to be constructed. Multiple implantation steps, and/or thermal diffusion may be required to obtain an optimum donor distribution in the n⁻ layer. The photoresist is stripped away. The implanted n⁻ type silicon layer may also be replaced with a selective epitaxial growth of silicon with a thickness of 100 nm to 1000 nm.

Referring now to Fig. 29, a p⁻⁻ layer 416 is next formed on active region 412. This p⁻ layer may be formed by implanting B or $BF_2$ ions, referred to herein as doping impurities of a second type, on active layer 412. Boron ions may be implanted at an energy of 3 keV to 10 keV, while $BF_2$ ions are implanted with an energy level of between 15 keV and 50 keV. Ion concentration in both instances is in the range of $5 \times 10^{11} cm^{-2}$ to $1 \times 10^{13} cm^{-2}$. The ions are thermally activated by annealing. The implanted ions will diffuse into the n⁻ active region, to form a p⁻n layer, referred to herein as a conductive channel of a second type. Annealing takes place at a temperature in a range of between 500°C and 1100°C.

At this point, formation of the FEM gate unit may begin. Referring now to Fig. 30, a FEM gate unit is identified generally at 418 and includes a lower metal layer, or electrode, 420, the ferroelectric (FE) material 422, and an upper metal layer, or electrode, 424. The construction of FEM gate unit 418 begins with the deposition of the lower electrode on $p^-$ layer 416. Lower electrode 420 may be formed of Pt or Ir, $IrO_2$, or an alloy of Pt/Ir, or other suitable conductive material. Other appropriate conductive barrier layer material may also be used. The thickness of electrode 420 is 20 nm to 100 nm, in the preferred embodiment.

Next, the FE material is deposited by chemical vapor deposition (CVD). The FE material may be any of the following: $Pb(Zr,Ti)O_3$ (PZT), $SrBi_2Ta_2O_9$ (SBT), $Pb_5Ge_3O_{11}$, $BaTiO_3$, or $LiNbO_3$. The preferred compounds are, in order of preference, $Pb_5Ge_3O_{11}$, SBT and PZT. Most of the experimental work in the FEM gate unit field has been done on PZT compounds. The FE material 422 is deposited to a thickness of 100 nm to 400 nm.

The upper electrode 424 is then formed over the FE material. The upper electrode may be formed of the same materials as the lower electrode, to a thickness of 20 nm to 200 nm.

Photoresist is applied over the FEM gate unit, and the cell is then etched to the proper configuration and size. It should be appreciated that the three layers of the FEM gate unit need not be precisely aligned as shown, as their shape may be formed by applying a photoresist, and etching, with masks that have different geometries. However, for the sake of clarity, the FEM gate unit is depicted as a structure which has contiguous, aligned sidewalls.

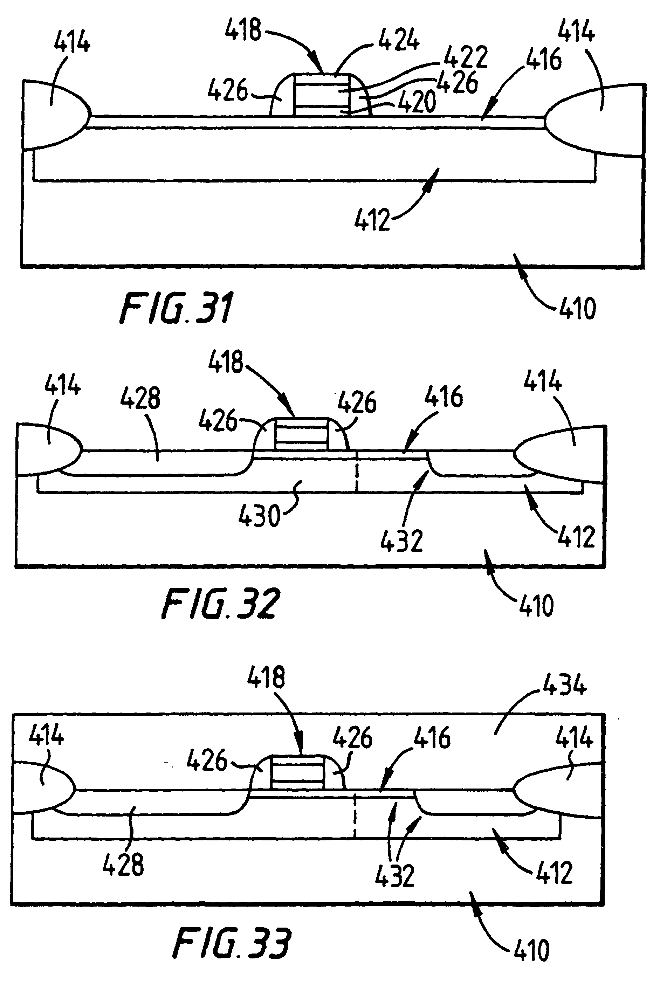

A layer of $TiO_x$, 426, as shown in Fig. 31, or other suitable barrier insulation material is formed by CVD to protect the FEM gate unit. The $TiO_x$ is etched to form the sidewall insulator for the gate electrode.

Turning now to Fig. 32, active region 412 may be seen to have been modified to a source region 428 a gate region 430, a drain region 432. These regions are formed by applying a photoresist across active region 412, $p^-$ layer 416 and FEM gate unit 418 to mask what will ultimately be gate region 430, and implanting the appropriate ions, also referred to herein as doping impurities of a third type, in the remainder of active region 412 to form two $n^+$ layers, also referred to herein as conductive channels of a third type, which will serve as source region 428 and drain region 432. It should be noted that $p^-$ layer 416 extends over gate junction region 430 and partially over drain junction region 432. Appropriate ion implantation in this instance may be the implantation of As ions at a preferred energy of about 50 keV, although implantation in a range of 40 keV to 70 keV is acceptable, and a dosing in a range of $1 \times 10^{15} cm^{-2}$ to $5 \times 10^{15} cm^{-2}$. Alternately, phosphorus ions may be implanted in an energy range of 30 keV - 60 keV in the same dosing range.

Referring now to Fig. 33, the wafer is heat treated to activate and defuse the implanted ions, both in the source region and drain region, and in the lower electrode. Diffusion of the B or $BF_2$ ions implanted in layer 416 results in the formation of a shallow p-n junction under FEM gate unit 418, which is the conductive channel of a second type. Temperature range for the heat treatment is in the range of 500°C to 1100°C, to allow passivation and diffusion of the implanted ions. A layer 434 of $SiO_2$ is then formed over the structure by CVD, or, other suitable passivation insulation is applied.

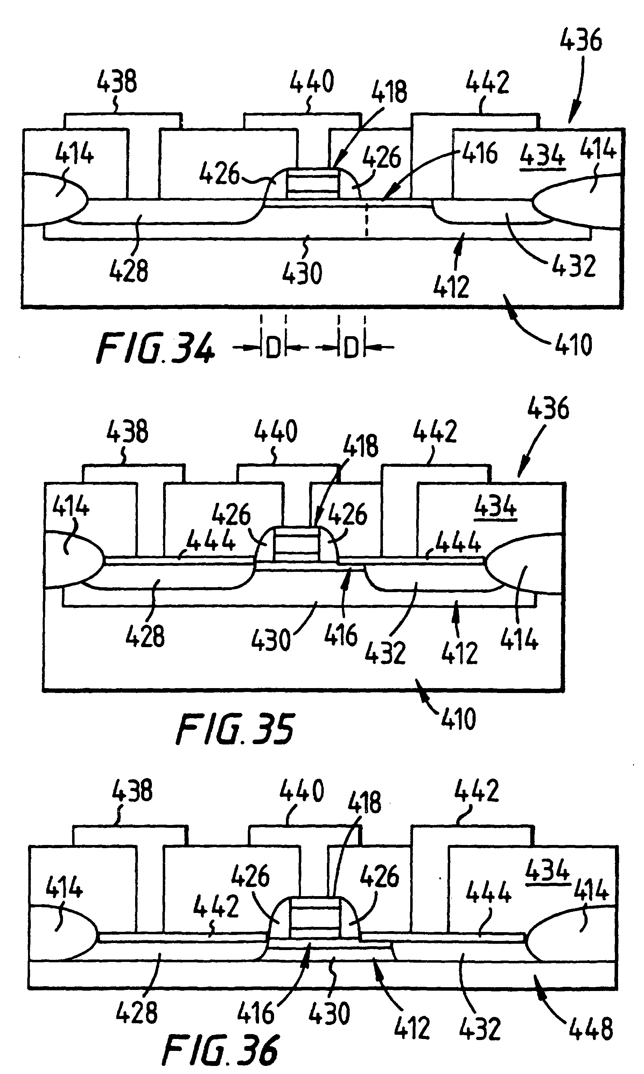

Turning now to Fig. 34, FEM gate unit 418 is depicted as part of a FEM memory cell 436, which includes FEM gate unit 418 and the underlying source, channel and drain regions, which embodiment includes a thin shallow junction region 416, which is a p-n layer, formed under FEM gate unit 418.

To complete the description of FEM cell 436, bores are formed in oxide layer 434 to receive a source electrode 438, a gate electrode 440 and a drain electrode 442 which are connected to their respective components. Drain electrode 442 may be seen to connect to both drain region 432 and p-n junction 416.

The embodiment depicted in Fig. 33 represents a ferroelectric gate depletion-type MIS transistor. At zero gate voltage, the charge in the $n^-$ channel underlying the FEM gate unit is completely depleted. Accordingly, the leakage current is very small. In order to maintain the small leakage, the distance between any edge of lower electrode 420 and the edges of the $n^+$ source or $n^+$ drain regions, represented by "D", has to be at least 50 nm in order that the leakage current remain small. However, as D increases, the series resistance of the memory cell also increases. It is therefore preferred that D be no larger than 300 nm. The gate leakage current is determined by the platinum to $p^-$ type silicon shallow junction 432 and the platinum to ferroelectric material contact. The leakage current is the gate current at a very small up to moderate field intensity. The potential barrier between the $p^-$ layer and $n^-$ type silicon is 0.8 eV to 1.0 eV. A potential barrier of this magnitude causes the $n^-$ type silicon channel to be completely depleted when the ferroelectric material is not polarized, or when the ferroelectric material is polarized with positive charge at the lower electrode. When the ferroelectric material is polarized with a negative charge at the lower electrode, the threshold voltage of the memory transistor is small. The nature of these memory charges and techniques for changing the amount of voltage necessary to the program the cells will be described later herein.

Alternately, the source/drain ion implantation and annealing may be completed before the deposition of the lower gate electrode, if the ferroelectric material is unable to sustain high temperature heat treatment.

Referring now to Fig. 35, and alternate embodiment of the FEM cell is depicted, which embodiment includes two silicide layers 444, 446 formed over the source and drain junction regions. These silicide layers are formed by CVD prior to the deposition of insulating layer 434. This structure has the advantage of having lower resistance to the source region and drain region. This increases the drain current of the memory cell.

An embodiment of the FEM cell formed on a SOI substrate 448 is depicted in Fig. 36.

Operation:

The structure constructed according to the embodiment is particularly efficient because the FEM gate unit, located over the conductive channel on the gate region, is able to shift the polarity of the gate region, allowing efficient current flow from the source through the channel to the drain. The structure provides for total charge depletion when in an "off" condition. When in an "on" condition, current flows through the entire channel region.

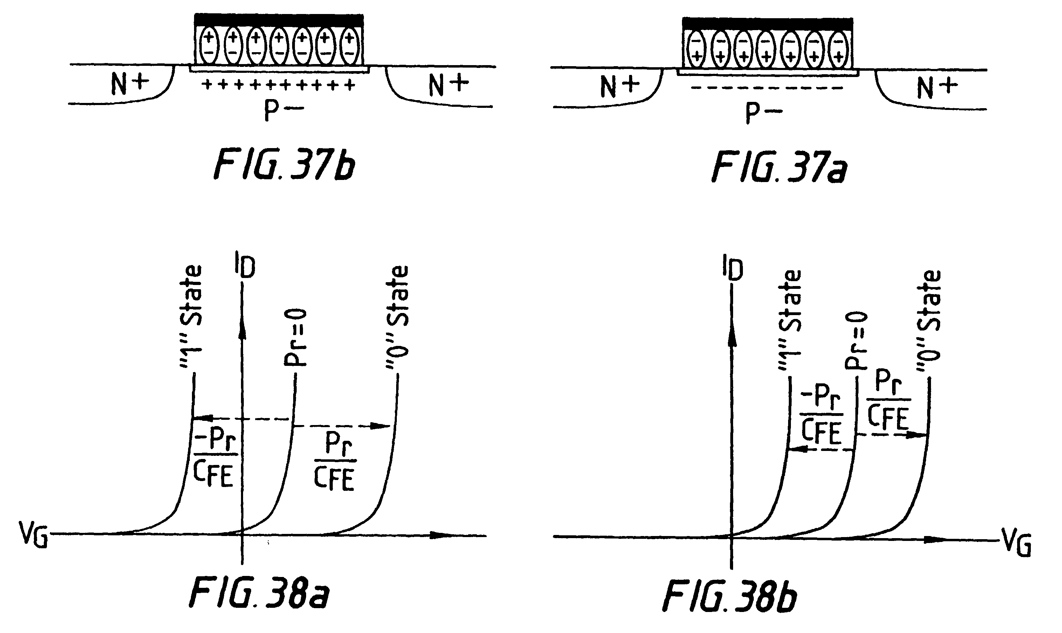

Memory cells constructed according to the embodiment may be placed in an array of memory cells such that the gate lines run perpendicular to the drain lines. In order to write to FEM gate unit 418, +Vpl is applied to all gate electrodes, while the source and drain electrodes of the memory cell are at the ground potential. This polarizes FE 422 such that a negative charge is located at lower electrode 420 and a positive charge is located at,upper electrode 424 (See Fig. 37b ). This places FEM gate unit 418 in a high conductive state.

When a negative voltage, $-V_{po}$, is applied to the gate electrode (program line), and a positive voltage, $+V_{po}$ is applied to the drain, and the source is grounded, and where $|V_{p1}| > |V_{po}|$, the FE is polarized with a positive charge at lower electrode 420. This places FEM gate unit 418 in a low conductive state (see Fig. 37a). The write process enables each memory transistor in a memory array to be written to independent of other memory cells in the array, with no interference to or from the programming of the other memory cells in the array.

The threshold voltage for FEM gate unit 418 may be determined as follows: for a large scale array the threshold voltage at the "1" state has to be a positive value, i.e., 0.4V to 0.8V. The threshold voltage for the "0" state has to be larger than the supply voltage, i.e., 3.3 V. The $n^-$ channel layer is depleted by the $p^-$ type substrate junction as well as by the very shallow $p^-$ surface layer and the gate bias voltage.

It can be shown that the memory window is equal to:

$$\Delta V_T = \frac{2Q_{FE}}{C_{FE}} \tag{3}$$

where $Q_{FE}$ is the remanent charge and $C_{FE}$ is the ferroelectric capacitance of the gate unit.

The width of the space in the $n^-$ region of a $p^+/n$ junction is about 0.3 m if the doping density of the $n^-$ region is $1.0 \times 10^{16} cm^{-3}$. It is apparent that if the thickness and doping of the $n^-$ channel layer are small, the "1" state threshold voltage can be a positive value. The threshold voltage can be adjusted by the doping density and the thickness of both n-channel layer and p-surface layer, the permitivity and the remnant charge of the ferroelectric capacitor.

During a read operation, a voltage, $V_a$, of no larger than the coercive voltage, i.e., that voltage where the memory content may change, is applied to the gate electrode and the drain electrode. Because the content of the memory cell is not disturbed when any electrode is biased with $V_a$, the read operation will not disturb the memory contents of any memory cell. Therefore, a long charge retention is obtained.

A One Transistor Memory Cell:

The general $I_D$ vs. $V_G$ Plot for the MFMOS FET is depicted in Fig. 38. Fig. 38a depicts the $I_D$ vs. $V_G$ characteristics of a FEM cell with high channel doping, $N_D$. The centerline is the $I_D$ vs. $V_O$ curve when the FEM gate unit is not charged. When the FEM cell is programmed to a "1" state, the threshold voltage of the FEM cell is negative. Thus, a large drain current may flow through the channel region even if $V_G = O$. Such a device is not suitable for large scale array applications.

Fig. 38b depicts the $I_D$ vs. $V_G$ characteristics of a FEM cell with low channel doping $N_D$. The threshold voltage of the FEM cell when it is programmed to a "1" state is positive. No current may flow through the device when the gate is at ground potential. A large scale memory array of such devices will have a very small standby leakage current, and will not require frequent refreshing.

Ferroelectric $Pb_5Ge_3O_{11}$ Thin Film for MFMOS Applications:

It can be shown that the lower ferroelectric capacitance results in higher memory window and lower programming voltage. Thicker film and lower $\in_r$ material can result in lower ferroelectric capacitance; however, the former choice could increase the programming voltage if the switching field for ferroelectric is well defined. Common oxide ferroelectric materials exhibit higher $\in_r$ and $T_c$. Oxide $Pb_5Ge_3O_{11}$ thin film has very low $\in_r$ and moderate $T_c$ (178°C).

Table 2 compares the memory window of MFMOS devices with ferroelectric gate of $Pb_5Ge_3O_{11}$, PZT and $SrBi_2Ta_2O_9$ thin films. Even though the steady state polarization for $Pb_5Ge_3O_{11}$ thin film is much lower than that for PZT and $SrBi_2Ta_2O_9$ film films, the memory window for $Pb_5Ge_3O_{11}$ gate controlled MFMOS device is larger than its counterparts due to its low $\in_r$.

Table 2:

| Memory Windows for MFMOS Devices with Various Ferroelectrics | | | |
|---|---|---|---|
| Ferroelectric | $Pb(Zr,Ti)O_3$ | $SrBi_2Ta_2O_9$ | $Pb_5Ge_3O_{11}$ |
| $P_r$ ($\mu C/cm^2$) | 15 | 7 | 3.5 |
| $\in_r$ | 1000 | 280 | 35 |
| $d_{Ferro}$ (Å) | 2000 | 2000 | 2000 |
| $V_{dep}$ (V) | 3.14 | 4.39 | 6.87 |
| $P_r^*$ ($\mu C/cm^2$) when $V_{dep}$ = 0.5V | 2.4 | 0.8 | 0.25 |
| Memory Window $2P_r^* / C_{FE}$(V) | 1.08 | 1.29 | 3.23 |
| Steady state $V_{dep}$ is assumed to be 0.5V | | | |

Thus, a FEM memory cell, and a method of constructing same has been disclosed. The FEM gate unit may be constructed as a single transistor device, or it may be constructed with an associated MOS transistor. Although a preferred embodiment of the invention has been disclosed, it should be appreciated that further variations may be made to the architecture and method without departing from the scope of the invention as defined in the appended claims.

(Example 5)

As previously noted, the invention is a method of making a MFMOS memory cell which includes a ferroelectric (FE) capacitor, or FEM gate unit, located on top of a MOS capacitor, the two devices being collectively referred to herein as a stacked gate unit. In one embodiment of the invention, the area of the MOS capacitor is greater than that of the ferroelectric capacitor, which increases the coupling efficiency and lowers the programming voltage of the device. Another embodiment is described wherein a second transistor is formed alongside the stacked MOS and FE capacitors, and includes placing a ferroelectric capacitor on top of a MOS capacitor wherein the ferroelectric capacitor and the MOS capacitor has the same cross-section. This configuration results in a small cell size and a higher programming voltage than that of the differentially sized structure, also referred to as an off-set gate ferroelectric memory cell. A further embodiment includes a MOS capacitor stacked with a FE capacitor, wherein both capacitors have the same size footprint.

The stacked ferroelectric memory gate unit may be formed on a SOI (SIMOX) substrate, or it may be formed in a bulk silicon substrate which has a p⁻ well formed therein. As used herein, "silicon substrate" means a SOI substrate, a bulk silicon substrate or any other type of substrate which contains silicon as a component thereof and which is suitable for use with the invention.

When a bulk substrate is used, the substrate is a n⁻ type. The initial step is to fabricate n⁻ well and p⁻ well structures, isolate these structures, and implant appropriate ions to provide threshold voltage adjustment for the transistors. When a SOI substrate is used, it is not necessary to form either the n⁻ well or the p⁻ well.

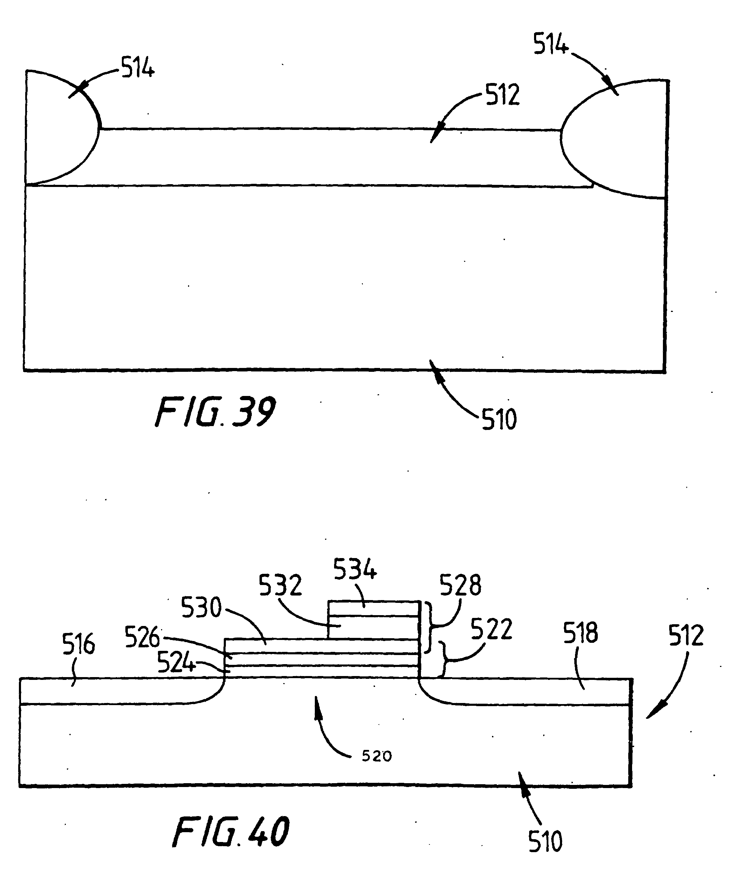

Turning now to Fig. 39, a silicon substrate is depicted at 510. Substrate 510, is preferably a single-crystal substrate, and is formed of bulk silicon. As depicted in Fig. 39, substrate 510 is formed of n⁻silicon. The p⁻ well 512 may be formed by implanting B or $BF_2$ ions into the surface of the substrate, followed by a thermal diffusion step at temperatures ranging between 950° C to 1200° C for one to four hours. Boron ions may be implanted at an energy of 3 kev to 10 kev, while $BF_2$ ions are implanted with an energy level of between 15 kev and 50 kev. Ion concentration in both instances are in the range of $1 \cdot 10^{12}$ cm⁻² to $1 \cdot 10^{14}$ cm⁻².

To isolate the device insulating regions 514, formed of $SiO_2$, are grown on the substrate before the p⁻ well 512 is formed. As is well known to those of a skill in the art, a multiplicity of such regions are formed on the surface of a silicon wafer. For the structure of the example, the cells are arranged in a perpendicular grid of gate to drain and p⁻ well to form a memory array.

Turning now to Fig. 40, a single transistor memory cell will be described. As depicted in Fig. 40, active region 512 has been modified to contain two n⁺ regions 516 and 518, which will ultimately serve as the source and drain, respectively, for the memory cell. A p⁻ well channel region 520, referred to herein as a conductive channel of a first type remains from substrate 510. Source region 516 and drain region 518 are formed by implanting appropriate ions, referred to herein as doping impurities of a second type, in active region 512 to form the two n$^+$ regions, also referred to herein as conductive channels of a second type. Appropriate ion implantation in this instance may be the implantation of As ions at a preferred energy of about 50 kev, although implantation in a range of 40 kev to 80 kev is acceptable, and a dosing in a range of $1 \cdot 10^{15}$cm$^{-2}$ to $5 \cdot 10^{15}$cm$^{-2}$. Alternately, phosphorus ions may be implanted in an energy range of 20 kev - 50 kev in the same dosing range.

A MOS capacitor 522 is formed by growth of a thin layer of thermal oxide 524 onto p$^-$ channel 520, following appropriate masking. Preferably, layer 524 has a thickness in a range of between 3 nm and 10 nm. An optional n$^+$ polysilicon layer 526 is formed by CVD to a thickness of 100 nm to 300 nm, to complete MOS capacitor 522. The n$^+$ polysilicon acts as a buffer layer to release the stress between the bottom electrode of a FEM capacitor and the underlying oxide.

At this point, formation of the FEM capacitor gate unit may begin. FEM gate unit 528 includes a lower metal layer or electrode 530, the ferroelectric (FE) material 532, and an upper metal layer or electrode 534. The construction of FEM gate unit 528 begins with the deposition of the lower electrode on MOS capacitor 522.

Lower electrode 530 may be formed of Pt, Ir, IrO$_2$, or an alloy of Pt/Ir, or other suitable conductive material. The thickness of this metal is preferably 20 nm to 100 nm. Lower electrode 530 and the n$^+$ polysilicon layer, when used, form the upper electrode of MOS capacitor 522.

Next, the FE material is deposited by chemical vapor deposition (CVD). The FE material may be any of the following: Pb(Zr, Ti) O$_3$ (PZT), SrBi$_2$Ta$_2$O$_9$ (SBT), Pb$_5$Ge$_3$O$_{11}$, BaTiO$_3$, LiNbO$_3$, or other suitable ferroelectric material. The preferred compounds are, in order of preference, Pb$_5$Ge$_3$O$_{11}$, SBT and PZT. Most of the experimental work in the FEM gate unit field has been done on PZT compounds. The FE material 532 is deposited to a thickness of 50 nm to 400 nm.

The upper electrode 534 is then formed over the FE material. The upper electrode may be formed of the same materials as the lower electrode, to a thickness of 20 nm to 200 nm, forming a stacked gate unit, including FEM gate unit 528 and MOS capacitor 522. This particular embodiment features an offset FEM gate unit, in that the FEM gate unit covers less than the entire surface area of the MOS capacitor.

The structure depicted in Fig. 40 is completed by depositing a suitable insulating material, such as TiO$_x$, Si$_3$N$_4$, or other suitable barrier insulation material, over the memory cell. A thick layer of interlevel dielectric is formed, and suitable contacts for the source, gate and drain regions are installe.

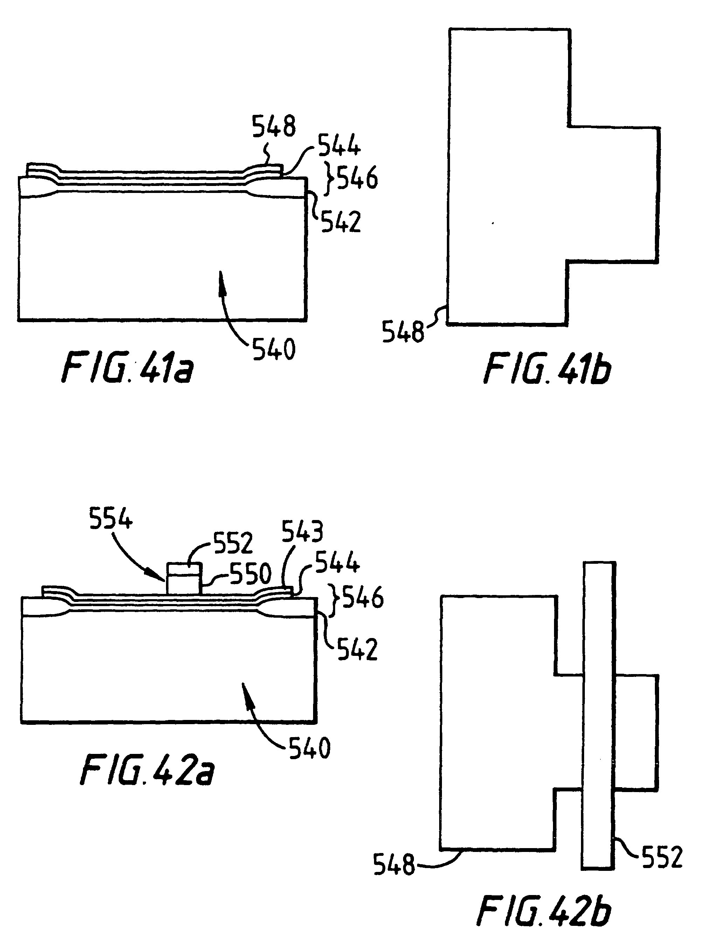

Referring now to Figs. 41a and 41b, the construction and structure of a two transistor memory cell having a stacked gate unit will be described. In this instance, the structure is formed on a silicon substrate 540 which has an oxide layer 542 formed thereover. Regions for the source, drain and gate may be formed at this step of the method, or may be formed later. In any event, a layer of n$^+$ polysilicon 544 is deposited, preferably by CVD which, with oxide layer 542, forms a MOS capacitor 546. A lower metal layer or electrode 548 is then formed over the n$^+$ polysilicon layer 544 as previously described. A top plan view of lower metal layer 548 is depicted in Fig. 41b.

In the next step, ferroelectric material 550 is deposited over bottom electrode 548, as described in connection with the single transistor embodiment hereof, and an upper metal layer 552 is then formed. Top plan views of the lower metal layer 548 and upper metal layer 552 are depicted in Fig. 42b. The upper and lower metal layers and the FE material constitute an FEM gate unit 554.

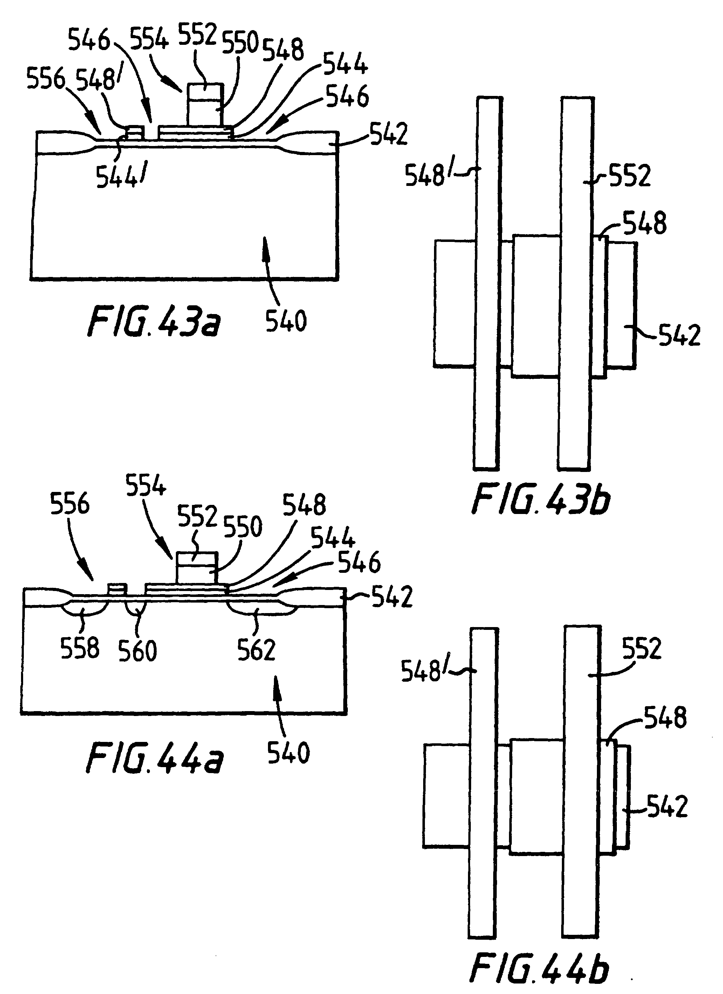

Photoresist is applied and lower electrode 548 and the n$^+$ polysilicon layer 544 are etched, resulting in the configuration depicted in Fig. 43. The structure shown in Fig. 43 includes a second transistor 556 which, includes portions of oxide layer 542, n$^+$ polysilicon layer 544' and lower metal layer 548', which components are designated as "primes." The previously applied photoresist is stripped away, a new photoresist is applied, and impurities of a second type, as previously described, are implanted to form n$^+$ regions 558, 560, 562, depicted in Fig. 44, which are referred to herein as conductive channels of a second type.

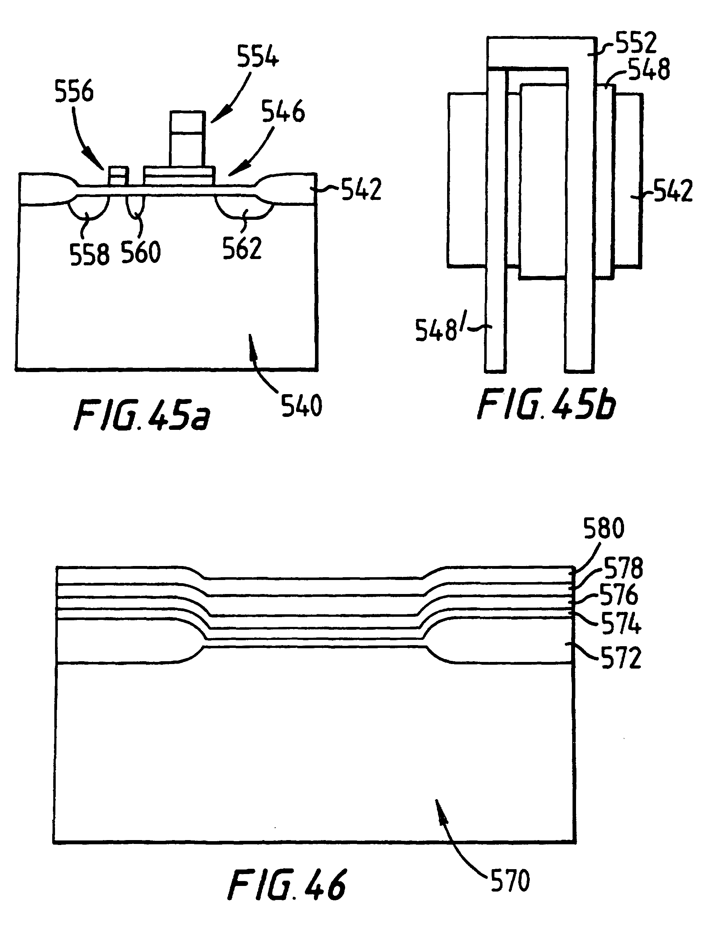

Referring now to Fig. 45, the existing photoresist is stripped away, the wafer is passivated with a layer of suitable insulation, new photoresist is applied to open contact holes and the first interconnect metal is defined, which results in upper metal layer 552 being electrically joined to metal layer 548'.

This configuration has the advantage of having a low leakage current. The device leakage current is limited by the MOS transistor current.

The next example again starts with a silicon substrate as previously described. Referring to Fig. 46, a p$^-$ well 570, has an oxide layer 572 formed thereover. Additional layers are deposited thereover in sequence, and include an n$^+$ polysilicon layer 574, a lower metal layer 576, a FE layer 578, and an upper metal layer 580.

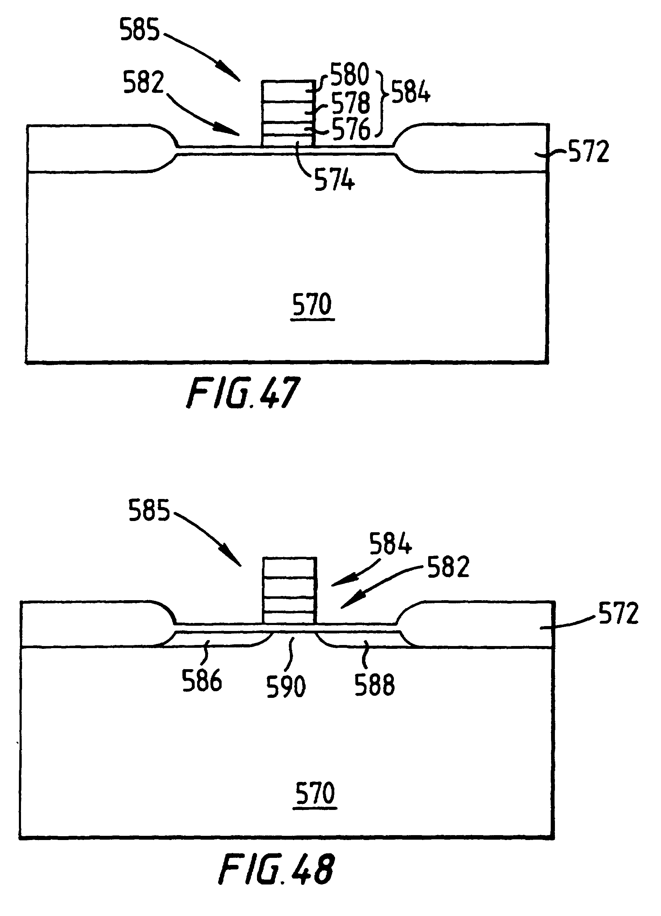

Photoresist is applied and the structure is etched, resulting in the configuration shown in Fig. 47, which includes a MOS capacitor 582 and a FEM gate unit, or capacitor, 584, formed into a stacked gate unit 585. At this point, a layer of insulating material, such as TiO$_x$, or other suitable insulating material may be applied in order to protect the ferroelectric. Then, n$^+$ ions are implanted to form a n$^+$ source region 586 and n$^+$ drain region 588. The remaining p$^-$ material, depicted at 590, provides a gate channel.

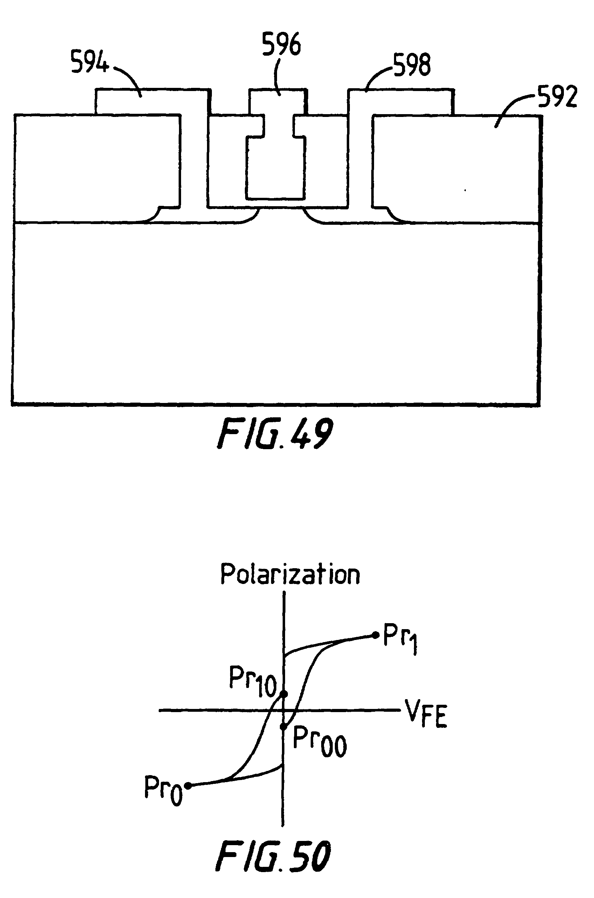

Referring now to Fig. 49, the final structure is depicted, with an insulating layer 592 in place, which includes a source electrode 594, a gate electrode 596, and a drain electrode 598.

This particular example provides for a very small cell size. The device is exceptionally suitable for use in VLSI memory applications.

Programming to High Threshold State:

Fig. 50 depicts the P-E hysteresis loop of the ferroelectric material used in the memory cells described herein. $Pr$ is the polarization value of the ferroelectric material. $Pr_0$ is negative polarity saturation polarization. $Pr_{00}$ is the polarization of the ferroelectric material after relaxation of the device after it has been programmed to a high threshold voltage state. $Pr_1$ is the positive polarity saturation polarization. $Pr_{10}$ is the polarization of the ferroelectric material after relaxation of the device after it has been programmed to a low threshold voltage state.

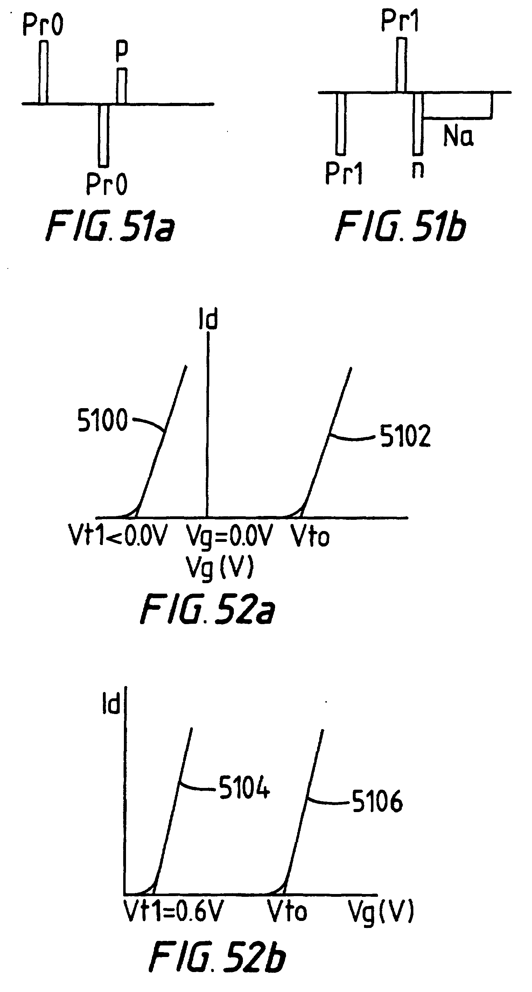

The charge distribution of a device constructed according to the example is depicted in Fig. 51, wherein Fig. 51a depicts the charge distribution when the device is programmed to a "0" state and Fig. 51b depicts the charge when the device is programmed to the "1" state. In order to program the memory transistor to a "0" state for a large positive threshold voltage, such that the device nonconductive at normal operation voltage, a negative voltage is applied to the control gate and results in the charge distribution as shown in Fig. 51a. The Poison's equation is:

$$\frac{d^2V}{dx^2} = \frac{qp}{\varepsilon_{OX}}\,[\partial(x)\partial(x = T_{OX})] + \frac{Pr_0qp}{\varepsilon_{FE}}\,\partial(x = T_{OX}) \tag{4}$$

Integrate twice yields:

$$V_{P0} = V_{FB}\frac{qp}{C_{SI}} + \frac{Pr_0qp}{C_{FE}} \tag{5}$$

where $Pr_0$ is shown in Fig. 50. The voltage drop across the ferroelectric capacitor is:

$$V_{FE} = \frac{Pr_0qp}{C_{FE}} \tag{6}$$

Therefore the programming voltage is:

$$V_{P0} = V_{FB}\frac{Pr_0}{C_{OX}} + V_{FE}(1 + \frac{C_{FE}}{C_{OX}}) \tag{7}$$

The threshold voltage after prograrnming is:

$$V_{T0} = V_{FB} + 2\phi_{FP} + \frac{\sqrt{4\phi_{FP}\varepsilon_{SI}qN_A}}{C_{OX}} + \frac{\sqrt{4\phi_{FP}\varepsilon_{SI}qN_A} + Pr_{00}}{C_{FE}} \tag{8}$$

where $Pr_{00}$ is the polarization of the ferroelectric material after relaxation from the programming the device to high threshold voltage.

Program to Low Threshold Voltage State:

To program the memory to a low threshold voltage, i.e., "1" state, a positive voltage, $V_{p1}$, is applied to the gate and a negative voltage, $V_{D1}$, to the drain and p⁻ well. The p⁻ well is not required when the device is made on a SOI substrate. The source is at the ground potential. The charge distribution is sketched in Fig. 51b. The Poison's equation is:

$$\frac{d^2V}{dx^2} = \frac{qN_A}{\varepsilon_{SI}} [U(x)U(xw)] + \frac{qN_AW+qn}{\varepsilon_{OX}} [\partial(x=W)\partial(x=W+T_{OX})] + \frac{[qN_AW+qn]Pr_1}{\varepsilon_{FE}} \partial(x=T_{OX}) \qquad (9)$$

Integrate Eq. (9) twice:

$$V_{PI} = V_{FB} + 2\phi_{FP} + \frac{qN_AW+qn}{C_{OX}} + \frac{[qN_AW+qn]PR_1}{C_{FE}} V_{DI} \qquad (10)$$

Equation (10) can be rewritten as:

$$V_{P1} = V_{FB} + 2\phi_{FP} + \frac{\sqrt{4q\varepsilon_{SI}N_A\phi_{FP}} + qn}{C_{OX}} + \frac{[\sqrt{4q\varepsilon_{SI}N_A\phi_{FP}} + qn]Pr_1}{C_{FE}} + V_{DI} \qquad (11)$$

The voltage drop from the surface inversion layer to the top electrode of the ferroelectric capacitor is:

$$V_{PI}V_{DI} = V_{FB} + \frac{\sqrt{4q\,\varepsilon_{SI}\,N_A\phi_{FP}} + qn}{C_{OX}} + \frac{[\sqrt{4q\,\varepsilon_{SI}\,N_A\phi_{FP}} + qn]\,Pr_1}{C_{FE}} \qquad (12)$$

The voltage drop in the ferroelectric capacitance is:

$$V_{FE} = \frac{[\sqrt{4q\,\varepsilon_{SI}\,N_A\phi_{FP}} + qn]\,Pr_1}{C_{FE}} \qquad (13)$$

Therefore the supply voltage is:

$$V_{PI} + V_{DI} = V_{FB} + \frac{Pr_1}{C_{OX}} + V_{FE}(1 + \frac{C_{FE}}{C_{OX}}) \qquad (14)$$

The threshold voltage is:

$$V_{TI} = V_{FB} + 2\phi_{FP} + \frac{\sqrt{4q\,\varepsilon_{SI}\,N_A\phi_{FP}}}{C_{OX}} + \frac{\sqrt{4q\,\varepsilon_{SI}\,N_A\phi_{FP}}Pr_{10}}{C_{FE}} \qquad (15)$$

where $Pr_{10}$ is the polarization charge after relaxation from the programming to the low threshold voltage state. Thus by (1) increasing channel doping density, NA, (2) decreasing the ferroelectric capacitance by selecting lower dielectric constant material and/or increasing the thickness of the ferroelectric film, and (3) increasing the gate oxide capacitance, $C_{ox}$, by using thinner thermal oxide, the threshold voltage of the device at the "0" state can be larger than 0.0 V. This is the essential condition for one transistor RAM VLSI array. The result also clearly indicates that when the oxide capacitance is increased the programming voltage can be small.

The programming voltage and the threshold voltage of the device under various polarization conditions are calculated from the above equations and are shown in Table 3, where the programming voltages and the channel doping density are adjusted to yield the "1" state threshold voltage of $V_{T1}$ = 0.6V. The polarization charge during programming is assumed to be 36% higher than the steady state polarization. We further assumed that the thickness of the ferroelectric material is 300 nm and its capacitance is $2.9 \cdot 10^{-7}$ F/cm$^2$. The voltage dropping across the ferroelectric during programming is 3V. Two gate oxide thickness, i.e., 5 nm and 6 nm, have been evaluated. The memory window, $\Delta V_{TH}$, is shown in the last column of Table 3 and is illustrated in Fig. 52.

Table 3

| Pr$_{00}$=Pr$_1$ | T$_{OX}$=5nm | | | T$_{OX}$=6nm | | | |
| --- | --- | --- | --- | --- | --- | --- | --- |
| | Dopant | Vp$_1$ | Vp$_0$ | Doping | Vp$_1$ | Vp$_0$ | ΔV$_{TH}$ |
| 0.50 | 1.44 | 5.70 | -4.70 | 1.23 | 5.28 | -3.53 | 4.05 |
| 0.75 | 6.00 | 5.95 | -4.45 | 5.22 | 5.71 | -3.09 | 5.78 |
| 1.00 | 13.69 | 6.20 | -4.20 | 11.97 | 6.15 | -2.65 | 7.50 |
| 1.25 | 24.50 | 6.45 | -3.95 | 21.48 | 6.59 | -2.21 | 9.23 |
| 1.50 | 38.44 | 6.70 | -3.70 | 33.76 | 7.03 | -1.78 | 10.95 |
| 1.75 | 55.50 | 6.95 | -3.45 | 48.79 | 7.46 | -1.34 | 12.68 |
| 2.00 | 75.69 | 7.20 | -3.20 | 66.59 | 7.90 | -0.90 | 14.40 |
| 2.25 | 99.00 | 7.45 | -2.95 | 87.14 | 8.34 | -0.46 | 16.13 |
| 2.50 | 125.44 | 7.70 | -2.70 | 110.46 | 8.78 | -0.03 | 17.85 |

Referring now to Fig. 52a, plot of $I_D$ versus $V_G$ for prior art devices is depicted. Line 5100 represents the situation where $V_{t1}$ is less than zero, while $V_{t0}$ is a positive value. A structure having such a characteristic requires at least two devices (one memory transistor and one normal transistor) for use in a RAM array, and will require a relatively large programming voltage if used in a one transistor RAM array.

Fig. 52b depicts the "1" threshold voltage, line 5104, and a "0" threshold voltage, line 5106, for the devices formed according to the method of the example.

Thus, a FEM memory cell, and a method of constructing same has been disclosed.

(Example 6)

The ferroelectric memory (FEM) cell of this example may be formed on a SOI (SIMOX) substrate, or, it may be formed in a bulk silicon substrate. The description herein will concentrate on the formation of the FEM gate unit on a bulk silicon substrate.

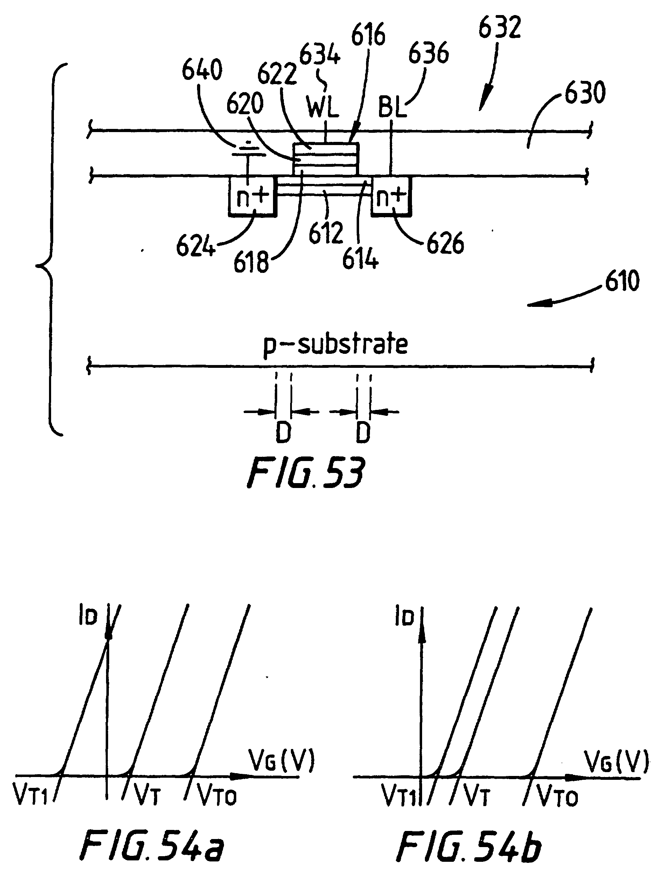

Turning now to Fig. 53, a silicon substrate is depicted at 610. Substrate 610, in the preferred embodiment is a single-crystal substrate, and is formed of bulk silicon. Other embodiments may be formed on a SOI substrate. As used herein, "silicon substrate" refers to either a bulk silicon substrate or a SOI substrate, or to any other suitable silicon-based substrate. As depicted in Fig. 53, the p$^-$ substrate 610 has doping impurities of a first type, which is a boron or boron compound, of a concentration of about $1.0 \cdot 10^{15}$cm$^{-3}$ to $5.0 \cdot 10^{15}$cm$^{-3}$.

A shallow n$^-$ type layer 612 (a well structure), also referred to herein as conductive channel of a second type, which has doping impurities of a second type, is then formed under the gate area by phosphorous or arsenic implantation. The ion energy is in the range of 10 keV to 50 keV and the dose is in the range of $1.0 \cdot 10^{12}$cm$^{-2}$ to $1.0 \cdot 10^{13}$cm$^{-2}$.

A very shallow layer of p$^-$ type silicon 14 (a sub-well structure) is formed in the shallow n$^-$type layer 12, and has doping impurities of a third type, implanted with BF$_2$ to the top of the n$^-$ type second conducting layer. The BF$_2$ energy is in the range of 10 keV to 40 keV, and the dose range is between about $5.0 \cdot 10^{11}$cm$^{-2}$ to $5.0 \cdot 10^{12}$cm$^{-2}$. This layer is referred to herein as a conductive channel of a third type.

At this point, formation of the FEM gate unit may begin. A FEM gate unit is identified generally at 616 and includes a lower metal layer, or electrode, 618, the ferroelectric (FE) material 620, and an upper metal layer, or electrode, 622. The construction of FEM gate unit 616 begins with the deposition of the lower electrode 618 on p$^-$layer 614. Lower electrode 618 may be formed of Ir or Ir/IrO$_2$ alloy, or an alloy of Pt/Ir, or other suitable conductive material. The thickness of this metal is 20 nm to 100 nm, in the preferred embodiment.

Next, the FE material is deposited by chemical vapor deposition (CVD), after appropriate masking. The FE material may be any of the following: Pb(Zr,Ti)O$_3$ (PZT), SrBi$_2$Ta$_2$O$_9$ (SBT), Pb$_5$Ge$_3$O$_{11}$, BaTiO$_3$, or LiNbO$_3$. The preferred compounds are, in order of preference, SBT, Pb$_5$Ge$_3$O$_{11}$ and PZT. Most of the experimental work in the FEM gate unit field has been done on PZT compounds. The FE material 620 is deposited to a thickness of 50 nm to 400 nm.

The upper electrode 622 is then formed over the FE material. The upper electrode may be formed of Pt, Pt/Ir alloy, Pt/IrO$_2$ alloy, or other suitable materials, to a thickness of 20 nm to 200 nm.

Photoresist is applied over the FEM gate unit, and the cell is then etched to the proper configuration and size. It should be appreciated that the three layers of the FEM gate unit need not be precisely aligned as shown, as their shape may be formed by applying a photoresist, and etching, with masks that have different geometries. However, for the sake of clarity, the FEM gate unit is depicted as a structure which has contiguous, aligned sidewalls.

The p$^-$ substrate 610 is now modified by implanting the appropriate ions, also referred to herein as doping impurities of a fourth type to form two n$^+$ layers, also referred to herein as conductive channels of a fourth type, which will serve as source region 624 and a drain region 626. Appropriate ion implantation in this instance may be the implantation of As ions at a preferred energy of about 50 keV, although implantation in a range of 40 keV to 70 keV is acceptable, and a dosing in a range of $1 \cdot 10^{15} cm^{-2}$ to $5 \cdot 10^{15} cm^{-2}$. Alternately, phosphorus ions may be implanted in an energy range of 30keV - 60keV in the same dosing range.

The wafer is heat treated to activate and diffuse the implanted ions, both in the source region and drain region. Temperature range for the heat treatment is in the range of 500°C to 1100°C, to allow activation and diffusion of the implanted ions.

A layer of $TiO_x$, $Si_3N_4$, or other suitable barrier insulation material, 630, is formed by CVD to protect the FEM gate unit, which results is the formation of a FE memory cell 632.

To complete the description of FEM cell 632, bores are formed in insulating layer 630 to receive a word line (WL) (gate) electrode 634, and a bit line (BL) electrode 636, which are connected to their respective components. Source 624 is connected to ground 640.

The embodiment depicted in Fig. 53 represents a ferroelectric gate depletion-type MFMS transistor. At zero gate voltage, the charge in the n$^-$ channel underlying the FEM gate unit is completely depleted. Accordingly, the leakage current is very small. In order to maintain the small leakage, the distance between any edge of lower electrode 618 and the edges of n$^+$ source region 624 and n$^+$ drain region 626, represented by "D", has to be at least 50 nm in order that the leakage current remain small. However, as D increases, the series resistance of the memory cell also increases. It is therefore preferred that D be no larger than 300 nm. The potential barrier between the p$^-$ conductive layer of the third type 14 and the n$^-$ conductive layer of the second type 612 is on the order of 0.9 eV. A potential barrier of this magnitude causes the n$^-$ type silicon channel to be completely depleted when the ferroelectric material is not polarized. When the ferroelectric material 620 is polarized with positive charge adjacent to lower electrode 618, the threshold voltage is small. When the ferroelectric material 620 is polarized with a negative charge adjacent to the lower electrode 618, the threshold voltage of the memory transistor is very large. The nature of these memory charges and techniques for changing the amount of voltage necessary to the program the cells will be described later herein.

Alternately, the source/drain ion implantation and annealing may be completed before the deposition of the lower gate electrode, if the ferroelectric material is unable to sustain high temperature heat treatment.

Operation:

The structure constructed according to the embodiment is particularly efficient because the FEM gate unit, located over the conductive channel on the gate region, is able to shift the polarity of the gate region, allowing efficient current flow from the source through the channel to the drain. The structure provides a total charge depletion when in an "off" condition. The operating theory of a depletion-type device is similar to that of a junction FET.

The general $I_D$ vs. $V_G$ plot for the IMFMS FET is depicted in Fig 54. Fig. 54a depicts the $I_D$ vs. $V_G$ characteristics of a symmetric FEM cell. The centerline is the $I_D$ vs. $V_O$ curve when the FEM gate unit is not charged, where $P_r = 0$. When the FEM cell is programmed to a "1" state, the threshold voltage of the FEM cell is negative. Thus, a large drain current may flow through the channel region even if $V_G = 0V$. Such a device is not suitable for large scale array applications.

Fig. 54b depicts the $I_D$ vs. $V_G$ characteristics of an asymmetric FEM cell of the invention. The threshold voltage of the FEM cell when it is programmed to a "1" state is positive. No current may flow through the device when the gate is at ground potential. A large scale memory array of such devices will have a very small standby leakage current.

The asymmetric polarized ferroelectric memory transistor cell of the embodiment may be applied to an MFMS cell and an MFMOS cell to provide a low leakage, high speed, very large scale memory array. The low leakage current is achieved by having a positive threshold voltage both for the "1" and "0" states. High speed write and read is achieved by increasing the drive current and decreasing the channel capacitance of the device. Because the electron mobility is much higher than the hole mobility, an n$^-$ channel memory device is preferred for high speed operation.

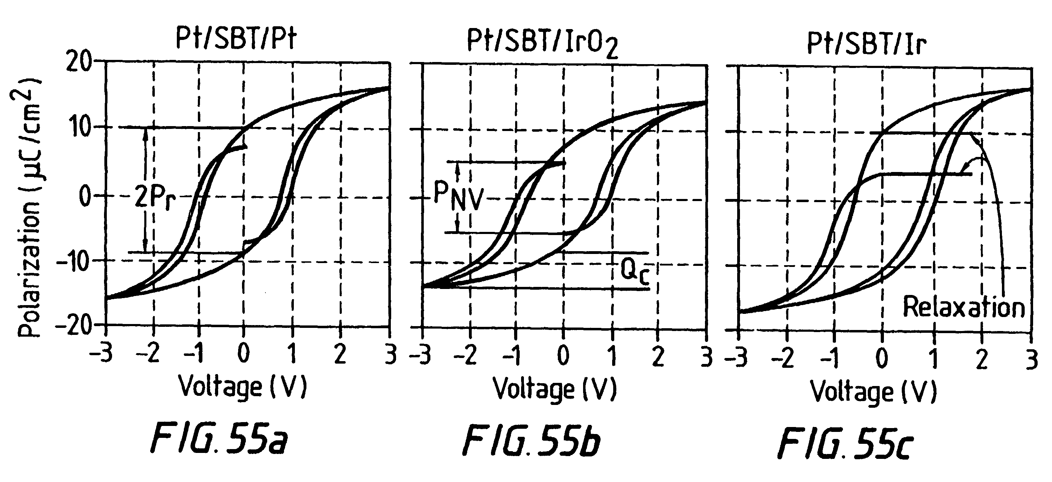

Referring now to Fig. 55, Jiang et al., "A New Technology for High-Density Nonvolatile Ferroelectric $SrBi_2Ta_2O_9$ Memories", 1996 VLSI Technology Symposium, Honolulu, June, 11-13, 1996, page 26, described that replacing platinum with indium as the lower electrode of a ferroelectric memory capacitor resulted in an improved performance. As depicted in Fig. 55, the P-E hysteresis loops measured for 100kHz single-shot pulses for $SrBi_2Ta_2O_9$ (SBT) capacitor having different bottom electrodes is depicted. In Fig. 55a, the bottom electrode is $Pt/TiO_2$; in Fig. 55b, the lower electrode is $IrO_2$; and in Fig. 55c, the bottom electrode is pure Ir. The remanent polarization, $P_{NV}$, is measured ten seconds after the capacitor has been written to. As shown in Fig. 55c, a Pt/SBT/Ir capacitor displays a very large depolarization charge at positive polarizations, while the depolarization of the negatively polarized capacitor is very small.

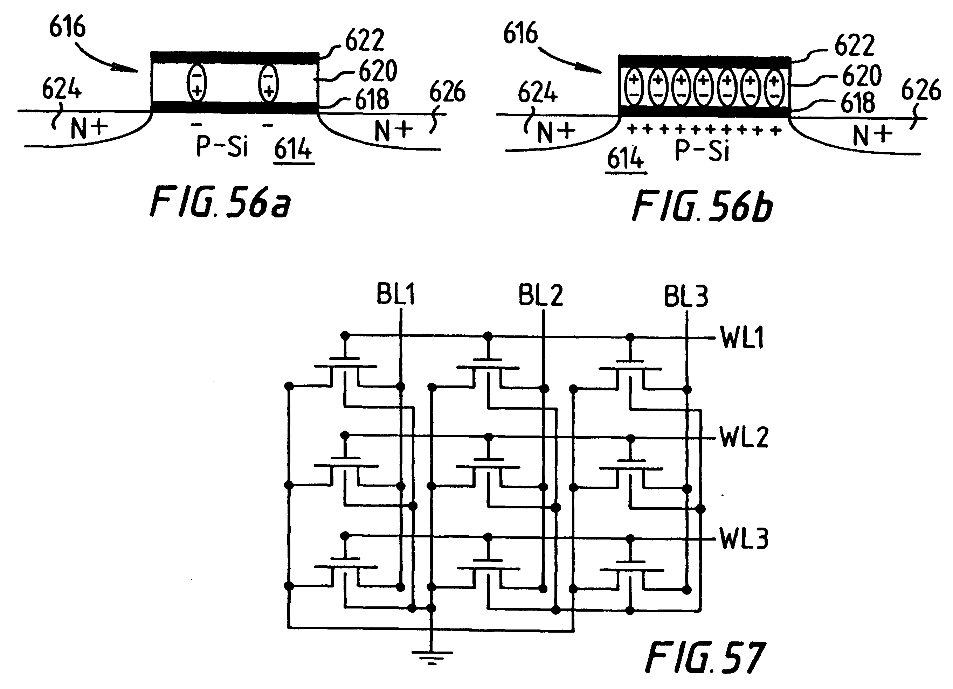

In order to have a positive "1" state (the high conductive state) threshold voltage, the device needs to have a small positive polarization charge located at the bottom ferroelectric/electrode interface, as shown in Fig 56a. In order to maintain a large memory window, a large negative polarization charge at the bottom ferroelectric/electrode interface is also required, as shown in Fig 56b. This can be achieved with a Pt/SBT/Ir semiconductor structure. The steady state "1" state polarization charge is about $10\mu C/cm^2$, while the steady state "0" state polarization charge is about minus $2\mu C/cm^2$. Corresponding threshold voltage shiftings are 12.1 V and -2.42 V, respectively, for a $0.3\mu m$ SBT thin film with a dielectric constant of 280. By adjusting the channel doping density to achieve the threshold voltage of about 3 V at 0 ferroelectric polarization, the $V_{T1}$ and $V_{T0}$ of about 0.6 volt and 15 volt may be obtained, as depicted in Fig 54b.

This ferroelectric memory device may be used in low voltage, high density and high speed applications. The memory cell is laid out in the p$^-$ well 610, as depicted in Fig. 57. Fig. 57 depicts a nine-cell memory array, wherein the word lines are designated WL1, WL2 and WL3, the bit, or drain, lines are designated BL1, BL2 and BL3. The source regions and the substrate of all of the transistors are grounded. The source, word line, and bit line are connected independently to peripheral circuits, as shown in Fig. 57. The memory array is block programmed to the "1" (high conductive) state by applying a positive voltage of $V_{PP}$ to the word line (gate) with the bit line connected to ground. In order to program each individual memory cell to a "0" (low conductive) state, a negative programming voltage, -$V_{PP}$, is applied to the word line while a positive programming voltage of $V_{PP}$ is applied to the bit line. This results in only one cell having a bias voltage of -$V_{PP}$ at the gate and +$V_{PP}$ at the drain. This memory cell is the only cell in the entire array which will be written to the "0" state.

The asymmetric polarization relaxation may be observed in many combination of electrodes. Additionally, it may be observed on any ferroelectric thin films and any kind of ferroelectric gate structures. The mechanism of the asymmetric polarization relaxation is both complex and sensitive to processed condition. This requires that, in the preferred embodiment of the invention, the asymmetric polarization relaxation technique should be used to fabricate the ferroelectric gate controlled one transistor memory cell.

The threshold voltage for FEM gate unit 616 may be determined as follows: for a large scale array the threshold voltage at the "1" state has to be a small positive value, i.e., 0.4V to 0.8V. The threshold voltage for the "0" state has to be larger than the supply voltage, i.e., 3.3V. The n$^-$ channel layer is depleted by the p$^-$ type substrate junction as well as by the very shallow p$^-$ suface layer and the gate bias voltage. It can be shown that the memory window is equal to:

$$\Delta V_T = \frac{2Q_{FE}}{C_{FE}} \qquad (16)$$

where $Q_{FE}$ is the remanent charge and $C_{FE}$ is the ferroelectric capacitance of the gate unit.

During a read operation, a voltage, $V_a$, of no larger than the coercive voltage, i.e., that voltage where the memory content may change, is applied to the gate electrode and the drain electrode. Because the content of the memory cell is not disturbed when any electrode is biased with $V_a$, the read operation will not disturb the memory contents of any memory cell. Therefore, a long charge retention is obtained.

**Claims**

1. A method of forming a semiconductor structure having a ferroelectric memory (FEM) gate unit (44) on a substrate (30) of single crystal silicon, comprising:

   forming a silicon device area for the FEM gate unit (44);
   implanting doping impurities in the silicon device area to form a conductive channel (32) of a first conductivity type for use as a source junction region (38) and a drain junction region (42);
   etching an insulating boundary (30a, 30b) about the device area;
   forming a gate region (40) between the source junction region (38) and drain junction region (42) for the FEM gate unit (44) on the silicon device area;
   forming a conductive channel precursor layer (52) on the gate region (40); and
   depositing an FEM gate unit (44) over the gate region (40), including depositing a lower metal layer (46), a FE layer (48) and an upper metal layer (50),

   **characterized in that** the FEM gate unit (44) is sized on the gate region (40) such that any edge of the FEM gate unit (44) is a distance "D" from the edges of the source junction region (38) and the drain junction region (42), where "D" is between 50 nm and 300 nm.

**2.** The method of claim 1 wherein forming a conductive channel precursor layer (52) includes implanting a dopant taken from the group consisting of B or $BF_2$ at an energy in a range of 3 keV to 10 keV or 15 keV to 50 keV, respectively, and a dose of $1 \cdot 10^{11}$ cm $^2$ to $1 \cdot 10^{13}$ cm $^2$ to form the conductive channel precursor (52).

**3.** The method of claim 1 which includes annealing the structure at a temperature of about 500°C to 1100°C to diffuse ions from the lower metal layer (46) into the gate junction region (45) to form the conductive channel precursor layer (52).

**4.** The method of claim 1 wherein said depositing the FEM gate unit (44) includes depositing a lower metal layer (46) of Pt, having a thickness of about 20 nm to 100 nm, depositing a FE layer (48) of material taken from the group consisting of Pb(Zr,Ti)$O_3$ (PZT), $SrBi_2Ta_2O_9$ (SBT), $Pb_5Ge_3O_{11}$, $BaTiO_3$ and $LiNbO_3$, having a thickness of about 100 nm to 400 nm, and depositing an upper metal layer (50) of material taken from the group consisting of Pt, Ir and Pt/Ir alloy, having a thickness of 20 nm to 100 nm.

**5.** The method of claim 1 wherein said implanting doping impurities includes doping the device area with ions taken from the group consisting of As, implanted at an energy of about 40 keV to 70 keV, and phosphorous, implanted at an energy of about 30 keV to 60 keV, the ions having a dose of about $2 \cdot 10^{15}$ cm$^{-2}$ to $5 \cdot 10^{15}$ cm$^{-2}$.

**6.** The method of claim 1 which includes depositing a layer of $TiO_x$ (56) over the FEM gate unit (44).

**7.** A method of claim 1 wherein the lower metal layer (46) is of material taken from the group consisting of Pt, Ir and Pt/Ir alloy, having a thickness of about 20 nm to 100 nm.

**8.** The method of claim 7 wherein forming a conductive channel precursor layer (52) includes implanting a dopant taken from the group consisting of B or $BF_2$ at an energy in a range of 3 keV to 10 keV or 15 keV to 50 keV, respectively, and a dose of $1 \times 10^{11}$ cm$^{-2}$ to $1 \times 10^{13}$ cm$^{-2}$ to form the conductive channel precursor layer (52).

**9.** The method of claim 7 which includes annealing the FEM cell at a temperature of about 500°C to 1100°C to diffuse ions from the lower metal layer (46) of the FEM gate unit into gate junction region (40) to form the conductive channel precursor layer (52).

**10.** The method of claim 7 which includes forming a channel of the second conductive type having a thickness of about 50 nm to 100 nm.

**11.** The method of claim 7 wherein said implanting doping impurities includes doping the device area with ions taken from the group consisting of As, implanted at an energy of about 40 keV to 70 keV, and phosphorous, implanted at an energy of about 30 keV to 60 keV, the ions having a dose of about $2 \cdot 10^{15}$ cm$^{-2}$ to $5 \cdot 10^{15}$ cm$^{-2}$.

**12.** The method of claim 7 which includes depositing a layer of $TiO_x$ (56) over the FEM gate unit (44).

**13.** The method of claim 7 wherein the conductive channel precursor layer (52) underlies the margins of the FEM gate unit (44).

**14.** A method of claim 1, further comprising forming a conductive channel of a third type on the gate region (40), wherein the conductive channel of the third conductivity type is sized on the gate region (40) such that any edge of the conductive channel of the third conductivity type is a distance "C" from the edges of the source junction region (38) and the drain junction region (42), where "C" is between about 0 nm and 300 nm.

**15.** The method of claim 14 wherein forming a conductive channel of the third type includes implanting a dopant taken from the group consisting of B or $BF_2$ at an energy in a range of 3 keV to 10 keV or 15 keV to 50 keV, respectively, and a dose of $1 \cdot 10^{11}$ cm$^{-2}$ to $1 \cdot 10^{13}$ cm$^{-2}$.

**16.** The method of claim 14 which includes annealing the structure at a temperature of about 500°C to 1100°C to diffuse B or $BF_2$ ions from the lower metal layer (46) into the gate region (40) to form the conductive channel of the third type.

**17.** The method of claim 14 wherein said depositing the FEM gate unit includes depositing a lower metal layer (46) of material taken from the group consisting of Pt, Ir, $IrO_2$ and Pt/Ir alloy, having a thickness of about 20 nm to 100 nm, depositing a FE layer (48) of material taken from the group consisting of Pb(Zr,Ti)O$_3$ (PZT), SrBi$_2$Ta$_2$O$_9$ (SBT), Pb$_5$Ge$_3$O$_{11}$, BaTiO$_3$ and LiNbO$_3$, having a thickness of about 50 nm to 400 nm, and depositing an upper metal layer (50) of material taken from the group consisting of Pt, Ir, IrO$_2$ and Pt/Ir alloy, having a thickness of 20 nm to 100 nm.

18. The method of claim 14 wherein said implanting doping impurities of the second type includes doping the device area with ions taken from the group consisting of As, implanted at an energy of about 40 keV to 70 keV, and phosphorous, implanted at an energy of about 30 keV to 50 keV, the ions having a dose of about $1 \cdot 10^{15}$ cm$^{-2}$ to $5 \cdot 10^{15}$ cm$^{-2}$.

19. The method of claim 14 further comprising depositing an insulating structure about the FEM gate unit (44), which includes depositing a layer of insulating material (56) taken from the group consisting of TiO$_x$ and Si$_3$N$_4$ over the FEM gate unit (44).

20. The method of claim 1, wherein the step of forming a gate region (40) comprises:

implanting doping impurities of a second conductivity type in the silicon device area to form a conductive channel of a second conductivity type for use as a gate region (40);
said step of depositing an FEM gate unit (44) over the gate region (40) includes depositing a lower metal layer (46) of material taken from the group consisting of Pt, Ir, IrO$_2$ and Pt/Ir alloy, having a thickness of about 20 nm to 100 nm, a FE layer (48) of material taken from the group consisting of Pb(Zr,Ti)O$_3$ (PZT), SrBi$_2$Ta$_2$O$_9$ (SBT), Pb$_5$Ge$_3$O$_{11}$, BaTiO$_3$ and LiNbO$_3$, having a thickness of about 50 nm to 400 nm, and an upper metal layer (50) of material taken from the group consisting of Pt, Ir, IrO$_2$ and Pt/Ir alloy, having a thickness of 20 nm to 100 nm, wherein the FEM gate (44) unit is sized on the gate region (40) such that any edge of the FEM gate unit (44) is a distance "D" from the edges of the source junction region (38) and the drain junction region (42), where "D" is between 50 nm and 300 nm;
and further comprising the step of forming a conductive channel of a third type on the gate region (40), wherein the conductive channel of the third type is sized on the gate region (40) such that any edge of the conductive channel of the third type is a distance "C" from the edges of the source junction region (38) and the drain junction region (42), where "C" is between about 0 nm and 300 nm.

21. The method of claim 20 wherein forming a conductive channel of the third type includes implanting a dopant taken from the group consisting of B or BF$_2$ at an energy in a range of 3 keV to 10 keV or 15 keV to 50 keV, respectively, and a dose of $1 \cdot 10^{11}$ cm$^{-2}$ to $1 \cdot 10^{13}$ cm$^{-2}$ in the lower metal layer (46).

22. The method of claim 20 further comprising forming a conductive channel of the third type includes implanting a dopant taken from the group consisting of B or BF$_2$ at an energy in a range of 3 keV to 10 keV or 15 keV to 50 keV, respectively, and a dose of $1 \cdot 10^{11}$ cm$^{-2}$ to $1 \cdot 10^{13}$ cm$^{-2}$ in the surface of the conductive layer (32) of the first type.

23. The method of claim 20 which includes annealing the structure at a temperature of about 500°C to 1100°C to diffuse B or BF$_2$ ions from the lower metal layer (46) into the gate region (40) to form the conductive channel of the third type.

24. The method of claim 20 wherein said implanting doping impurities of the second type includes doping the device area with ions taken from the group consisting of As, implanted at an energy of about 40 keV to 70 keV, and phosphorous, implanted at an energy of about 30 keV to 50 keV, the ions having a dose of about $1 \cdot 10^{15}$ cm$^{-2}$ to $5 \cdot 10^{15}$ cm$^{-2}$.

25. The method of claim 20 wherein said depositing an insulating structure about the FEM gate unit (44) includes depositing a layer of insulating material (56) taken from the group consisting of TiO$_x$ and Si$_3$N$_4$ over the FEM gate unit (44).

26. The method of claim 1, further comprising the step of implanting doping impurities of a second type over the device area to form a conductive layer of a second type wherein the conductive layer of the second type extends into the drain junction region (42).

27. The method of claim 26 wherein forming a conductive layer of the second type includes implanting a dopant taken from the group consisting of B or BF$_2$ at an energy in a range of 3 keV to 10 keV or 15 keV to 50 keV respectively

and a dose of $1\cdot10^{11}$ cm$^{-2}$ to $1\cdot10^{13}$ cm$^{-2}$ in the device area.

28. The method of claim 26 which includes annealing the structure at a temperature of about 500°C to 1100°C to diffuse B or BF$_2$ ions from the conductive channel of the second type into the gate region (40) to form the conductive layer of the second type.

29. The method of claim 26 wherein said depositing the FEM gate unit (44) includes depositing a lower metal layer (46) of material taken from the group consisting of Pt, Ir, IrO$_2$ and Pt/Ir alloy, having a thickness of about 20 nm to 100 nm, depositing a FE layer (48) of material taken from the group consisting of Pb(Zr,Ti)O$_3$ (PZT), SrBi$_2$Ta$_2$O$_9$ (SBT), Pb$_5$Ge$_3$O$_{11}$, BaTiO$_3$ and LiNbO$_3$, having a thickness of about 100 nm to 400 nm, and depositing an upper metal layer (50) of material taken from the group consisting of Pt, Ir, IrO$_2$ and Pt/Ir alloy, having a thickness of 20 nm to 100 nm.

30. The method of claim 26 wherein said implanting doping impurities of the second type includes doping the device area with ions taken from the group consisting of As, implanted at an energy of about 40 keV to 70 keV, and phosphorous, implanted at an energy of about 30 keV to 50 keV, the ions having a dose of about $1\cdot10^{15}$ cm$^{-2}$ to $5\cdot10^{15}$ cm$^{-2}$.

31. The method of claim 26 further comprising depositing an insulating structure about the FEM gate unit includes depositing a layer of TiO$_x$ (56) over the FEM gate unit (44).

32. The method of claim 26 which further includes depositing a silicide layer (54) over the source junction region (38) and the drain junction region (42).

33. The method of claim 1, further comprising:

incorporating doping impurities of a fourth conductivity type into the substrate (30) to form a conductive substrate of a fourth conductivity type.

34. The method of claim 33 wherein forming a implanting doping impurities of a second type includes implanting a dopant taken from the group consisting of phosphorous and arsenic at an energy level in the range of about 10 keV to 50 keV and at a doses in a range of about $5.0\cdot10^{12}$ cm$^{-2}$ to $5.0\cdot10^{13}$ cm$^{-2}$.

35. The method of claim 33 wherein forming a conductive channel of the third type includes implanting a dopant taken from the group consisting of B or BF$_2$ at an energy in a range of 1 keV to 10 keV or 10 keV to 50 keV, respectively, and a dose of $5\cdot10^{11}$ cm$^{-2}$ to $1\cdot10^{13}$ cm$^{-2}$.

36. The method of claim 33 which includes annealing the structure at a temperature of about 500°C to 1100°C to diffuse B or BF$_2$ ions from the gate region (40) to form a barrier layer (70) between the gate region (40) and the FEM gate unit (44).

37. The method of claim 33 wherein said depositing the FEM gate unit (44) includes depositing a lower metal layer (46) of material taken from the group consisting of Ir, Ir/IrO$_2$ alloy, having a thickness of about 20 nm to 100 nm, depositing a FE layer (48) of material taken from the group consisting of Pb(Zr,Ti)O$_3$ (PZT), SrBi$_2$Ta$_2$O$_9$ (SBT), Pb$_5$Ge$_3$O$_{11}$, BaTiO$_3$ and LiNbO$_3$, having a thickness of about 50 nm to 400 nm, and depositing an upper metal layer (50) of material taken from the group consisting of Pt, Ir, IrO$_2$ and Pt/Ir alloy, having a thickness of 20 nm to 100 nm.

38. The method of claim 33 wherein said implanting doping impurities of the fourth type includes doping the device area with ions taken from the group consisting of As, implanted at an energy of about 40 keV to 70 keV, and phosphorous, implanted at an energy of about 30 keV to 60 keV, the ions having a dose of about $1\cdot10^{15}$ cm$^{-2}$ to $5\cdot10^{15}$ cm$^{-2}$.

39. The method of claim 33 wherein said depositing an insulating structure about the FEM gate unit (44) includes depositing a layer of insulating material (56) taken from the group consisting of TiO$_x$ and Si$_3$N$_4$.

40. The method of claim 1 wherein the step of depositing an FEM gate unit (44) over the gate region (40) includes depositing a lower metal layer (46) of material taken from the group consisting of Ir and Ir/IrO$_2$ alloy, having a

thickness of about 20 nm to 100 nm, a FE layer (48) of material taken from the group consisting of Pb(Zr,Ti)$O_3$ (PZT), SrBi$_2$Ta$_2$O$_9$ (SBT), Pb$_5$Ge$_3$O$_{11}$, BaTiO$_3$ and LiNbO$_3$, having a thickness of about 50 nm to 400 nm, and an upper metal layer (50) of material taken from the group consisting of Pt, Ir, IrO$_2$ and Pt/Ir alloy, having a thickness of 20 nm to 100 nm.

41. The method of claim 40 which includes annealing the structure at a temperature of about 500°C to 1100°C to diffuse B or BF$_2$ ions from the gate region (40) to form a barrier layer (70) between the gate region (40) and the FEM gate unit (44).

42. The method of claim 40 wherein said implanting doping impurities of the second type includes doping the device area with ions taken from the group consisting of As, implanted at an energy of about 40 keV to 70 keV, and phosphorous, implanted at an energy of about 30 keV to 60 keV, the ions having a dose of about $1 \cdot 10^{15}$ cm$^{-2}$ to $5 \cdot 10^{15}$ cm$^{-2}$.

43. The method of claim 40 wherein said depositing an insulating structure about the FEM gate unit (44) includes depositing a layer insulating material (56) taken from the group consisting of TiO$_x$ and Si$_3$N$_4$.

44. A ferroelectric memory (FEM) cell comprising:

a single-crystal silicon substrate (30) including an active region (32) therein;
a source junction region (38) and a drain junction region (42) located in said active region (32), doped to form a pair of conductive channels of a first conductivity type;
a gate region (40) located in said active region (32) between said source junction region (38) and said drain junction region (42) doped to form a conductive channel of a second conductivity type;
a conductive channel precursor region (52) located on said gate region (40);
a FEM gate unit (44) including a lower metal layer (46), a FE layer (48) and an upper metal layer (50);
an insulating layer (56), having an upper surface, overlying said junction regions (38, 40, 42), said FEM gate unit (44) and said substrate (30);
a source electrode (60) and a drain electrode (64), each located on the upper surface of said insulating layer (56) and extending therethrough to make electrical contact with their respective junction regions (38, 42), and
a gate electrode (62) located on the upper surface of said insulating layer (56) and extending therethrough to make electrical contact with the upper metal layer (50) of said FEM gate unit (44);

**characterized in that** said FEM gate unit (44) is sized on the gate junction region (40) such that any edge of the FEM gate unit (44) is a distance "D" from the edges of said source junction region (38) and said drain junction region (42), where "D" is between 50 nm and 300 nm.

45. The FEM cell of claim 44 wherein said conductive channel precursor region (52) includes Pt ions therein which diffuse from the lower metal layer (46) of said FEM gate unit (44) during annealing of the structure at a temperature of about 500°C to 1100°C.

46. The FEM cell of claim 44 wherein said conductive channel precursor region (52) includes ions implanted therein, and wherein the ions are taken from the group consisting of B and BF$_2$, implanted at an energy in a range of 3 keV to 10 keV and 15 keV to 50 keV, respectively, and a dose of $1 \cdot 10^{11}$ cm$^{-2}$ to $1 \cdot 10^{13}$ cm$^{-2}$.

47. The FEM cell of claim 44 wherein said FEM gate unit (44) includes a lower metal layer (46) of Pt having a thickness of about 20 nm to 100 nm, a FE layer (48) of material taken from the group consisting of Pb(Zr,Ti)O$_3$ (PZT), SrBi$_2$Ta$_2$O$_9$ (SBT), Pb$_5$Ge$_3$O$_{11}$, BaTiO$_3$ and LiNbO$_3$, having a thickness of about 100 nm to 400 nm, and an upper metal layer (50) of material taken from the group consisting of Pt, Ir and Pt/Ir alloy, having a thickness of 20 nm to 100 nm.

48. The FEM cell of claim 44 wherein said active region (32) includes ions taken from the group consisting of As, implanted at an energy of about 40 keV to 70 keV, and phosphorous, implanted at an energy of about 30 keV to 60 keV, the ions having a dose of about $2 \cdot 10^{15}$ cm$^{-2}$ to $5 \cdot 10^{15}$ cm$^{-2}$.

49. The ferroelectric memory (FEM) cell of claim 44, wherein said source electrode (60) and said drain electrode (64) are each located on the upper surface of said insulating layer (56) and extending therethrough to make electrical contact with their respective junction regions (38, 42), and said gate electrode (62) is located on the upper surface of said insulating layer (56) and extending therethrough to make electrical contact with the upper metal layer (50) of said FEM gate unit (44).

50. The FEM cell of claim 49 wherein said conductive channel of said third type includes ions implanted therein, and wherein the ions are taken from the group consisting of B and $BF_2$, implanted at an energy in a range of 3 keV to 10 keV and 15 keV to 50 keV, respectively, and a dose of $1 \cdot 10^{11}$ cm$^{-2}$ to $1 \cdot 10^{13}$ cm$^{-2}$, which diffuse from the lower metal layer (46) of said FEM gate unit (44) during annealing of the structure at a temperature of about 500°C to 1100°C.

51. The FEM cell of claim 49 wherein said FEM gate unit includes a lower metal layer (46) of Pt, having a thickness of about 20 nm to 100 nm, a FE layer (48) of material taken from the group consisting of $Pb(Zr,Ti)O_3$ (PZT), $SrBi_2Ta_2O_9$ (SBT), $Pb_5Ge_3O_{11}$, $BaTiO_3$ and $LiNbO_3$, having a thickness of about 100 nm to 400 nm, and an upper metal layer (50) of material taken from the group consisting of Pt, Ir, $IrO_2$ and Pt/Ir alloy, having a thickness of 20 nm to 100 nm.

52. The FEM cell of claim 49 wherein said active region (32) includes ions taken from the group consisting of As, implanted at an energy of about 40 keV to 70 keV, and phosphorous, implanted at an energy of about 30 keV to 60 keV, the ions having a dose of about $1 \cdot 10^{15}$ cm$^{-2}$ to $5 \cdot 10^{15}$ cm$^{-2}$.

53. The FEM cell of claim 49 wherein said conductive channel of said third type is constructed and arranged such that any edge thereof is a distance "C" from the edges of the source junction region (38) and the drain junction regions (42), wherein "C" is between about 0 nm and 300 nm.

54. The ferroelectric memory (FEM) cell of claim 49, further comprising:

a conductive channel of a third type located on said gate region (40) and extending partially into said drain junction region (42);

wherein said FEM gate unit (44) overlays said conductive channel of said second type and has a surface area less than that of said conductive channel region of said second type; and said source electrode (60) and said drain electrode (64) are each located on the upper surface of said insulating layer (56) and extending therethrough to make electrical contact with their respective junction regions (38, 42), wherein said drain electrode (64) makes contact with said drain junction region (42) and said conductive channel of said second type, and said gate electrode (62) is located on the upper surface of said insulating layer (56) and extending therethrough to make electrical contact with the upper metal layer (50) of said FEM gate unit (44).

55. The FEM cell of claim 54 wherein said conductive channel of said second type includes ions implanted therein, and wherein the ions are taken from the group consisting of B and $BF_2$, implanted at an energy in a range of 3 keV to 10 keV and 15 keV to 50 keV, respectively, and a dose of $1 \cdot 10^{11}$ cm$^{-2}$ to $1 \cdot 10^{13}$ cm$^{-2}$, which diffuse from the device area during annealing of the structure at a temperature of about 500°C to 1100°C.

56. The FEM cell of claim 54 wherein said FEM gate unit includes a lower metal layer (46) of Pt, having a thickness of about 20 nm to 100 nm, a FE layer (48) of material taken from the group consisting of $Pb(Zr,Ti)O_3$ (PZT), $SrBi_2Ta_2O_9$ (SBT), $Pb_5Ge_3O_{11}$, $BaTiO_3$ and $LiNbO_3$, having a thickness of about 100 nm to 400 nm, and an upper metal layer (50) of material taken from the group consisting of Pt, Ir, $IrO_2$ and Pt/Ir alloy, having a thickness of 20 nm to 100 nm.

57. The FEM cell of claim 54 wherein said active region (32) includes ions taken from the group consisting of As, implanted at an energy of about 40 keV to 70 keV, and phosphorous, implanted at an energy of about 30 keV to 50 keV, the ions having a dose of about $1 \cdot 10^{15}$ cm$^{-2}$ to $5 \cdot 10^{15}$ cm$^{-2}$.

58. The FEM cell of claim 54 which further includes a silicide layer (54) overlaying said source junction region (38) and said drain junction region (42).

59. The ferroelectric memory (FEM) cell of claim 44 wherein said source electrode (60) is located in said insulating layer (56) and connected to a ground.

**60.** The FEM cell of claim 59 wherein said conductive channel of said third type includes ions implanted therein, and wherein the ions are taken from the group consisting of B and $BF_2$, implanted at an energy in a range of 1 keV to 10 keV and 10 keV to 50 keV, respectively, and a dose of $1 \cdot 10^{11}$ $cm^{-2}$ to $1 \cdot 10^{13}$ $cm^{-2}$, which diffuse from said gate region (40) during annealing of the structure, at a temperature of about 500°C to 1100°C, to form a barrier layer (70) between said FEM gate unit (44) and said gate region (40).

**61.** The FEM cell of claim 59 wherein said FEM gate unit (44) includes a lower metal layer (46) of Ir, having a thickness of about 20 nm to 100 nm, a FE layer (48) of material taken from the group consisting of $Pb(Zr,Ti)O_3$ (PZT), $SrBi_2Ta_2O_9$ (SBT), $Pb_5Ge_3O_{11}$, $BaTiO_3$ and $LiNbO_3$, having a thickness of about 100 nm to 400 nm, and an upper metal layer (50) of material taken from the group consisting of Ir and $IrO_2$ alloy, having a thickness of 20 nm to 100 nm.

**62.** The FEM cell of claim 59 wherein said active region (32) includes ions taken from the group consisting of As, implanted at an energy of about 40 keV to 70 keV, and phosphorous, implanted at an energy of about 30 keV to 60 keV, the ions having a dose of about $1 \cdot 10^{15}$ $cm^{-2}$ to $5 \cdot 10^{15}$ $cm^{-2}$.

**Patentansprüche**

**1.** Verfahren zum Ausbilden einer Halbleiterstruktur mit einer Gateeinheit (44) für einen ferroelektrischen Speicher (FEM) auf einem Substrat (30) aus einkristallinem Silizium,
mit den Schritten:

- Ausbilden einer Siliziumeinrichtungsfläche für die FEM-Gateeinheit (44),
- Implantieren von Dotierungsverunreinigungen in der Siliziumeinrichtungsfläche, um einen leitenden Kanal (32) eines ersten Leitfähigkeitstyps auszubilden für die Verwendung als Sourceanschlussbereich (38) und als Drainanschlussbereich (42),
- Ätzen einer isolierenden Grenze (30a, 30b) um die Einrichtungsfläche herum,
- Ausbilden eines Gatebereichs (40) zwischen dem Sourceanschlussbereich (38) und dem Drainanschlussbereich (52) für die FEM-Gateeinheit (44) auf der Siliziumeinrichtungsfläche,
- Ausbilden einer leitenden Kanalprecursorschicht (42) auf dem Gatebereich (40) und
- Abscheiden einer FEM-Gateeinheit (44) über dem Gatebereich (40), wobei das Abscheiden einer unteren Metallschicht (46), einer FE-Schicht (48) und einer oberen Metallschicht (50) dabei enthalten ist,

**dadurch gekennzeichnet,**
**dass** die FEM-Gateeinheit (44) in ihrer Größe derart auf dem Gatebereich (40) ausgebildet ist, dass jegliche Kante der FEM-Gateeinheit (44) in einem Abstand "D" von den Kanten des Sourceanschlussbereichs (38) und des Drainanschlussbereichs (42) entfernt ist, wobei "D" zwischen 50 nm und 300 nm liegt.

**2.** Verfahren nach Anspruch 1, bei welchem das Ausbilden einer leitenden Kanalprecursorschicht (52) beinhaltet ein Implantieren eines Dotierstoffes aus der Gruppe, die gebildet wird von B oder $BF_2$, bei einer Energie im Bereich von 3 keV bis 10 keV bzw. 15 keV bis 50 keV und bei einer Dosis von $1 \cdot 10^{11}$ $cm^{-2}$ bis $1 \cdot 10^{13}$ $cm^{-2}$, um den leitfähigen Kanalprecursor (52) auszubilden.

**3.** Verfahren nach Anspruch 1,
bei welchem durchgeführt wird ein Annealen der Struktur bei einer Temperatur von etwa 500°C bis 1100°C, um Ionen von der unteren Metallschicht (46) in den Gateanschlussbereich (45) hinein zu diffundieren, um die leitfähige Kanalprecursorschicht (52) auszubilden.

**4.** Verfahren nach Anspruch 1,
bei welchem das Abscheiden der FEM-Gateeinheit (44) beinhaltet ein Abscheiden einer unteren Metallschicht (46) aus Pt, und zwar mit einer Schichtstärke von etwa 20 nm bis 100 nm, ein Abscheiden einer FE-Schicht (48) eines Materials aus der Gruppe, die gebildet wird von $Pb(Zr,Ti)O_3$ (PZT), $SrBi_2Ta_2O_9$ (SBT), $Pb_5Ge_3O_{11}$, $BaTiO_3$ und $LiNbO_3$ und zwar mit einer Schichtstärke von etwa 100 nm bis 400 nm, und ein Abscheiden einer oberen Metallschicht (50) eines Metalls aus der Gruppe, die gebildet wird von Pt, Ir und Pt/Ir-Legierungen, und zwar mit einer Schichtstärke von 20 nm bis 100 nm.

**5.** Verfahren nach Anspruch 1,

bei welchem das Implantieren der Dotierverunreinigungen aufweist ein Dotieren der Einrichtungsfläche mit Ionen aus der Gruppe, die besteht aus As, implantiert bei einer Energie von etwa 40 keV bis 70 keV und aus Phosphor, implantiert bei einer Energie von etwa 30 keV bis 60 keV, wobei die Ionen eine Dosis besitzen von etwa $2 \cdot 10^{15}$ $cm^{-2}$ bis $5 \cdot 10^{15}$ $cm^{-2}$.

6. Verfahren nach Anspruch 1,
welches aufweist das Abscheiden einer Schicht aus Ti-O$_x$ (56) über der FEM-Gateeinheit (44).

7. Verfahren nach Anspruch 1,
bei welchem die untere Metallschicht (46) ausgebildet wird aus einem Material aus der Gruppe, die gebildet wird von Pt, Ir und Pt/Ir-Legierungen mit einer Schichtstärke von etwa 20 nm bis 100 nm.

8. Verfahren nach Anspruch 7,
bei welchem das Ausbilden einer leitenden Kanalprecursorschicht (42) beinhaltet ein Implantieren eines Dotierstoffes aus der Gruppe, die gebildet wird von B oder BF$_2$, bei einer Energie im Bereich von 3 keV bis 10 keV bzw. 15 keV bis 50 keV und bei einer Dosis von $1 \cdot 10^{11}$ $cm^{-2}$ bis $1 \cdot 10^{13}$ $cm^{-2}$, um den leitfähigen Kanalprecursor (52) auszubilden.

9. Verfahren nach Anspruch 7,
bei welchem durchgeführt wird ein Annealen der Struktur bei einer Temperatur von etwa 500°C bis 1100°C, um Ionen von der unteren Metallschicht (46) in den Gateanschlussbereich (45) hinein zu diffundieren, um die leitfähige Kanalprecursorschicht (52) auszubilden.

10. Verfahren nach Anspruch 7,
welches aufweist einen Schritt des Ausbildens eines Kanals vom zweiten Leitfähigkeitstyp mit einer Schichtstärke von etwa 50 nm bis 100 nm.

11. Verfahren nach Anspruch 7,
bei welchem das Implantieren der Dotierverunreinigungen aufweist ein Dotieren der Einrichtungsfläche mit Ionen aus der Gruppe, die besteht aus As, implantiert bei einer Energie von etwa 40 keV bis 70 keV, und aus Phosphor, implantiert bei einer Energie von etwa 30 keV bis 60 keV, wobei die Ionen eine Dosis besitzen von etwa $2 \cdot 10^{15}$ $cm^{-2}$ bis $5 \cdot 10^{15}$ $cm^{-2}$.

12. Verfahren nach Anspruch 7,
welches aufweist das Abscheiden einer Schicht aus Ti-O$_x$ (56) über der FEM-Gateeinheit (44).

13. Verfahren nach Anspruch 7,
bei welchem die leitfähige Kanalprecursorschicht (52) unter den Rändern oder Grenzen der FEM-Gateeinheit (44) liegt.

14. Verfahren nach Anspruch 1,
bei welchem ein Schritt des Ausbildens eines leitfähigen Kanals eines dritten Typs auf dem Gatebereich (40) vorgesehen ist, wobei der leitfähige Kanal des dritten Leitfähigkeitstyps in seiner Größe auf dem Gatebereich (40) derart ausgebildet wird, dass jegliche Kante des leitfähigen Kanals vom dritten Leitfähigkeitstyp in einem Abstand "C" entfernt ist von den Kanten des Sourceanschlussbereichs (38) und des Drainanschlussbereichs (42), wobei "C" zwischen etwa 0 nm und 300 nm liegt.

15. Verfahren nach Anspruch 14,
bei welchem das Ausbilden eines leitfähigen Kanals eines dritten Typs beinhaltet ein Implantieren eines Dotierstoffes aus der Gruppe, die gebildet wird von B oder BF$_2$, bei einer Energie im Bereich von 3 keV bis 10 keV bzw. 15 keV bis 50 keV und bei einer Dosis von $1 \cdot 10^{11}$ $cm^{-2}$ bis $1 \cdot 10^{13}$ $cm^{-2}$.

16. Verfahren nach Anspruch 14,
bei welchem vorgesehen ist ein Annealen der Struktur bei einer Temperatur von etwa 500 °C bis 1100 °C, um B- oder BF$_2$-Ionen von der unteren Metallschicht (46) in den Gatebereich (40) hinein zu diffundieren, um den leitfähigen Kanal vom dritten Typ auszubilden.

17. Verfahren nach Anspruch 14,

bei welchem das Abscheiden der FEM-Gateeinheit (44) beinhaltet ein Abscheiden einer unteren Metallschicht (46) aus einem Material aus der Gruppe, die gebildet wird von Pt, Ir, IrO$_2$ und Pt/Ir-Legierungen, und zwar mit einer Schichtstärke von etwa 20 nm bis 100 nm, ein Abscheiden einer FE-Schicht (48) eines Materials aus der Gruppe, die gebildet wird von Pb(Zr,Ti)O$_3$ (PZT), SrBi$_2$Ta$_2$O$_9$ (SBT), Pb$_5$Ge$_3$O$_{11}$, BaTiO$_3$ und LiNbO$_3$ und zwar mit einer Schichtstärke von etwa 50 nm bis 400 nm, und ein Abscheiden einer oberen Metallschicht (50) eines Materials aus der Gruppe, die gebildet wird von Pt, Ir, IrO$_2$ und Pt/Ir-Legierungen, und zwar mit einer Schichtstärke von 20 nm bis 100 nm.

**18.** Verfahren nach Anspruch 14,
bei welchem das Implantieren der Dotierverunreinigungen vom zweiten Typ aufweist ein Dotieren der Einrichtungsfläche mit Ionen aus der Gruppe, die besteht aus As, implantiert bei einer Energie von etwa 40 keV bis 70 keV und aus Phosphor, implantiert bei einer Energie von etwa 30 keV bis 50 keV, wobei die Ionen eine Dosis besitzen von etwa 1·10$^{15}$ cm$^{-2}$ bis 5·10$^{15}$ cm$^{-2}$.

**19.** Verfahren nach Anspruch 14,
bei welchem des Weiteren ein Schritt des Abscheidens einer isolierenden Struktur um die FEM-Gateeinheit (44) herum vorgesehen ist, welcher einen Schritt des Abscheidens einer Schicht eines isolierenden Materials (56) umfasst, und zwar aus der Gruppe, die besteht aus TiO$_x$ und Si$_3$N$_4$, und zwar über der FEM-Gateeinheit (44).

**20.** Verfahren nach Anspruch 1,
bei welchem der Schritt des Ausbildens eines Gatebereichs (40) aufweist:

- einen Schritt des Implantierens von Dotierstoffverunreinigungen eines zweiten Leitfähigkeitstyps in der Siliziumeinrichtungsfläche, um einen leitfähigen Kanal vom zweiten Leitfähigkeitstyp zur Verwendung als Gatebereich (40) auszubilden,
- bei welchem ein Abscheiden der FEM-Gateeinheit (44) über dem Gatebereich (40) beinhaltet ein Abscheiden einer unteren Metallschicht (46) aus einem Material aus der Gruppe, die gebildet wird von Pt, Ir, IrO$_2$ und Pt/Ir-Legierungen, und zwar mit einer Schichtstärke von etwa 20 nm bis 100 nm, ein Abscheiden einer FE-Schicht (48) eines Materials aus der Gruppe, die gebildet wird von Pb(Zr,Ti)O$_3$ (PZT), SrBi$_2$Ta$_2$O$_9$ (SBT), Pb$_5$Ge$_3$O$_{11}$, BaTiO$_3$ und LiNbO$_3$, und zwar mit einer Schichtstärke von etwa 50 nm bis 400 nm, und ein Abscheiden einer oberen Metallschicht (50) eines Materials aus der Gruppe, die gebildet wird von Pt, Ir, IrO$_2$ und Pt/Ir-Legierungen, und zwar mit einer Schichtstärke von 20 nm bis 100 nm, wobei die FEM-Gateeinheit (44) in ihrer derart auf dem Gatebereich (40) ausgebildet wird, dass jegliche Kante der FEM-Gateeinheit (44) in einem Abstand "D" von den Kanten des Sourceanschlussbereichs (38) und des Drainanschlussbereichs (42) entfernt ist, wobei "D" zwischen 50 nm und 300 nm liegt, und
- einen Schritt des Ausbildens eines leitfähigen Kanals eines dritten Typs auf dem Gatebereich (40), wobei der leitfähige Kanal des dritten Leitfähigkeitstyps in seiner Größen derart auf dem Gatebereich (40) ausgebildet wird, dass jegliche Kante des leitfähigen Kanals vom dritten Leitfähigkeitstyp in einem Abstand "C" entfernt ist von den Kanten des Sourceanschlussbereichs (38) und des Drainanschlussbereichs (42), wobei "C" zwischen etwa 0 nm und 300 nm liegt.

**21.** Verfahren nach Anspruch 20,
bei welchem das Ausbilden eines leitenden Kanals vom dritten Typ beinhaltet ein Implantieren eines Dotierstoffes aus der Gruppe, die gebildet wird von B oder BF$_2$, bei einer Energie im Bereich von 3 keV bis 10 keV bzw. 15 keV bis 50 keV und bei einer Dosis von 1·10$^{11}$ cm$^{-2}$ bis 1·10$^{13}$ cm$^{-2}$, in der unteren Metallschicht (46).

**22.** Verfahren nach Anspruch 20,
bei welchem ein Schritt des Ausbildens eines leitfähigen Kanals vom dritten Typ vorgesehen ist, welcher beinhaltet ein Implantieren eines Dotierstoffes aus der Gruppe, die gebildet wird von B oder BF$_2$, bei einer Energie im Bereich von 3 keV bis 10 keV bzw. 15 keV bis 50 keV und bei einer Dosis von 1·10$^{11}$ cm$^{-2}$ bis 1·10$^{13}$ cm$^{-2}$, in der leitfähigen Schicht (32) vom ersten Typ.

**23.** Verfahren nach Anspruch 20,
bei welchem durchgeführt wird ein Annealen der Struktur bei einer Temperatur von etwa 500°C bis 1100°C, um B- oder BF$_2$-Ionen von der unteren Metallschicht (46) in den Gatebereich (40) hinein zu diffundieren, um den leitfähigen Kanal vom dritten Typ auszubilden.

**24.** Verfahren nach Anspruch 20,

bei welchem das Implantieren der Dotierverunreinigungen vom zweiten Typ aufweist ein Dotieren der Einrichtungsfläche mit Ionen aus der Gruppe, die besteht aus As, implantiert bei einer Energie von etwa 40 keV bis 70 keV und aus Phosphor, implantiert bei einer Energie von etwa 30 keV bis 50 keV, wobei die Ionen eine Dosis besitzen von etwa $1 \cdot 10^{15}$ cm$^{-2}$ bis $5 \cdot 10^{15}$ cm$^{-2}$.

25. Verfahren nach Anspruch 20,
bei welchem der Schritt des Abscheidens einer isolierenden Struktur um die FEM-Gateeinheit (44) herum einen Schritt des Abscheidens einer Schicht eine isolierenden Materials (56) aufweist, und zwar aus der Gruppe, die besteht aus TiO$_x$ und Si$_3$N$_4$ und zwar über der FEM-Gateeinheit (44).

26. Verfahren nach Anspruch 1,
bei welchem der Schritt des Implantierens von Dotierungsverunreinigungen eines zweiten Typs über der Einrichtungsfläche vorgesehen ist, um eine leitfähige Schicht vom zweiten Typ auszubilden, wobei sich die leitfähige Schicht vom zweiten Typ in den Drainanschlussbereich (42) hinein erstreckt.

27. Verfahren nach Anspruch 26,
bei welchem der Schritt des Ausbildens einer leitfähigen Schicht vom zweiten Typ aufweist ein Implantieren eines Dotierstoffes aus der Gruppe, die gebildet wird von B oder BF$_2$, bei einer Energie im Bereich von 3 keV bis 10 keV bzw. 15 keV bis 50 keV und bei einer Dosis von $1 \cdot 10^{11}$ cm$^{-2}$ bis $1 \cdot 10^{13}$ cm$^{-2}$ in der Einrichtungsfläche.

28. Verfahren nach Anspruch 26,
bei welchem durchgeführt wird ein Annealen der Struktur bei einer Temperatur von etwa 500°C bis 1100°C, um B- oder BF$_2$-Ionen vom leitfähigen Kanal vom zweiten Typ in den Gatebereich (40) hinein zu diffundieren, um die leitfähige Schicht vom zweiten Typ auszubilden.

29. Verfahren nach Anspruch 26,
bei welchem das Abscheiden der FEM-Gateeinheit (44) beinhaltet ein Abscheiden einer unteren Metallschicht (46) aus einem Material aus der Gruppe, die gebildet wird von Pt, Ir, IrO$_2$ und Pt/Ir-Legierungen, und zwar mit einer Schichtstärke von etwa 20 nm bis 100 nm, ein Abscheiden einer FE-Schicht (48) eines Materials aus der Gruppe, die gebildet wird von Pb(Zr,Ti)O$_3$ (PZT), SrBi$_2$Ta$_2$O$_9$ (SBT), Pb$_5$Ge$_3$O$_{11}$, BaTiO$_3$ und LiNbO$_3$, und zwar mit einer Schichtstärke von etwa 100 nm bis 400 nm, und ein Abscheiden einer oberen Metallschicht (50) eines Metalls aus der Gruppe, die gebildet wird von Pt, Ir, IrO$_2$ und Pt/Ir-Legierungen, und zwar mit einer Schichtstärke von 20 nm bis 100 nm.

30. Verfahren nach Anspruch 26,
bei welchem das Implantieren der Dotierverunreinigungen vom zweiten Typ aufweist ein Dotieren der Einrichtungsfläche mit Ionen aus der Gruppe, die besteht aus As, implantiert bei einer Energie von etwa 40 keV bis 70 keV, und aus Phosphor, implantiert bei einer Energie von etwa 30 keV bis 50 keV, wobei die Ionen eine Dosis besitzen von etwa $1 \cdot 10^{15}$ cm$^{-2}$ bis $5 \cdot 10^{15}$ cm$^{-2}$.

31. Verfahren nach Anspruch 26,
bei welchem ein Schritt des Abscheidens einer isolierenden Struktur um die FEM-Gateeinheit vorgesehen ist, welcher einen Schritt aufweist des Abscheidens einer Schicht aus TiO$_x$ über der FEM-Gateeinheit (44).

32. Verfahren nach Anspruch 26,
bei welchem ferner ein Schritt des Abscheidens einer Silizidschicht (54) über dem Sourceanschlussbereich (38) und dem Drainanschlussbereich (42) vorgesehen ist.

33. Verfahren nach Anspruch 1,
bei welchem ferner ein Schritt des Inkorporierens von Dotierstoffverunreinigungen eines vierten Leitfähigkeitstyps in das Substrat (30) vorgesehen ist, um ein leitfähiges Substrat vom vierten Leitfähigkeitstyp auszubilden.

34. Verfahren nach Anspruch 33,
bei welchem das Ausbilden von implantierten Dotierstoffverunreinigungen vom zweiten Leitfähigkeitstyp ein Implantieren von Dotierstoff aufweist aus der Gruppe, die gebildet wird von Phosphor und Arsen bei einem Energieniveau im Bereich von etwa 10 keV bis 50 keV und bei Dosen im Bereich von etwa $5,0 \cdot 10^{12}$ cm$^{-2}$ bis $5,0 \cdot 10^{13}$ cm$^{-2}$.

35. Verfahren nach Anspruch 33,

bei welchem das Ausbilden eines leitenden Kanals vom dritten Typ aufweist ein Implantieren eines Dotierstoffes aus der Gruppe, die gebildet wird von B oder $BF_2$, bei einer Energie im Bereich von 1 keV bis 10 keV bzw. 10 keV bis 50 keV und bei einer Dosis von $5 \cdot 10^{11}$ cm$^{-2}$ bis $1 \cdot 10^{13}$ cm$^{-2}$.

**36.** Verfahren nach Anspruch 33,
bei welchem durchgeführt wird ein Annealen der Struktur bei einer Temperatur von etwa 500°C bis 1100°C, um B- oder $BF_2$-Ionen aus dem Gatebereich (40) zu diffundieren, um eine Barriereschicht (70) zwischen dem Gatebereich (40) und der FEM-Gateeinheit (44) auszubilden.

**37.** Verfahren nach Anspruch 33,
bei welchem das Abscheiden der FEM-Gateeinheit (44) beinhaltet ein Abscheiden einer unteren Metallschicht (46) aus einem Material aus der Gruppe, die gebildet wird von Ir und Ir/$IrO_2$-Legierungen, und zwar mit einer Schichtstärke von etwa 20 nm bis 100 nm, ein Abscheiden einer FE-Schicht (48) eines Materials aus der Gruppe, die gebildet wird von Pb(Zr,Ti)$O_3$ (PZT), $SrBi_2Ta_2O_9$ (SBT), $Pb_5Ge_3O_{11}$, $BaTiO_3$ und $LiNbO_3$, und zwar mit einer Schichtstärke von etwa 50 nm bis 400 nm, und ein Abscheiden einer oberen Metallschicht (50) eines Metalls aus der Gruppe, die gebildet wird von Pt, Ir, $IrO_2$ und Pt/Ir-Legierungen, und zwar mit einer Schichtstärke von 20 nm bis 100 nm.

**38.** Verfahren nach Anspruch 33,
bei welchem das Implantieren der Dotierverunreinigungen vom vierten Typ aufweist ein Dotieren der Einrichtungsfläche mit Ionen aus der Gruppe, die besteht aus As, implantiert bei einer Energie von etwa 40 keV bis 70 keV, und aus Phosphor, implantiert bei einer Energie von etwa 30 keV bis 60 keV, wobei die Ionen eine Dosis besitzen von etwa $1 \cdot 10^{15}$ cm$^{-2}$ bis $5 \cdot 10^{15}$ cm$^{-2}$.

**39.** Verfahren nach Anspruch 33,
bei welchem des Weiteren ein Schritt des Abscheidens einer isolierenden Struktur um die FEM-Gateeinheit (44) herum vorgesehen ist, welcher einen Schritt des Abscheidens einer Schicht eine isolierenden Materials (56) umfasst, und zwar aus der Gruppe, die besteht aus $TiO_x$ und $Si_3N_4$.

**40.** Verfahren nach Anspruch 1,
bei welchem der Schritt des Abscheidens der FEM-Gateeinheit (44) über dem Gatebereich (40) beinhaltet ein Abscheiden einer unteren Metallschicht (46) aus einem Material aus der Gruppe, die gebildet wird von Ir und Ir/$IrO_2$-Legierungen, und zwar mit einer Schichtstärke von etwa 20 nm bis 100 nm, ein Abscheiden einer FE-Schicht (48) eines Materials aus der Gruppe, die gebildet wird von Pb(Zr,Ti)$O_3$ (PZT), $SrBi_2Ta_2O_9$ (SBT), $Pb_5Ge_3O_{11}$, $BaTiO_3$ und $LiNbO_3$, und zwar mit einer Schichtstärke von etwa 50 nm bis 400 nm, und ein Abscheiden einer oberen Metallschicht (50) eines Metalls aus der Gruppe, die gebildet wird von Pt, Ir, $IrO_2$ und Pt/Ir-Legierungen, und zwar mit einer Schichtstärke von 20 nm bis 100 nm.

**41.** Verfahren nach Anspruch 40,
bei welchem durchgeführt wird ein Annealen der Struktur bei einer Temperatur von etwa 500°C bis 1100°C, um B- oder $BF_2$-Ionen aus dem Gatebereich (40) zu diffundieren, um eine Barriereschicht (70) zwischen dem Gatebereich (40) und der FEM-Gateeinheit (44) auszubilden.

**42.** Verfahren nach Anspruch 40,
bei welchem das Implantieren der Dotierverunreinigungen vom zweiten Typ aufweist ein Dotieren der Einrichtungsfläche mit Ionen aus der Gruppe, die besteht aus As, implantiert bei einer Energie von etwa 40 keV bis 70 keV, und aus Phosphor, implantiert bei einer Energie von etwa 30 keV bis 60 keV, wobei die Ionen eine Dosis besitzen von etwa $1 \cdot 10^{15}$ cm$^{-2}$ bis $5 \cdot 10^{15}$ cm$^{-2}$.

**43.** Verfahren nach Anspruch 40,
bei welchem des Weiteren ein Schritt des Abscheidens einer isolierenden Struktur um die FEM-Gateeinheit (44) herum vorgesehen ist, welcher einen Schritt des Abscheidens einer Schicht eine isolierenden Materials (56) umfasst, und zwar aus der Gruppe, die besteht aus $TiO_x$ und $Si_3N_4$.

**44.** Ferroelektrische Speicherzelle (FEM),
mit:

-   einem einkristallinen Siliziumsubstrat (30) mit einem aktiven Bereich (32) darin,

- einem Sourceanschlussbereich (38) und einem Drainanschlussbereich (42), welche im aktiven Bereich (32) ausgebildet sind und welche derart dotiert sind, dass ein Paar leitfähiger Kanäle von einem ersten Leitfähigkeitstyp gebildet wird,
- einem Gatebereich (40), welcher im aktiven Bereich (32) zwischen dem Sourceanschlussbereich (38) und dem Drainanschlussbereich (42) ausgebildet und derart dotiert ist, dass ein leitfähiger Kanal eines zweiten Leitfähigkeitstyps gebildet wird,
- einem leitfähigen Kanalprecursorbereich (52), welcher im Gatebereich (40) ausgebildet ist,
- einer FEM-Gateeinheit (44) mit einer unteren Metallschicht (46), einer FE-Schicht (48) und einer oberen Metallschicht (50),
- einer isolierenden Schicht (56) mit einer oberen Fläche oder Oberfläche, welche über den Anschlussbereichen (38, 40, 42), der FEM-Gateeinheit (44) und dem Substrat (30) liegt,
- einer Sourceelektrode (60) und einer Drainelektrode (64), die beide auf der oberen Fläche oder Oberfläche der isolierenden Schicht (56) angeordnet sind und sich dort hindurch erstrecken, um einen elektrischen Kontakt mit den jeweiligen Anschlussbereichen (38, 42) auszubilden, und mit einer Gateelektrode (62), die auf der oberen Fläche oder Oberfläche der isolierenden Schicht (56) ausgebildet ist und sich dort hindurch erstreckt, um einen elektrischen Kontakt mit der oberen Metallschicht (50) der FEM-Gateeinheit (44) auszubilden,

**dadurch gekennzeichnet,**
**dass** die FEM-Gateeinheit (44) in ihrer Größen derart auf dem Gateanschlussbereich (40) ausgebildet ist, dass jegliche Kante der FEM-Gateeinheit (44) in einem Abstand "D" von den Kanten des Sourceanschlussbereichs (38) und des Drainanschlussbereichs (42) entfernt ist, wobei "D" zwischen 50 nm und 300 nm liegt.

45. FEM-Zelle nach Anspruch 44,
bei welcher der leitfähige Kanalprecursorbereich (52) Pt-Ionen aufweist, die von der unteren Metallschicht (46) der FEM-Gateeinheit (44) während eines Annealens der Struktur bei einer Temperatur von etwa 500°C bis 1100°C diffundieren.

46. FEM-Zelle nach Anspruch 44,

- bei welcher der leitfähige Kanalprecursorbereich (52) darin implantierte Ionen aufweist und
- bei welcher die Ionen aus der Gruppe stammen, die B und BF2 aufweist, und zwar implantiert bei einer Energie im Bereich von 3 keV bis 10 keV bzw. 15 keV bis 50 keV und mit einer Dosis von $1 \cdot 10^{11}$ cm$^{-2}$ bis $1 \cdot 10^{13}$ cm$^{-3}$.

47. FEM-Zelle nach Anspruch 44,
bei welcher die FEM-Gateeinheit (44) aufweist eine untere Metallschicht (46) aus Pt mit einer Schichtstärke von etwa 20 nm bis 100 nm, eine FE-Schicht (48) eines Materials aus der Gruppe, die besteht aus Pb(Zr,Ti)O$_3$ (PZT), SrBi$_2$Ta$_2$O$_9$ (SBT), Pb$_5$Ge$_3$O$_{11}$, BaTiO$_3$ und LiNbO$_3$, mit einer Schichtstärke von etwa 100 nm bis 400 nm, sowie eine obere Metallschicht (50) aus einem Material aus der Gruppe, die besteht aus Pt, Ir und Pt/Ir-Legierungen, mit einer Schichtstärke von 20 nm bis 100 nm.

48. FEM-Zelle nach Anspruch 44,
bei welcher der aktive Bereich (32) Ionen aufweist aus der Gruppe, die besteht aus As, implantiert bei einer Energie von etwa 40 keV bis 70 keV, und Phosphor, implantiert bei einer Energie von etwa 30 keV bis 60 keV, wobei die Ionen eine Dosis aufweisen von etwa $2 \cdot 10^{15}$ cm$^{-2}$ bis $5 \cdot 10^{15}$ cm$^{-2}$.

49. FEM-Zelle nach Anspruch 44,

- bei welcher die Sourceelektrode (60) und die Drainelektrode (64) auf der oberen Fläche oder Oberfläche der isolierenden Schicht (56) angeordnet sind und sich dort hindurch erstrecken, um einen elektrischen Kontakt mit den jeweiligen Anschlussbereichen (38, 42) auszubilden und
- bei welcher die Gateelektrode (62) auf der oberen Fläche oder Oberfläche der isolierenden Schicht (56) ausgebildet ist und sich dort hindurch erstreckt, um einen elektrischen Kontakt mit der oberen Metallschicht (50) der FEM-Gateeinheit (44) auszubilden.

50. FEM-Zelle nach Anspruch 49,

- bei welcher der leitfähiger Kanal vom dritten Typ darin implantierte Ionen aufweist und
- bei welcher die Ionen aus der Gruppe stammen, die B und BF$_2$ aufweist, und zwar implantiert bei einer Energie im Bereich von 3 keV bis 10 keV bzw. 15 keV bis 50 keV und mit einer Dosis von $1 \cdot 10^{11}$ cm$^{-2}$ bis $1 \cdot 10^{13}$ cm$^{-3}$ welche von der oberen Metallschicht (46) der FEM-Gateeinheit (44) während eines Annealens der Struktur bei einer Temperatur von etwa 500°C bis 1100°C diffundieren.

51. FEM-Zelle nach Anspruch 49,
bei welcher die FEM-Gateeinheit (44) aufweist eine untere Metallschicht (46) aus Pt mit einer Schichtstärke von etwa 20 nm bis 100 nm, eine FE-Schicht (48) eines Materials aus der Gruppe, die besteht aus Pb(Zr,Ti)O$_3$ (PZT), SrBi$_2$Ta$_2$O$_9$ (SBT), Pb$_5$Ge$_3$O$_{11}$, BaTiO$_3$ und LiNbO$_3$, mit einer Schichtstärke von etwa 100 nm bis 400 nm, sowie eine obere Metallschicht (50) aus einem Material aus der Gruppe, die besteht aus Pt, Ir, IrO$_2$ und Pt/Ir-Legierungen, mit einer Schichtstärke von 20 nm bis 100 nm.

52. FEM-Zelle nach Anspruch 49,
bei welcher der aktive Bereich (32) Ionen aufweist aus der Gruppe, die besteht aus As, implantiert bei einer Energie von etwa 40 keV bis 70 keV, und Phosphor, implantiert bei einer Energie von etwa 30 keV bis 60 keV, wobei die Ionen eine Dosis aufweisen von etwa $1 \cdot 10^{15}$ cm$^{-2}$ bis $5 \cdot 10^{15}$ cm$^{-2}$.

53. FEM-Zelle nach Anspruch 49,
bei welcher der leitfähige Kanal vom dritten Typ so aufgebaut und angeordnet ist, dass jegliche Kante davon in einem Abstand "C" von den Kanten des Sourceanschlussbereichs (38) und des Drainanschlussbereichs (42) entfernt ist, wobei "C" zwischen 0 nm und 300 nm liegt.

54. FEM-Zelle nach Anspruch 49,
welche des weiteren aufweist:

- einen leitfähigen Kanal vom dritten Typ, welcher im Gatebereich (40) angeordnet ist und sich partiell in den Drainanschlussbereich (42) hinein erstreckt;
- wobei die FEM-Gateeinheit (44) über dem leitfähigen Kanal vom zweiten Typ liegt und einen Oberflächenbereich aufweist, der geringer ist als derjenige des leitfähigen Kanalbereichs vom zweiten Typ, und
- wobei die Sourceelektrode (60) und die Drainelektrode (64) derart auf der oberen Fläche oder Oberfläche der isolierenden Schicht (56) angeordnet sind und sich dort hindurch erstrecken, um einen elektrischen Kontakt mit den jeweiligen Anschlussbereichen (38, 42) auszubilden, wobei die Drainelektrode (64) einen Kontakt herstellt mit Drainanschlussbereich (42) und mit dem leitfähigen Kanal vom zweiten Typ und wobei die Gateelektrode (62) derart auf der oberen Fläche oder Oberfläche der isolierenden Schicht (56) angeordnet ist und sich dort hindurch erstreckt, um einen elektrischen Kontakt mit der oberen Metallschicht (50) der FEM-Gateeinheit (44) auszubilden.

55. FEM-Zelle nach Anspruch 54,

- bei welcher der leitfähiger Kanal vom zweiten Typ darin implantierte Ionen aufweist und
- bei welcher die Ionen aus der Gruppe stammen, die B und BF$_2$ aufweist, und zwar implantiert bei einer Energie im Bereich von 3 keV bis 10 keV bzw. 15 keV bis 50 keV und mit einer Dosis von $1 \cdot 10^{11}$ cm$^{-2}$ bis $1 \cdot 10^{13}$ cm$^{-3}$, welche von der Einrichtungsfläche während eines Annealens der Struktur bei einer Temperatur von etwa 500°C bis 1100°C diffundieren

56. FEM-Zelle nach Anspruch 54,
bei welcher die FEM-Gateeinheit (44) aufweist eine untere Metallschicht (46) aus Pt mit einer Schichtstärke von etwa 20 nm bis 100 nm, eine FE-Schicht (48) eines Materials aus der Gruppe, die besteht aus Pb(Zr,Ti)O$_3$ (PZT), SrBi$_2$Ta$_2$O$_9$ (SBT), Pb$_5$Ge$_3$O$_{11}$, BaTiO$_3$ und LiNbO$_3$, mit einer Schichtstärke von etwa 100 nm bis 400 nm, sowie eine obere Metallschicht (50) aus einem Material aus der Gruppe, die besteht aus Pt, Ir, IrO$_2$ und Pt/Ir-Legierungen, mit einer Schichtstärke von 20 nm bis 100 nm.

57. FEM-Zelle nach Anspruch 54,
bei welcher der aktive Bereich (32) Ionen aufweist aus der Gruppe, die besteht aus As, implantiert bei einer Energie von etwa 40 keV bis 70 keV und Phosphor, implantiert bei einer Energie von etwa 30 keV bis 50 keV, wobei die Ionen eine Dosis aufweisen von etwa $1 \cdot 10^{15}$ cm$^{-2}$ bis $5 \cdot 10^{15}$ cm$^{-2}$.

58. FEM-Zelle nach Anspruch 54,
welche des Weiteren eine Silizidschicht (54) aufweist, die über dem Sourceanschlussbereich (38) und dem Drainanschlussbereich (42) liegt.

**59.** FEM-Zelle nach Anspruch 44,
bei welcher die Sourceelektrode (60) in der isolierenden Schicht (56) angeordnet und mit Masse verbunden ist.

**60.** FEM-Zelle nach Anspruch 59,

- bei welcher der leitfähiger Kanal vom dritten Typ darin implantierte Ionen aufweist und
- bei welcher die Ionen aus der Gruppe stammen, die B und $BF_2$ aufweist, und zwar implantiert bei einer Energie im Bereich von 1 keV bis 10 keV bzw. 10 keV bis 50 keV und mit einer Dosis von $1 \cdot 10^{11}$ cm$^{-2}$ bis $1 \cdot 10^{13}$ cm$^{-3}$, welche von dem Gatebereich (40) während eines Annealens der Struktur bei einer Temperatur von etwa 500°C bis 1100°C diffundieren, um eine Barriereschicht (70) zwischen der FEM-Gateeinheit (44) und dem Gatebereich (40) auszubilden.

**61.** FEM-Zelle nach Anspruch 59,
bei welcher die FEM-Gateeinheit (44) aufweist eine untere Metallschicht (46) aus Ir mit einer Schichtstärke von etwa 20 nm bis 100 nm, eine FE-Schicht (48) eines Materials aus der Gruppe, die besteht aus $Pb(Zr,Ti)O_3$ (PZT), $SrBi_2Ta_2O_9$ (SBT), $Pb_5Ge_3O_{11}$, $BaTiO_3$ und $LiNbO_3$, mit einer Schichtstärke von etwa 100 nm bis 400 nm sowie eine obere Metallschicht (50) aus einem Material aus der Gruppe, die besteht aus Ir und $IrO_2$-Legierungen, mit einer Schichtstärke von 20 nm bis 100 nm.

**62.** FEM-Zelle nach Anspruch 59,
bei welcher der aktive Bereich (32) Ionen aufweist aus der Gruppe, die besteht aus As, implantiert bei einer Energie von etwa 40 keV bis 70 keV, und Phosphor, implantiert bei einer Energie von etwa 30 keV bis 60 keV, wobei die Ionen eine Dosis aufweisen von etwa $1 \cdot 10^{15}$ cm$^{-2}$ bis $5 \cdot 10^{15}$ cm$^{-2}$.

**Revendications**

**1.** Procédé de formation d'une structure de semiconducteur ayant une unité de grille (44) de mémoire ferroélectrique (FEM) sur un substrat (30) de silicium monocristallin, comprenant les étapes consistant à :

former une zone de dispositif en silicium pour l'unité de grille FEM (44) ;
implanter des impuretés dopantes dans la zone de dispositif en silicium afin de former un canal conducteur (32) d'un premier type de conductivité pour une utilisation en tant que région de jonction de source (38) et région de jonction de drain (42) ;
attaquer chimiquement une frontière isolante (30a, 30b) autour de la zone du dispositif ;
former une région de grille (40) entre la région de jonction de source (38) et la région de jonction de drain (42) pour l'unité de grille FEM (44) sur la zone du dispositif en silicium ;
former une couche précurseur (52) de canal conducteur sur la région de grille (40) ; et
déposer une unité de grille FEM (44) sur la région de grille (40), comprenant le dépôt d'une couche métallique inférieure (46), d'une couche FE (48) et d'une couche métallique supérieure (50),

**caractérisée en ce que** l'unité de grille FEM (44) est dimensionnée sur la région de grille (40) de telle sorte que tout bord de l'unité de grille FEM (44) est à une distance « D » des bords de la région de jonction de source (38) et de la région de jonction de drain (42) où « D » est compris entre 50 nm et 300 nm.

**2.** Procédé selon la revendication 1, dans lequel la formation d'une couche précurseur (52) de canal conducteur comprend l'implantation d'un dopant pris dans le groupe constitué par B ou $BF_2$ à une énergie dans une gamme de 3 keV à 10 keV ou 15 keV à 50 keV, respectivement, et une dose de $1.10^{11}$ cm$^{-2}$ à $1.10^{13}$ cm$^{-2}$ afin de former le précurseur (52) de canal conducteur.

**3.** Procédé selon la revendication 1, qui comprend le recuit de la structure à une température d'environ 500°C à 1100°C pour faire diffuser les ions de la couche métallique inférieure (46) dans la région de jonction de grille (45) afin de former la couche précurseur (52) de canal conducteur.

**4.** Procédé selon la revendication 1, dans lequel ledit dépôt de l'unité de grille FEM (44) comprend le dépôt d'une couche métallique inférieure (46) de PT, ayant une épaisseur d'environ 20 nm à 100 nm, le dépôt d'une couche FE (48) d'un matériau pris dans le groupe constitué par $Pb(Zr,Ti)O_3(PZT)$, $SrBi_2Ta_2O_9(SBT)$, $Pb_5Ge_3O_{11}$, $BaTiO_3$ et $LiNbO_3$, ayant une épaisseur d'environ 100 nm à 400 nm, et le dépôt d'une couche métallique supérieure (50) d'un matériau pris dans le groupe constitué par Pt, Ir et un alliage Pt/Ir, ayant une épaisseur de 20 nm à 100 nm.

5.  Procédé selon la revendication 1, dans lequel ladite implantation des impuretés dopantes comprend le dopage de la zone du dispositif par des ions pris dans le groupe constitué par As, implanté à une énergie d'environ 40 KeV à 70 keV, et le phosphore, implanté à une énergie d'environ 30 keV à 60 KeV, les ions ayant une dose d'environ $2.10^{15}$ $cm^{-2}$ à $5.10^{15}$ $cm^{-2}$.

6.  Procédé selon la revendication 1, qui comprend le dépôt d'une couche de $TiO_x$ (56) sur l'unité de grille FEM (44).

7.  Procédé selon la revendication 1, dans lequel la couche métallique inférieure (46) est constituée d'un matériau pris dans le groupe constitué par Pt, Ir et un alliage Pt/Ir, ayant une épaisseur d'environ 20 nm à 100 nm.

8.  Procédé selon la revendication 7, dans lequel la formation d'une couche précurseur (52) de canal conducteur comprend l'implantation d'un dopant pris dans le groupe constitué par B ou $BF_2$ à une énergie dans une gamme de 3 keV à 10 keV ou 15 keV à 50 keV, respectivement, et une dose de $1\times10^{11}$ $cm^{-2}$ à $1\times10^{13}$ $cm^{-2}$ pour former la couche précurseur (52) de canal conducteur.

9.  Procédé selon la revendication 7, qui comprend le recuit de la cellule FEM à une température d'environ 500°C à 1100°C pour faire diffuser les ions de la couche métallique inférieure (46) de l'unité de grille FEM dans la région de jonction de grille (40) afin de former la couche précurseur (52) de canal conducteur.

10. Procédé selon la revendication 7, qui comprend la formation d'un canal du deuxième type conducteur ayant une épaisseur d'environ 50 nm à 100 nm.

11. Procédé selon la revendication 7, dans lequel ladite implantation des impuretés dopantes comprend le dopage de la zone du dispositif par des ions pris dans le groupe constitué par As, implanté à une énergie d'environ 40 KeV à 70 keV, et le phosphore, implanté à une énergie d'environ 30 keV à 60 KeV, les ions ayant une dose d'environ $2.10^{15}$ $cm^{-2}$ à $5.10^{15}$ $cm^{-2}$.

12. Procédé selon la revendication 7, qui comprend le dépôt d'une couche de $TiO_x$ (56) sur l'unité de grille FEM (44).

13. Procédé selon la revendication 7, dans lequel la couche précurseur (52) de canal conducteur est en dessous des marges de l'unité de grille FEM (44).

14. Procédé selon la revendication 1, comprenant en outre la formation d'un canal conducteur d'un troisième type sur la région de grille (40) dans lequel le canal conducteur du troisième type de conductivité est dimensionné sur la région de grille (40) de telle sorte que tout bord du canal conducteur du troisième type de conductivité est à une distance « C » des bords de la région de jonction de source (38) et de la région de jonction de drain (42) où « C » est comprise entre environ 0 nm et 300 nm.

15. Procédé selon la revendication 14, dans lequel la formation d'un canal conducteur du troisième type comprend l'implantation d'un dopant pris dans le groupe constitué par B ou $BF_2$ à une énergie dans une gamme de 3 keV à 10 keV ou 15 keV à 50 keV, respectivement, et une dose de $1.10^{11}$ $cm^{-2}$ à $1.10^{13}$ $cm^{-2}$.

16. Procédé selon la revendication 14, qui comprend le recuit de la structure à une température d'environ 500°C à 1100°C pour faire diffuser les ions B et $BF_2$ de la couche métallique inférieure (46) dans la région de grille (40) afin de former le canal conducteur du troisième type.

17. Procédé selon la revendication 14, dans lequel ledit dépôt de l'unité de grille FEM comprend le dépôt d'une couche métallique inférieure (46) d'un matériau pris dans le groupe constitué par Pt, Ir, $IrO_2$ et un alliage Pt/Ir, ayant une épaisseur d'environ 20 nm à 100 nm, le dépôt d'une couche FE (48) d'un matériau pris dans le groupe constitué par $Pb(Zr,Ti)O_3(PZT)$, $SrBi_2Ta_2O_9(SBT)$, $Pb_5Ge_3O_{11}$, $BaTiO_3$ et $LiNbO_3$, ayant une épaisseur d'environ 50 nm à 400 nm, et le dépôt d'une couche métallique supérieure (50) d'un matériau pris dans le groupe constitué par Pt, Ir, $IrO_2$ et un alliage Pt/Ir, ayant une épaisseur de 20 nm à 100 nm.

18. Procédé selon la revendication 14, dans lequel ladite implantation des impuretés dopantes du deuxième type comprend le dopage de la zone du dispositif par des ions pris dans le groupe constitué par As, implantés à une énergie d'environ 40 KeV à 70 keV, et le phosphore, implantés à une énergie d'environ 30 keV à 50 KeV, les ions ayant une dose d'environ $1.10^{15}$ cm$^{-2}$ à $5.10^{15}$ cm$^{-2}$.

**19.** Procédé selon la revendication 14, comprenant en outre le dépôt d'une structure isolante autour de l'unité de grille FEM (44), qui comprend le dépôt d'une couche de matériau isolant (56) pris dans le groupe constitué par TiO$_x$ et Si$_3$N$_4$ sur l'unité de grille FEM (44).

**20.** Procédé selon la revendication 1, dans lequel l'étape de formation d'une région de grille (40) comprend :

l'implantation d'impuretés dopantes d'un deuxième type de conductivité dans la zone du dispositif en silicium afin de former un canal conducteur d'un deuxième type de conductivité pour une utilisation comme région de grille (40) ;

ladite étape de dépôt d'une unité de grille FEM (44) sur la région de grille (40) comprend le dépôt d'une couche métallique inférieure (46) d'un matériau pris dans le groupe constitué par Pt, Ir, IrO$_2$ et un alliage Pt/Ir, ayant une épaisseur d'environ 20 nm à 100 nm, d'une couche FE (48) d'un matériau pris dans le groupe constitué par Pb(Zr,Ti)O$_3$(PZT), SrBi$_2$Ta$_2$O$_9$(SBT), Pb$_5$Ge$_3$O$_{11}$, BaTiO$_3$ et LiNbO$_3$, ayant une épaisseur d'environ 50 nm à 400 nm, et d'une couche métallique supérieure (50) d'un matériau pris dans le groupe constitué par Pt, Ir et un alliage Pt/Ir, ayant une épaisseur de 20 nm à 100 nm, dans lequel l'unité de grille FEM (44) est dimensionnée sur la région de grille (40) de telles sorte que tout bord de l'unité de grille FEM (44) est à une distance « D » des bords de la région de jonction de source (38) et de la région de jonction de drain (42) où « D » est comprise entre 50 nm et 300 nm ;

et comprenant en outre l'étape de formation d'un canal conducteur d'un troisième type sur la région de grille (40) dans lequel le canal conducteur du troisième type est dimensionné sur la région de grille (40) de telle sorte que tout bord du canal conducteur du troisième type est à une distance « C » des bords de la région de jonction de source (38) et de la région de jonction de drain (42) où « C » est comprise entre environ 0 nm et 300 nm.

**21.** Procédé selon la revendication 20, dans lequel la formation d'un canal conducteur du troisième type comprend l'implantation d'un dopant pris dans le groupe constitué par B ou BF$_2$ à une énergie dans une gamme de 3 keV à 10 keV ou 15 keV à 50 keV, respectivement, et une dose de $1.10^{11}$ cm$^{-2}$ à $1.10^{13}$ cm$^{-2}$ dans la couche métallique inférieure (46).

**22.** Procédé selon la revendication 20, comprenant en outre la formation d'un canal conducteur du troisième type comprenant l'implantation d'un dopant pris dans le groupe constitué par B ou BF$_2$ à une énergie dans une gamme de 3 keV à 10 keV ou 15 keV à 50 keV, respectivement, et une dose de $1 \times 10^{11}$ cm$^{-2}$ à $1 \times 10^{13}$ cm$^{-2}$ dans la surface de la couche conductrice (32) du premier type.

**23.** Procédé selon la revendication 20, qui comprend le recuit de la structure à une température d'environ 500°C à 1100°C pour faire diffuser les ions B ou BF$_2$ de la couche métallique inférieure (46) dans la région de grille (40) afin de former le canal conducteur du troisième type.

**24.** Procédé selon la revendication 20, dans lequel ladite implantation des impuretés dopantes du deuxième type comprend le dopage de la zone du dispositif par des ions pris dans le groupe constitué par As, implantés à une énergie d'environ 40 KeV à 70 keV, et le phosphore, implantés à une énergie d'environ 30 keV à 50 KeV, les ions ayant une dose d'environ $1.10^{15}$ cm$^{-2}$ à $5.10^{15}$ cm$^{-2}$.

**25.** Procédé selon la revendication 20, dans lequel ledit dépôt d'une structure isolante autour de l'unité de grille FEM (44) comprend le dépôt d'une couche de matériau isolant (56) pris dans le groupe constitué par TiO$_x$ et Si$_3$N$_4$ sur l'unité de grille FEM (44).

**26.** Procédé selon la revendication 1, comprenant en outre l'étape d'implantation d'impuretés dopantes d'un deuxième type sur la zone du dispositif afin de former une couche conductrice d'un deuxième type dans lequel la couche conductrice du deuxième type s'étend dans la région de jonction de drain (42).

**27.** Procédé selon la revendication 26, dans lequel la formation d'une couche conductrice du deuxième type comprend l'implantation d'un dopant pris dans le groupe constitué par B ou BF$_2$ à une énergie dans une gamme de 3 keV à 10 keV ou de 15 keV à 50 keV, respectivement, et une dose de $1.10^{11}$ cm$^{-2}$ à $1.10^{13}$ cm$^{-2}$ dans la zone du dispositif.

**28.** Procédé selon la revendication 26, qui comprend le recuit de la structure à une température d'environ 500°C à 1100°C pour faire diffuser les ions B ou BF$_2$ du canal conducteur du deuxième type dans la région de grille (40) afin de former la couche conductrice du deuxième type.

**29.** Procédé selon la revendication 26, dans lequel ledit dépôt de l'unité de grille FEM (44) comprend le dépôt d'une couche métallique inférieure (46) d'un matériau pris dans le groupe constitué par Pt, Ir, IrO$_2$ et un alliage Pt/Ir, ayant une épaisseur d'environ 20 nm à 100 nm, le dépôt d'une couche FE (48) d'un matériau pris dans le groupe constitué par Pb(Zr,Ti)O$_3$(PZT), SrBi$_2$Ta$_2$O$_9$(SBT), Pb$_5$Ge$_3$O$_{11}$, BaTiO$_3$ et LiNbO$_3$, ayant une épaisseur d'environ 100 nm à 400 nm, et le dépôt d'une couche métallique supérieure (50) d'un matériau pris dans le groupe constitué par Pt, Ir, IrO$_2$ et un alliage Pt/Ir, ayant une épaisseur de 20 nm à 100 nm.

**30.** Procédé selon la revendication 26, dans lequel ladite implantation des impuretés dopantes du deuxième type comprend le dopage de la zone du dispositif par des ions pris dans le groupe constitué par As, implantés à une énergie d'environ 40 KeV à 70 keV, et le phosphore, implantés à une énergie d'environ 30 keV à 50 KeV, les ions ayant une dose d'environ $1.10^{15}$ cm$^{-2}$ à $5.10^{15}$ cm$^{-2}$.

**31.** Procédé selon la revendication 26, comprenant en outre le dépôt d'une structure isolante autour de l'unité de grille FEM, qui comprend le dépôt d'une couche de TiO$_x$ (56) sur l'unité de grille FEM (44).

**32.** Procédé selon la revendication 26, qui comprend en outre le dépôt d'une couche de siliciure (54) sur la région de jonction de source (38) et la région de jonction de drain (42).

**33.** Procédé selon la revendication 1, comprenant en outre :

l'incorporation d'impuretés dopantes d'un quatrième type de conductivité dans le substrat (30) afin de former un substrat conducteur d'un quatrième type de conductivité.

**34.** Procédé selon la revendication 33, dans lequel la formation d'impuretés dopantes d'un deuxième type comprend l'implantation d'un dopant pris dans le groupe constitué par le phosphore et l'arsenic à un niveau d'énergie dans la gamme d'environ 10 keV à 50 keV et à une dose dans une gamme d'environ $5,0.10^{12}$ cm$^{-2}$ à $5,0.10^{13}$ cm$^{-2}$.

**35.** Procédé selon la revendication 33, dans lequel la formation d'un canal conducteur du troisième type comprend l'implantation d'un dopant pris dans le groupe constitué par B ou BF$_2$ à une énergie dans une gamme de 1 keV à 10 keV ou de 10 keV à 50 keV, respectivement, et une dose de $5.10^{11}$ cm$^{-2}$ à $1.10^{13}$ cm$^{-2}$.

**36.** Procédé selon la revendication 33, qui comprend le recuit de la structure à une température d'environ 500°C à 1100°C pour faire diffuser les ions B ou BF$_2$ à partir de la région de grille (40) afin de former une couche barrière (70) entre la région de grille (40) et l'unité de grille FEM (44).

**37.** Procédé selon la revendication 33, dans lequel ledit dépôt de l'unité de grille FEM (44) comprend le dépôt d'une couche métallique inférieure (46) d'un matériau pris dans le groupe constitué par Ir, un alliage Ir/IrO$_2$, ayant une épaisseur d'environ 20 nm à 100 nm, le dépôt d'une couche FE (48) d'un matériau pris dans le groupe constitué par Pb(Zr,Ti)O$_3$(PZT), SrBi$_2$Ta$_2$O$_9$(SBT), Pb$_5$Ge$_3$O$_{11}$, BaTiO$_3$ et LiNbO$_3$, ayant une épaisseur d'environ 50 nm à 400 nm, et le dépôt d'une couche métallique supérieure (50) d'un matériau pris dans le groupe constitué par Pt, Ir, IrO$_2$ et un alliage Pt/Ir, ayant une épaisseur de 20 nm à 100 nm.

**38.** Procédé selon la revendication 33, dans lequel ladite implantation des impuretés dopantes du quatrième type comprend le dopage de la zone du dispositif par des ions pris dans le groupe constitué par As, implantés à une énergie d'environ 40 KeV à 70 keV, et le phosphore, implantés à une énergie d'environ 30 keV à 60 KeV, les ions ayant une dose d'environ $1.10^{15}$ cm$^{-2}$ à $5.10^{15}$ cm$^{-2}$.

**39.** Procédé selon la revendication 33, dans lequel ledit dépôt d'une structure isolante autour de l'unité de grille FEM (44) comprend le dépôt d'une couche d'un matériau isolant (56) pris dans le groupe constitué par TiO$_x$ et Si$_3$N$_4$.

**40.** Procédé selon la revendication 1, dans lequel l'étape de dépôt d'unité de grille FEM (44) sur la région de grille (40) comprend le dépôt d'une couche métallique inférieure (46) d'un matériau pris dans le groupe constitué par Ir et un alliage Ir/IrO$_2$, ayant une épaisseur d'environ 20 nm à 100 nm, d'une couche FE (48) d'un matériau pris dans le groupe constitué par Pb(Zr,Ti)O$_3$(PZT), SrBi$_2$Ta$_2$O$_9$(SBT), Pb$_5$Ge$_3$O$_{11}$, BaTiO$_3$ et LiNbO$_3$, ayant une épaisseur

d'environ 50 nm à 400 nm, et d'une couche métallique supérieure (50) d'un matériau pris dans le groupe constitué par Pt, Ir, IrO$_2$ et un alliage Pt/Ir, ayant une épaisseur de 20 nm à 100 nm.

41. Procédé selon la revendication 40, qui comprend le recuit de la structure à une température d'environ 500°C à 1100°C pour faire diffuser les ions B ou BF$_2$ à partir de la région de grille (40) afin de former une couche barrière (70) entre la région de grille (40) et l'unité de grille FEM (44).

42. Procédé selon la revendication 40, dans lequel ladite implantation des impuretés dopantes du deuxième type comprend le dopage de la zone du dispositif par des ions pris dans le groupe constitué par As, implantés à une énergie d'environ 40 KeV à 70 keV, et le phosphore, implantés à une énergie d'environ 30 keV à 60 KeV, les ions ayant une dose d'environ 1.10$^{15}$ cm$^{-2}$ à 5.10$^{15}$ cm$^{-2}$.

43. Procédé selon la revendication 40, dans lequel ledit dépôt d'une structure isolante autour de l'unité de grille FEM (44) comprend le dépôt d'un matériau isolant de couche (56) pris dans le groupe constitué par TiO$_x$ et Si$_3$N$_4$.

44. Cellule de mémoire ferroélectrique (FEM) comprenant :

un substrat en silicium monocristallin (30) comprenant une région active (32) à l'intérieur ;
une région de jonction de source (38) et une région de jonction de drain (42) situées dans ladite région active (32), dopées afin de former une paire de canaux conducteurs d'un premier type de conductivité ;
une région de grille (40) située dans ladite région active (32) entre ladite région de jonction de source (38) et ladite région de jonction de drain (42) dopée afin de former un canal conducteur d'un deuxième type de conductivité ;
une région précurseur (52) de canal conducteur située sur ladite région de grille (40) ;
une unité de grille FEM (44) comprenant une couche métallique inférieure (46), une couche FE (48) et une couche métallique (50) ;
une couche isolante (56), ayant une surface supérieure, recouvrant lesdites régions de jonction (38, 40, 42), ladite unité de grille FEM (44) et ledit substrat (30) ;
une électrode de source (60) et une électrode de drain (64), chacune située sur la surface supérieure de ladite couche isolante (56) et s'étendant au travers pour réaliser un contact électrique avec leur région de jonction respective (38,42), et une électrode de grille (62) située sur la surface supérieure de ladite couche isolante (56) et s'étendant au travers pour réaliser un contact électrique avec la couche métallique supérieure (50) de ladite unité de grille FEM (44) ;

**caractérisée en ce que** ladite unité de grille FEM (44) est dimensionnée sur la région de jonction de grille (40) de telle sorte que tout bord de l'unité de grille FEM (44) est à une distance « D » des bords de ladite région de jonction de source (38) et de ladite région de jonction de drain (42), où « D » est comprise entre 50 nm et 300 nm.

45. Cellule FEM selon la revendication 44, dans laquelle ladite région précurseur (52) de canal conducteur comprend des ions Pt à l'intérieur qui diffusent à partir de la couche métallique inférieure (46) de ladite unité de grille FEM (44) pendant le recuit de la structure à une température d'environ 500°C à 1100°C.

46. Cellule FEM selon la revendication 44, dans laquelle ladite région précurseur (52) de canal conducteur comprend des ions implantés à l'intérieur, et dans laquelle les ions sont pris dans le groupe constitué par B et BF$_2$ implantés à une énergie dans une gamme de 3 keV à 10 keV ou de 15 keV à 50 keV, respectivement, et une dose de 1.10$^{11}$ cm$^{-2}$ à 1.10$^{13}$ cm$^{-2}$.

47. Cellule FEM selon la revendication 44, dans laquelle ladite unité de grille FEM (44) comprend une couche métallique inférieure (46) de Pt ayant une épaisseur d'environ 20 nm à 100 nm, une couche de Fe (48) d'un matériau pris dans le groupe constitué par Pb(Zr,Ti)O$_3$(PZT), SrBi$_2$Ta$_2$O$_9$(SBT), Pb$_5$Ge$_3$O$_{11}$, BaTiO$_3$ et LiNbO$_3$, ayant une épaisseur d'environ 100 nm à 400 nm, et une couche métallique supérieure (50) d'un matériau pris dans le groupe constitué par Pt, Ir et un alliage Pt/Ir, ayant une épaisseur de 20 nm à 100 nm.

48. Cellule FEM selon la revendication 44, dans laquelle ladite région active (32) comprend des ions pris dans le groupe constitué par As, implantés à une énergie d'environ 40 KeV à 70 keV, et le phosphore, implantés à une énergie d'environ 30 keV à 60 KeV, les ions ayant une dose d'environ 2.10$^{15}$ cm$^{-2}$ à 5.10$^{15}$ cm$^{-2}$.

49. Cellule de mémoire ferroélectrique (FEM) selon la revendication 44, dans laquelle ladite électrode de source (60) et ladite électrode de drain (64) sont chacune située sur la surface supérieur de ladite couche isolante (56) et s'étendant au travers pour réaliser un contact électrique avec leur région de jonction respective (38,42), et ladite électrode de grille (62) est située sur la surface supérieure de ladite couche isolante (56) et s'étendant au travers pour réaliser un contact électrique avec la couche métallique supérieure (50) de ladite unité de grille FEM (44) ;

50. Cellule FEM selon la revendication 49, dans laquelle ledit canal conducteur dudit troisième type comprend des ions implantés à l'intérieur, et dans laquelle les ions sont pris dans le groupe constitué par B et $BF_2$ implantés à une énergie dans une gamme de 3 keV à 10 keV et de 15 keV à 50 keV, respectivement, et une dose de $1.10^{11}$ $cm^{-2}$ à $1.10^{13}$ $cm^{-2}$ qui diffusent à partir de la couche métallique inférieure (46) de ladite unité de grille FEM (44) pendant le recuit de la structure à une température d'environ 500°C à 1100°C.

51. Cellule FEM selon la revendication 49, dans laquelle ladite unité de grille FEM comprend une couche métallique inférieure (46) de Pt ayant une épaisseur d'environ 20 nm à 100 nm, une couche FE (48) d'un matériau pris dans le groupe constitué par $Pb(Zr,Ti)O_3(PZT)$, $SrBi_2Ta_2O_9(SBT)$, $Pb_5Ge_3O_{11}$, $BaTiO_3$ et $LiNbO_3$, ayant une épaisseur d'environ 100 nm à 400 nm, et une couche métallique supérieure (50) d'un matériau pris dans le groupe constitué par Pt, Ir, $IrO_2$ et un alliage Pt/Ir, ayant une épaisseur de 20 nm à 100 nm.

52. Cellule FEM selon la revendication 49, dans laquelle ladite région active (32) comprend des ions pris dans le groupe constitué par As, implantés à une énergie d'environ 40 KeV à 70 keV, et le phosphore, implantés à une énergie d'environ 30 keV à 60 KeV, les ions ayant une dose d'environ $1.10^{15}$ $cm^{-2}$ à $5.10^{15}$ $cm^{-2}$.

53. Cellule FEM selon la revendication 49, dans laquelle ledit canal conducteur dudit troisième type est construit et agencé de telle sorte que tout bord de celui-ci est à une distance « C » des bords de la région de jonction de source (38) et de la région de jonction de drain (42), dans laquelle « C » est comprise entre environ 0 nm et 300 nm.

54. Cellule de mémoire ferroélectrique (FEM), selon la revendication 49, comprenant en outre :

un canal conducteur d'un troisième type situé sur ladite région de grille (40) et s'étendant partiellement dans ladite région de jonction de drain (42) ;
dans laquelle ladite unité de grille FEM (44) recouvre ledit canal conducteur dudit deuxième type et a une aire surfacique inférieure à celle de ladite région de canal conducteur dudit deuxième type ;
et ladite électrode de source (60) et ladite électrode de drain (64) sont chacune situées sur la surface supérieure de ladite couche isolante (56) et s'étendant au travers pour réaliser un contact électrique avec leur région de jonction respective (38, 42), dans laquelle ladite électrode de drain (64) réalise un contact électrique avec ladite région de jonction de drain (42) et ledit canal conducteur dudit deuxième type, et ladite électrode de grille (62) est située sur la surface supérieure de ladite couche isolante (56) et s'étendant au travers pour réaliser un contact électrique avec la couche métallique supérieure (50) de ladite unité de grille FEM (44).

55. Cellule FEM selon la revendication 54, dans laquelle ledit canal conducteur dudit deuxième type comprend des ions implantés à l'intérieur, et dans laquelle les ions sont pris dans le groupe constitué par B et $BF_2$, implantés à une énergie dans une gamme de 3 keV à 10 keV et de 15 keV à 50 keV, respectivement, et une dose de $1.10^{11}$ $cm^{-2}$ à $1.10^{13}$ $cm^{-2}$ qui diffusent à partir de la zone du dispositif pendant le recuit de la structure à une température d'environ 500°C à 1100°C.

56. Cellule FEM selon la revendication 54, dans laquelle ladite unité de grille FEM comprend une couche métallique inférieure (46) de Pt ayant une épaisseur d'environ 20 nm à 100 nm, une couche FE (48) d'un matériau pris dans le groupe constitué par $Pb(Zr,Ti)O_3(PZT)$, $SrBi_2Ta_2O_9(SBT)$, $Pb_5Ge_3O_{11}$, $BaTiO_3$ et $LiNbO_3$, ayant une épaisseur d'environ 100 nm à 400 nm, et une couche métallique supérieure (50) d'un matériau pris dans le groupe constitué par Pt, Ir, $IrO_2$ et un alliage Pt/Ir, ayant une épaisseur de 20 nm à 100 nm.

57. Cellule FEM selon la revendication 54, dans laquelle ladite région active (32) comprend des ions pris dans le groupe constitué par As, implantés à une énergie d'environ 40 KeV à 70 keV, et le phosphore, implantés à une énergie d'environ 30 keV à 50 KeV, les ions ayant une dose d'environ $1.10^{15}$ $cm^{-2}$ à $5.10^{15}$ $cm^{-2}$.

58. Cellule FEM selon la revendication 54, qui comprend en outre une couche de siliciure (54) recouvrant ladite région de jonction de source (38) et ladite région de jonction de drain (42).

59. Cellule de mémoire ferroélectrique (FEM) selon la revendication 44, dans laquelle ladite électrode de source (60) est située dans ladite couche isolante (56) et connectée à une masse.

**60.** Cellule FEM selon la revendication 59, dans laquelle ledit canal conducteur dudit troisième type comprend des ions implantés à l'intérieur, et dans laquelle les ions sont pris dans le groupe constitué par B et $BF_2$, implantés à une énergie dans une gamme de 1 keV à 10 keV et de 10 keV à 50 keV, respectivement, et une dose de $1.10^{11}$ $cm^{-2}$ à $1.10^{13}$ $cm^{-2}$ qui diffusent à partir de ladite région de grille (40) pendant le recuit de la structure, à une température d'environ 500°C à 1100°C, afin de former une couche barrière (70) entre ladite unité de grille FEM (44) et ladite région de grille (40).

**61.** Cellule FEM selon la revendication 59, dans laquelle ladite unité de grille FEM (44) comprend une couche métallique inférieure (46) de Ir, ayant une épaisseur d'environ 20 nm à 100 nm, une couche FE (48) d'un matériau pris dans le groupe constitué par $Pb(Zr,Ti)O_3(PZT)$, $SrBi_2Ta_2O_9(SBT)$, $Pb_5Ge_3O_{11}$, $BaTiO_3$ et $LiNbO_3$, ayant une épaisseur d'environ 100 nm à 400 nm, et une couche métallique supérieure (50) d'un matériau pris dans le groupe constitué par un alliage de Ir et $IrO_2$, ayant une épaisseur de 20 nm à 100 nm.

**62.** Cellule FEM selon la revendication 59, dans laquelle ladite région active (32) comprend des ions pris dans le groupe constitué par As, implantés à une énergie d'environ 40 KeV à 70 keV, et le phosphore, implantés à une énergie d'environ 30 keV à 60 KeV, les ions ayant une dose d'environ $1.10^{15}$ $cm^{-2}$ à $5.10^{15}$ $cm^{-2}$.

*FIG.1*

*FIG.2*

*FIG.3*

*FIG.4*

FIG.5

FIG.6 —|D|— —|D|—

FIG.7

FIG.8a

FIG.8b

FIG.9a

FIG.9b

EP 0 869 557 B1

214 212 214

FIG.10

210

228 215 224 226

214 232 222 214

230

218 220 216 218

210

FIG. 11

FIG.12

FIG.13

FIG.14

FIG.15

*FIG. 16*

*FIG. 17*

FIG. 18a

FIG. 18b

FIG. 19a

FIG. 19b

314     312                                              314

n−

*FIG. 20*                                      310

316        322
           320
           318                  312
314                                              314

n−

*FIG. 21*

310

316
320   322
324            324      312
314                                314

n−

318

*FIG. 22*

310

FIG.23

FIG.24

FIG.25

EP 0 869 557 B1

FIG. 26a

FIG. 26b

FIG. 27a

FIG. 27b

52

FIG.28

FIG.29

FIG.30

FIG.31

FIG.32

FIG.33

54

FIG.34

FIG.35

FIG.36

FIG.37a

FIG.37b

FIG.38b

FIG.38a

FIG. 39

FIG. 40

FIG.41a

FIG.41b

FIG.42a

FIG.42b

FIG.43a

FIG.43b

FIG.44a

FIG.44b

556    554    546

558  560    562    542

FIG.45a    540

552
548

542

548'

FIG.45b

580
578
576
574
572

FIG.46    570

585

582

580
578 } 584
576

574

572

570

*FIG.47*

585

584
582

572

586  590  588

570

*FIG.48*

FIG.49

FIG.50

FIG.51a

FIG.51b

FIG.52a

FIG.52b

FIG. 53

FIG.54a

FIG.54b

FIG. 55a

FIG. 55b

FIG. 55c

EP 0 869 557 B1

FIG.56a

FIG.56b

FIG.57

EP 0 869 557 B1